(19) Europäisches Patentamt / European Patent Office / Office européen des brevets

(11) **EP 2 360 733 A1**

(12) **EUROPEAN PATENT APPLICATION**
published in accordance with Art. 153(4) EPC

(43) Date of publication:
**24.08.2011 Bulletin 2011/34**

(51) Int Cl.:
**H01L 31/04** $^{(2006.01)}$

(21) Application number: **09822006.4**

(22) Date of filing: **19.10.2009**

(86) International application number:
**PCT/JP2009/068012**

(87) International publication number:
**WO 2010/047309 (29.04.2010 Gazette 2010/17)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **20.10.2008 JP 2008270257**
**20.10.2008 JP 2008270258**
**20.10.2008 JP 2008270259**
**20.10.2008 JP 2008270260**

(71) Applicant: **Idemitsu Kosan Co., Ltd.**
**Chiyoda-ku**
**Tokyo 100-8321 (JP)**

(72) Inventors:
• **KAIJO Akira**
  **Sodegaura-shi**
  **Chiba 299-0293 (JP)**
• **OYAMA Masashi**
  **Sodegaura-shi**
  **Chiba 299-0293 (JP)**

(74) Representative: **Gille Hrabal Struck Neidlein Prop Roos**
**Patentanwälte**
**Brucknerstrasse 20**
**40593 Düsseldorf (DE)**

(54) **PHOTOVOLTAIC ELEMENT AND METHOD FOR MANUFACTURING SAME**

(57)     On a p-type conductive light absorption layer (130) provided by a chalcopyrite structure compound that is layered bridging a pair of backside electrode layers (120) provided on a side of a glass substrate (110), a light-transmissive n-type buffer layer (140) that forms a p-n junction with the light absorption layer (130) is layered. A light-transmissive transparent electrode layer (160) is layered on the buffer layer (140) to extend from a side of the light absorption layer (130) and the buffer layer (140) to one of the pair of backside electrode layers (120). The transparent electrode layer (160) is formed in an amorphous film containing indium oxide and zinc oxide as primary components, the transparent electrode layer (160) exhibiting a film stress of $\pm 1 \times 10^9$ Pa or less. A photovoltaic element can be favorably processed without causing cracking and damage even by an easily processable mechanical scribing, so that productivity can be enhanced and yield rate can be improved.

FIG.1

**Description**

Technical Field

The present invention relates to a photovoltaic element that has a light absorption layer that is formed of a p-type conductive chalcopyrite-structure compound into a thin layer, and a manufacturing method thereof.

Background Art

A solar battery is a clean power-generating device powered by practically unexhaustible sunlight and thus is widely used for various applications. The solar battery includes a device that uses power generated by a photoelectric conversion element such as silicon and compound semiconductor, the photoelectric conversion element generating photovoltaic power when light such as sunlight is incident thereon.
The solar battery can be classified into several categories. Among them, monocrystalline silicon solar battery and polycrystalline silicon solar battery employ expensive silicon substrates. Accordingly, thin-film solar batteries that are expected to significantly reduce the material cost have been used.

Among the thin-film solar batteries, those employing non-silicon semiconductor material of compounds of chalcopyrite crystalline structure as the photoelectric conversion material, especially CIGS solar batteries that employ CIGS compound comprising copper (Cu), indium (In), gallium (Ga) and selenium (Se) have attracted attentions.
The CIGS solar batteries exemplarily include: a lower electrode thin layer formed on a glass substrate; a light absorption thin layer comprised of CIGS compound containing cupper, indium, gallium and selenium; a highly resistant buffer thin layer provided on the light absorption thin layer by InS, ZnS, CdS, ZnO and the like; and an upper electrode thin layer provided by AZO and the like (see, for instance, Patent Literature 1).
Since CIGS semiconductor material exhibits high optical absorptance and a power-generating layer can be formed by vapor deposition, sputtering and the like, the thickness of the CIGS solar batteries as disclosed in the Patent Literature 1 can be reduced to several $\mu$ms. Thus, the size and the material cost of the CIGS solar batteries can be reduced, and less energy is required for manufacturing the solar batteries.

The solar battery that forms a light absorption layer by the typical chalcopyrite crystalline structure as in the CIGS solar batteries disclosed in the Patent Literature 1 includes a serial connection of the photovoltaic elements in order to efficiently collect power. The serial connection of the photovoltaic elements in the thin-film structure is provided by scribing and dividing the formed layer.
In order to scribe, various processes such as irradiation of laser beam and mechanical scribing in which the layer is cut using a diamond are used. Among them, mechanical scribing has been preferred in terms of availability of the apparatus and easy processability. However, mechanical scribing tends to involve cracking and partial breakage, so that excellent performance may not be obtained. In order to facilitate the mechanical scribing, it has been known that, when the layer to be subjected to the mechanical scribing is amorphous, the layer can be efficiently machined. In a known arrangement, a transparent electrode is provided by an amorphous material (see, for instance, Patent Literature 2).

Further, the thin-film solar batteries have deficiencies such as (1) conversion efficiency that largely deteriorates after installation, and (2) low conversion efficiency as compared with monocrystalline silicon solar battery and polycrystalline silicon solar battery. In order to overcome the deficiencies, various studies have been undertaken.
Known methods for improving the photoelectric conversion efficiency of the solar batteries include: (a) providing concavity and convexity on the surface of the substrate near the photoelectric conversion layer to increase the chance of multipath reflection of the light transmitted through the photoelectric conversion layer; (b) forming a light containment layer and (c) forming an antireflection film to increase the light quantity incident on the photoelectric conversion layer.
For instance, in order to form the light containment layer and antireflection film, a $Zn_2In_2O_5$ transparent conductive film having a large optical refraction index is formed on a ZnO, $SnO_2$ or $In_2O_3$ transparent conductive film and a $InGaO_3$ transparent conductive film having a small optical refraction index is formed thereon (see, for instance, Patent Literature 3).

Citation List

Patent Literatures

[Patent Literature 1]    JP-A-2007-317885
[Patent Literature 2]    JP-A-2005-64273
[Patent Literature 3]    JP-A-8-26225

## Summary of the Invention

### Problems to Be Solved by the Invention

However, conventional solar batteries having a light absorption layer provided by a compound of typical chalcopyrite crystalline structure cause cracking and partial breakage when an amorphous transparent electrode layer is divided by mechanical scribing, so that the amorphous transparent electrode layer cannot be favorably scribed (first problem).

Further, the upper electrode thin layer provided by AZO and the like exhibits low resistance after being crystallized. Crystallization of the upper electrode thin layer by heat-film formation or post-annealing results in: reduction in semiconductor characteristics on account of transferring of the S component contained in the buffer layer (CdS or InS); reduction in hole-blocking effect on account of reduction in the resistance of the buffer layer; and reduction in electro-coupling properties on account of energy barrier generated by boundaries formed at an interface with an n-type semiconductor layer formed between the buffer layer and the transparent electrode layer. When the boundaries are formed in solar battery devices, since the bonding area at the interface is small, electro-coupling properties are decreased during long-time use of the solar battery devices, thus impairing reliability (second problem).

Further, though a high energy conversion efficiency has been desired in a limited installation area, further higher energy conversion efficiency has been desired for the solar batteries that form a light absorption layer by the conventional chalcopyrite crystalline structure (third problem).

In addition, a conventional thin-film solar battery device requires that a highly resistant buffer layer film such as ZnO is formed thereon with a transparent electrode layer made of a material different from that of the highly resistant buffer layer such as ZnOA1 as in the CIGS solar battery device disclosed in the Patent Literature 3. However, when the device structure is provided by sputtering, since the target material for forming a highly resistant buffer layer is highly resistant, only RF sputtering that is low in film-formation speed can be used. Accordingly, in order to manufacture the CIGS solar battery device, separate film-forming apparatuses have to be used (e.g. RF sputtering for forming the highly resistant buffer layer, and DC sputtering for forming the transparent electrode layer), so that substrates have to be transferred to another film-forming apparatus for each manufacturing step, thereby deteriorating the manufacturing efficiency of the CIGS solar battery devices. Further, in order to provide a device arrangement that is targeted for light containment for improving photoelectric conversion efficiency, since the film-formation material differs for each of the layers, additional steps such as transferring to another film-forming apparatus and exchanging target material are required, thereby deteriorating the manufacturing efficiency of the thin-film solar battery devices (fourth problem).

The present invention has been made in view of the above deficiencies.

An object of the present invention is to provide a photovoltaic element that has a light absorption layer that is provided by a compound having a chalcopyrite crystalline structure and still can be favorably processed and, consequently, is capable of improving a yield rate thereof, and a manufacturing method thereof.

Another object of the present invention is to provide a photovoltaic element that has a light absorption layer provided by a compound having a chalcopyrite crystalline structure and still can reduce an energy barrier at a boundary with a transparent electrode layer and, consequently, is capable of obtaining stable electro-coupling properties for a long time, and a manufacturing method thereof.

A still another object of the present invention is to provide a photovoltaic element that has a light absorption layer provided by a compound having a chalcopyrite crystalline structure and still can provide high energy conversion efficiency, and a manufacturing method thereof.

A further object of the present invention is to provide a photovoltaic element that exhibits excellent light containment properties, excellent surface antireflective properties, excellent photoelectric conversion efficiency and excellent manufacturing efficiency, and a manufacturing method thereof.

### Means for Solving the Problems

A photovoltaic element according to an aspect of the invention includes: a glass substrate; a pair of backside electrode layers provided on a side of the glass substrate; a p-type conductive light absorption layer that is layered to bridge the pair of backside electrode layer, the light absorption layer being provided by a chalcopyrite-structure compound; a light-transmissive n-type buffer layer that is layered on the light absorption layer and forms a p-n junction with the light absorption layer; and a light-transmissive transparent electrode layer that is layered on the buffer layer to extend from a side of the layered light absorption layer and buffer layer to one of the pair of backside electrode layers, in which the transparent electrode layer has a film stress of $\pm 1 \times 10^9$ Pa or less.

In the above aspect of the invention, the transparent electrode layer is preferably provided by indium oxide and zinc oxide as primary components, the transparent electrode layer being formed into an amorphous layer having a grain size of 0.001 $\mu$m or less measured by observing a surface thereof by an atomic force microscope.

A photovoltaic element, comprising: a glass substrate; a backside electrode layer provided on a side of the glass substrate; a p-type conductive light absorption layer that is layered on the backside electrode layer, the light absorption layer being provided by a chalcopyrite-structure compound; a light-transmissive n-type buffer layer that is layered on the light absorption layer and forms a p-n junction with the light absorption layer; a light-transmissive n-type semiconductor layer that is layered on the buffer layer and exhibits a higher resistance than the buffer layer, the n-type semiconductor layer being n-type against the light absorption layer; and a light-transmissive transparent electrode layer that is layered on the n-type semiconductor layer to extend from a side of the layered light absorption layer, the buffer layer and the n-type semiconductor layer toward the backside electrode layer, in which the n-type semiconductor layer and the transparent electrode layer are provided by indium oxide and zinc oxide as primary components, a difference in a work function of the n-type semiconductor layer and a work function of the transparent electrode layer is less than 0.3 eV, and a difference in an energy band gap of the n-type semiconductor layer and an energy band gap of the transparent electrode layer is less than 0.2 eV.

In the above arrangement, the transparent electrode layer is preferably formed in an amorphous film containing indium oxide and zinc oxide as primary components.

Further, in the above arrangements, the transparent electrode layer is preferably formed by a sputtering using a mixture gas of argon and oxygen under at least one of conditions of: oxygen partial pressure of the mixture gas being in a range from $1 \times 10^{-3}$ to $5 \times 10^{-2}$ Pa; and a substrate temperature in a range from 100 to 200 degrees Celsius, so that the transparent electrode layer is formed in an amorphous film.

In the above arrangements, the transparent electrode layer preferably contains $In_2O_3$ and ZnO that are contained at a ratio of $In_2O_3/(In_2O_3+ZnO)$ being in a range from 50 to 95 mass%.

Further, in the above arrangements, the transparent electrode layer preferably contains a third component in addition to indium oxide and zinc oxide as primary components, the third component being contained in 20 mass% or less.

In the above arrangements, a light-transmissive n-type semiconductor layer that is layered on the buffer layer and exhibits a higher resistance than the buffer layer, the n-type semiconductor layer being n-type against the light absorption layer is preferably further provided.

In the above arrangements, the n-type semiconductor layer is preferably formed by a sputtering using a mixture gas of argon and oxygen under at least one of conditions of: oxygen partial pressure of the mixture gas being in a range from $1 \times 10^{-2}$ to 0.2 Pa; and a substrate temperature in a range from 100 to 200 degrees Celsius, so that the n-type semiconductor layer is formed in a high-resistance amorphous film.

Further, in the above arrangements, the n-type semiconductor layer is preferably formed into an amorphous layer having a grain size of 0.001 $\mu$m or less measured by observing a surface thereof by an atomic force microscope.

Further, in the above arrangements, the n-type semiconductor layer is preferably provided by the same material as the transparent electrode layer.

Furthermore, in the above arrangements, the n-type semiconductor layer preferably has a film stress of $\pm 1 \times 10^9$ Pa or less.

In the above arrangements, the n-type semiconductor layer is preferably formed by a sputtering using a mixture gas of argon and oxygen under at least one of conditions of: oxygen partial pressure of the mixture gas being in a range from $1 \times 10^{-2}$ to 0.2 Pa; and a substrate temperature in a range from 100 to 200 degrees Celsius, so that the n-type semiconductor layer is formed in an amorphous film.

Further, in the above arrangements, a conductive and light-transmissive surface transparent electrode layer that is layered on the transparent electrode, the surface transparent electrode layer having a refractivity smaller than a refractivity of the transparent electrode layer is preferably provided.

Further, in the above arrangement, the surface transparent electrode layer is preferably formed by a sputtering using a mixture gas of argon and oxygen under at least one of conditions of: oxygen partial pressure of the mixture gas being in a range from $1 \times 10^{-3}$ to $5 \times 10^{-2}$ Pa; and a substrate temperature in a range from 100 to 200 degrees Celsius, so that the transparent electrode layer is formed in an amorphous film.

Further, in the above arrangements, the surface transparent electrode layer is preferably provided by the same material as the transparent electrode layer.

Furthermore, in the above arrangements, the surface transparent electrode layer preferably has a film stress of $\pm 1 \times 10^9$ Pa or less.

A photovoltaic element according to another aspect of the invention includes: a glass substrate; a backside electrode layer provided on a side of the glass substrate; a p-type conductive light absorption layer that is layered on the backside electrode layer, the light absorption layer being provided by a chalcopyrite-structure compound; a light-transmissive n-type buffer layer that is layered on the light absorption layer; a light-transmissive n-type semiconductor layer that is layered on the buffer layer and exhibits a higher resistance than the buffer layer, the n-type semiconductor layer being n-type against the light absorption layer; a transparent electrode layer that is layered on the n-type semiconductor layer; and a surface transparent electrode layer that is layered on the transparent electrode layer, in which the n-type semiconductor layer, the transparent electrode layer and the surface transparent electrode layer are provided by the same amorphous film-forming material, a refractivity of the transparent electrode layer is larger than a refractivity of the n-type semiconductor layer, and a refractivity of the surface transparent electrode layer is smaller than the refractivity of the transparent electrode layer.

In the above aspect, the refractivity of the n-type semiconductor layer is preferably in a range from 1.6 to 2.0, the refractivity of the transparent electrode layer is in a range from 1.8 to 2.3, and the refractivity of the surface transparent electrode layer is in a range from 1.6 to 2.0.

In the above aspect of the invention, the film-forming material is preferably an oxide of at least one of elements selected from the group consisting of indium (In), zinc (Zn), tin (Sn), aluminum (A1), gallium (Ga), tungsten (W), cerium (Ce) and titanium (Ti).

A manufacturing method of a photovoltaic element according to still another aspect of the invention includes: a backside-electrode-layer forming step for thinly forming a backside electrode layer on a glass substrate; a light-absorption-layer forming step for thinly forming a p-type light absorption layer on the backside electrode layer, the light absorption layer being provided by a chalcopyrite-structure compound; a buffer-layer forming step for thinly forming an n-type buffer layer on the light absorption layer, the buffer layer forming a p-n junction with the light absorption layer; and a transparent electrode-layer forming step for forming a transparent electrode layer on the buffer layer, in which in the transparent electrode-layer forming step, the transparent electrode layer is thinly formed to exhibit a film stress or $\pm 1 \times 10^9$ Pa or less.

In the above aspect of the invention, in the transparent electrode-layer forming step, the transparent electrode layer is preferably provided by indium oxide and zinc oxide as primary components, the transparent electrode layer being formed into an amorphous layer having grain size of 0.001 $\mu$m or less measured by observing a surface thereof by an atomic force microscope.

A manufacturing method of a photovoltaic element according to further aspect of the invention includes: a backside-electrode-layer forming step for thinly forming a backside electrode layer on a glass substrate; a light-absorption-layer forming step for thinly forming a p-type light absorption layer on the backside electrode layer, the light absorption layer being provided by a chalcopyrite-structure compound; a buffer-layer forming step for thinly forming an n-type buffer layer on the light absorption layer, the buffer layer forming a p-n junction with the light absorption layer; a transparent electrode-layer forming step for forming a transparent electrode layer on the buffer layer; and a first scribing step for, after forming the buffer layer in the buffer-layer forming step, scribing the light absorption layer and the buffer layer that are layered on the backside electrode layer to provide a predetermined insulation distance therebetween to expose the backside electrode layer, in which, in the transparent electrode-layer forming step, the transparent electrode layer that is layered on the buffer layer in an amorphous film by indium oxide and zinc oxide as primary components, the transparent electrode layer reaching to the backside electrode layer exposed in the first scribing step, and after the transparent electrode layer is formed in the transparent electrode-layer forming step, a second scribing step in which the transparent electrode layer is subjected to a mechanical scribing at a predetermined insulation distance therebetween to provide a series connection of the photovoltaic element is performed.

A manufacturing method of a photovoltaic element according to still further aspect of the invention includes: a backside-electrode-layer forming step for thinly forming a backside electrode layer on a glass substrate; a light-absorption-layer forming step for thinly forming a p-type light absorption layer on the backside electrode layer, the light absorption layer being provided by a chalcopyrite-structure compound; a buffer-layer forming step for thinly forming an n-type buffer layer on the light absorption layer, the buffer layer forming a p-n junction with the light absorption layer; an n-type semiconductor-layer forming step for thinly forming a light-transmissive n-type semiconductor layer that exhibits a higher resistance than the buffer layer and is n-type against the light absorption layer; and a transparent electrode-layer forming step for forming a transparent electrode layer on the n-type semiconductor layer, in which, in the n-type semiconductor-layer forming step and the transparent electrode-layer forming step, the n-type semiconductor layer and the transparent electrode layer are thinly provided by indium oxide and zinc oxide as primary components so that a difference in a work function of the n-type semiconductor layer and a work function of the transparent electrode layer is less than 0.3 eV, and a difference in an energy band gap of the n-type semiconductor layer and an energy band gap of the transparent electrode layer is less than 0.2 eV.

A manufacturing method of a photovoltaic element according to still further aspect of the invention includes: a backside-electrode-layer forming step for thinly forming a backside electrode layer on a glass substrate; a light-absorption-layer forming step for thinly forming a p-type light absorption layer on the backside electrode layer, the light absorption layer being provided by a chalcopyrite-structure compound; a buffer-layer forming step for thinly forming a light-transmissive n-type buffer layer on the light absorption layer; an n-type semiconductor-layer forming step for thinly forming a light-transmissive n-type semiconductor layer that exhibits a higher resistance than the buffer layer and is n-type against the light absorption layer; a transparent electrode-layer forming step for forming a transparent electrode layer on the n-type semiconductor layer; and a surface-transparent electrode-layer forming step for forming a surface transparent electrode layer on the transparent electrode layer, in which the n-type semiconductor layer, the transparent electrode layer and the surface transparent electrode layer are provided by the same amorphous material, a refractivity of the transparent electrode layer is larger than a refractivity of the buffer layer, and

a refractivity of the surface transparent electrode layer is smaller than the refractivity of the buffer layer, and the n-type semiconductor-layer forming step, the transparent electrode-layer forming step and the surface-transparent electrode-layer forming step are continuously performed using the same apparatus.

In the above aspect, the refractivity of the n-type semiconductor layer is preferably in a range from 1.6 to 2.0, the refractivity of the transparent electrode layer is preferably in a range from 1.8 to 2.3, and the refractivity of the surface transparent electrode layer is preferably in a range from 1.6 to 2.0.

Further, in the above aspects of the invention, in the n-type semiconductor-layer forming step, the n-type semiconductor layer is preferably formed by a film-forming process using a mixture gas of argon and oxygen under at least one of conditions of: oxygen partial pressure of the mixture gas being in a range from 1 x 10-2 to 0.2 Pa; and a temperature of the glass substrate being in a range from 100 to 200 degrees Celsius, so that the n-type semiconductor layer is formed in an amorphous film.

Further, in the above aspects of the invention, in the transparent electrode-layer forming step, the transparent electrode layer is preferably formed by the same film-forming process as in the n-type semiconductor-layer forming step using the mixture gas of argon and oxygen under at least one of conditions of: oxygen partial pressure of the mixture gas being in a range from $1 \times 10^{-3}$ to $5 \times 10^{-2}$ Pa; and a temperature of the glass substrate being in a range from 100 to 200 degrees Celsius, so that the transparent electrode layer is formed in an amorphous film.

Further, in the above aspects of the invention, the film-forming material is preferably an oxide of at least one of elements selected from the group consisting of indium (In), zinc (Zn), tin (Sn), aluminum (Al), gallium (Ga), tungsten (W), cerium (Ce) and titanium (Ti).

The photovoltaic element according to one of the aspects of the invention includes: the glass substrate; the backside electrode layers provided on a side of the glass substrate in a pair; the p-type conductive light absorption layer provided by a compound having a chalcopyrite-structure, the light absorption layer being layered bridging the backside electrode layers; the light-transmissive n-type buffer layer that forms a p-n junction with the light absorption layer, the buffer layer being layered on the light absorption layer; and the light-transmissive transparent electrode layer being layered on the buffer layer and extending along one side of the light absorption layer and the buffer layer to one of the backside electrode layers, where the transparent electrode layer is formed to have a film stress of $\pm 1 \times 10^9$ Pa or less. Thus, a transparent electrode that collects power generated by electromotive force of p-n junctions on which light is incident can be favorably processed without causing cracking or damages even by an easily processable mechanical scribing.

The photovoltaic element according to one of the above aspects of the invention includes: the glass substrate; the backside electrode layer provided on a side of the glass substrate; the p-type conductive light absorption layer provided by a compound having a chalcopyrite-structure, the light absorption layer being layered bridging the backside electrode layers; the light-transmissive n-type buffer layer that forms a p-n junction with the light absorption layer, the buffer layer being layered on the light absorption layer; and the light-transmissive transparent electrode layer being layered on the buffer layer and extending along one side of the light absorption layer and the buffer layer to one of the backside electrode layers, where the transparent electrode layer is provided by indium oxide and zinc oxide as primary components and is formed into an amorphous film having a grain size in a range from 0.0001 to 0.001 $\mu$m measured by observing a surface thereof by an atomic force microscope. Thus, no boundary is formed by the buffer layer or the n-type semiconductor layer provided between the buffer layer and the transparent electrode layer. In addition, since the grain size is small, more surface area of a coupling surface can be provided. Accordingly, stable electro-coupling properties can be provided. Thus, the photovoltaic element according this aspect exhibits stable electro-coupling properties after a long-term use, thus providing stable energy conversion efficiency for a long time.

The photovoltaic element according to one of the aspects of the invention includes: the glass substrate; the backside electrode layer provided on a side of the glass substrate; the p-type conductive light absorption layer provided by a compound having a chalcopyrite-structure, the light absorption layer being provided on the backside electrode layer; the light-transmissive n-type buffer layer that forms a p-n junction with the light absorption layer, the buffer layer being layered on the light absorption layer; the n-type semiconductor layer that has higher resistance than the buffer layer and forms a p-n junction with the light absorption layer, the n-type semiconductor layer being layered on the buffer layer; and the light-transmissive transparent electrode layer being layered on the n-type semiconductor layer and extending along one side of the light absorption layer, the buffer layer and the n-type semiconductor layer toward the backside electrode layer, the n-type semiconductor layer being provided by indium oxide and zinc oxide as primary components, where a difference in the work function between the n-type semiconductor layer and the transparent electrode layer is less than 0.3 eV and a difference in the energy band gap between the n-type semiconductor layer and the transparent electrode layer is less than 0.2 eV. Accordingly, simply by providing the n-type semiconductor layer that exhibits a predetermined high resistance, the movement of the holes and electrons can be effectively controlled and high energy conversion efficiency can be achieved.

In one of the aspects of the invention, the n-type semiconductor layer, the transparent electrode layer and the surface transparent electrode layer are provided by the same amorphous film-forming material, the refractivity of the transparent electrode layer being larger than the refractivity of the n-type semiconductor layer and the refractivity of the surface transparent electrode layer is smaller than the refractivity of the transparent electrode layer and the n-type semiconductor layer, the transparent electrode layer and the surface transparent electrode layer being continuously formed using the same apparatus. Accordingly, the refraction of light at the surface transparent electrode layer can be restrained to the minimum, so that the light incident on the transparent electrode layer is effectively reflected thereinside, thus enhancing light containment effect. Thus, a photovoltaic element with a high photoelectric conversion efficiency can be obtained.

Further, the photovoltaic element can form the above layer structure that exhibits the refractivity relationship without exchanging the film-forming material or switching the manufacturing machines for each of the layer-forming steps, Thus, a photovoltaic element with a high photoelectric conversion efficiency can be obtained at a high production efficiency.

Brief Description of Drawings

Fig. 1 is a cross section schematically showing an arrangement of a photovoltaic element according to first to third exemplary embodiments of the invention.
Fig. 2 is a cross section schematically showing an arrangement of a photovoltaic element according to a fourth exemplary embodiment of the invention.

Description of Embodiments

Exemplary embodiments of the invention will be described below with reference to the attached drawings.

First Exemplary Embodiment

A first exemplary embodiment of the invention will be described in detail below.

Arrangement of Photovoltaic Element

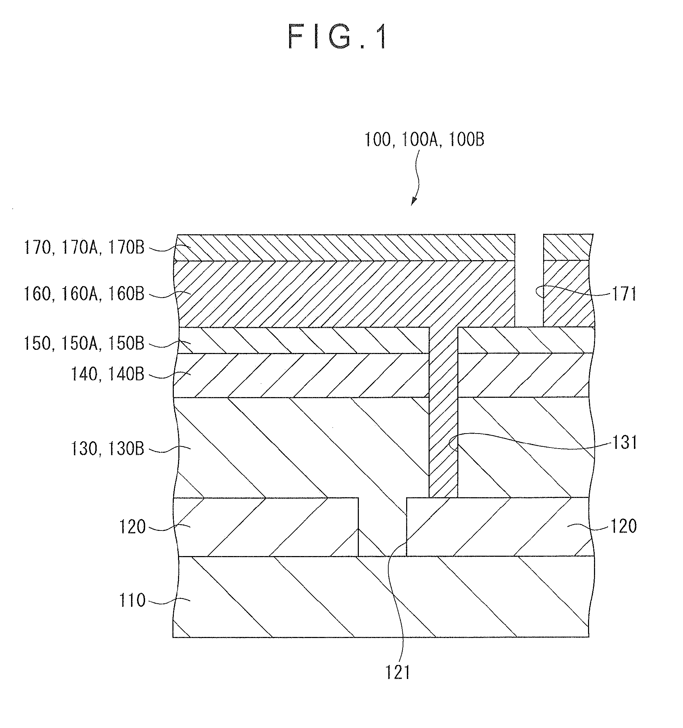

Fig. 1 is a cross section schematically showing a photovoltaic element of a solar battery according to the invention, in which reference numeral 100 denotes the photovoltaic element that generates an electromotive force by a light incident thereon. A plurality of the photovoltaic elements 100 are, for instance, connected in series to form a solar battery that produces electric energy.

The photovoltaic element 100 includes a glass substrate 110 and: a backside electrode layer 120; a light absorption layer 130; a buffer layer 140; an n-type semiconductor layer 150; a transparent electrode layer 160; and a surface transparent electrode layer 170 that are sequentially layered on the glass substrate 110.

The glass substrate 110 is provided by, for instance, alkali glass such as soda-lime glass, which, however, is not limitative.

Backside Electrode Layer

The backside electrode layer 120 is formed by a conductive material in a thin film on a side of the glass substrate 110. A plurality of the backside electrode layers 120 are juxtaposed with an insulation distance therebetween so that a planar area thereof is defined in a predetermined size. Each of the backside electrode layers 120 is provided by, for instance, forming a layer of Mo (molybdenum) by DC sputtering and the like and, subsequently, dividing the layer at the width of the insulation distance by laser beam irradiation and the like. A groove between the backside electrode layers 120 that has a width of the insulation distance is denoted as a dividing groove 121 in Fig. 1.

The exemplary conductive material is Mo since the light absorption layer 130 is exemplarily provided by CIGS material (described below in detail). However, the conductive material may alternatively be a metal such as gold, silver, copper, aluminum, nickel, iron, chromium, molybdenum, tungsten, titanium, cobalt, tantalum, niobium and zirconium and an alloy thereof. Among them, a highly reflective metal is especially preferable. The film-forming process may be vapor deposition, various sputtering, CVD, spraying, spin-on method and dipping instead of DC sputtering.

The backside electrode layer 120 preferably has a thickness in a range from 0.01 to 1 $\mu$m, more preferably from 0.1 to 1 $\mu$m. When the backside electrode layer 120 is thinner than 0.01 $\mu$m, the resistance value thereof may be increased. On the other hand, when the backside electrode layer 120 is thicker than 1 $\mu$m, the backside electrode layer 120 may be peeled off. Thus, the thickness of the backside electrode layer 120 is set in a range from 0.01 to 1 $\mu$m, preferably from 0.1 to 1 $\mu$m.

Further, the backside electrode layer 120 may not have a flat surface but may have irregularities on the surface thereof to diffusely reflect the light. Specifically, the long-wavelength light that cannot be fully absorbed by the layered light absorption layer 130 is diffused to lengthen the optical path length in the light absorption layer 130, so that long-wavelength sensitivity of the photovoltaic element 100 can be improved and short-circuit current can be increased. As a result, a photoelectric conversion efficiency can be improved. Incidentally, the irregularities for diffusing the light preferably have difference in height between tops and bottoms thereof (Rmax) in a range from 0.2 to 2.0 $\mu$m. When the Rmax is larger than 2.0 $\mu$m, coverage performance may be deteriorated, film thickness unevenness may be caused and, consequently, resistance may become uneven. Accordingly, it is preferable that, when the irregularities are provided, Rmax is set in a range from 0.2 to 2.0 $\mu$m. The irregularities may be provided by various processes such as dry etching, wet etching, sandblasting and heating.

Light Absorption Layer

The light absorption layer 130 is provided as a thin film of a p-type conductive chalcopyrite compound (a compound having chalcopyrite structure) that bridges upper sides of the backside electrode layers 120.
Specifically, the light absorption layer 130 may be provided by a group-II-VI semiconductor such as ZnSe, CdS and ZnO, group-III-V semiconductor such as GaAs, InP and GaN, group-IV semiconductor such as SiC and SiGe and chalcopyrite semiconductor (group I-III-VI semiconductor) such as $Cu(In,Ga)Se_2$, $Cu(In,Ga)(Se,S)_2$ and $CuInS_2$. In this exemplary embodiment, the so-called CIGS light absorption layer 130 that is formed of Cu, In, Ga and Se in a thin film by sputtering, vapor deposition and the like is exemplarily provided. In other words, various materials are used in various film-forming processes in order to provide chalcopyrite-structure composition when being formed in a film.
The film is, for instance, manufactured by multi-source vapor deposition using a molecular beam epitaxy device.
The light absorption layer 130 preferably has a thickness in a range from 0.1 to 10 $\mu$m, more preferably from 0.5 to 5 $\mu$m. When the light absorption layer 130 is thinner than 0.1 $\mu$m, the light absorption amount may be reduced. On the other hand, when the light absorption layer 130 is thicker than 10 $\mu$m, the productivity may be deteriorated or the light absorption layer 130 may be likely to be peeled off on account of film stress. Thus, the thickness of the light absorption layer 130 is set in a range from 0.1 to 10 $\mu$m, preferably from 0.5 to 5 $\mu$m.
Incidentally, after the light absorption layer 130 is formed on the backside electrode layer 120 and a below-described buffer layer 140 is formed thereon, the light absorption layer 130 is divided to expose the backside electrode layer 120 by, for instance, mechanical scribing, so that the light absorption layer 130 bridges the adjacent backside electrode layers 120. The light absorption layer 130 can be provided by various alternative processes such as, for instance, selenization of Cu-In-Ga while annealing. The light absorption layer 130 is not limited to Cu, In, Ga and Se.

Buffer Layer

The buffer layer 140 is formed in a thin film on an upper side of the light absorption layer 130. The buffer layer 140 is a light-transmissive relatively low-resistance n-type semiconductor layer that is layered on the light absorption layer 130 to form a p-n junction. Further, the buffer layer 140 also serves as a barrier against a half-metal resistance layer such as $Cu_2Se$ residing on the surface of the light absorption layer 130 to serve as a shunt path.
The buffer layer 140 is provided in a thin film by, for instance, solution growth of InS. The film is, for instance, manufactured under a manufacturing condition of CBD (Chemical Bath Deposition).
The buffer layer 140 preferably has a thickness in a range from 0.01 to 0.5 $\mu$m, more preferably from 0.1 to 0.5 5 $\mu$m. When the buffer layer 140 is thinner than 0.01 $\mu$m, p-n junction may become uneven. On the other hand, when the buffer layer 140 is thicker than 0.5 $\mu$m, the external light is blocked and the light absorption amount of the light absorption layer 130 may be reduced. Thus, the thickness of the buffer layer 140 is set in a range from 0.01 to 0.5 $\mu$m, preferably from 0.1 to 0.5 $\mu$m.
Incidentally, though InS is exemplarily used since CIGS material is exemplarily used as the light absorption layer 130, any material can be used as long as the material can favorably form a p-n junction with the light absorption layer 130.
The buffer layer 140 is divided together with the light absorption layer 130 when the mechanical scribing is applied on the light absorption layer 130 as described above.

N-Type Semiconductor Layer

The n-type semiconductor layer 150 is an amorphous layer formed in a thin film on an upper side of the buffer layer 140. The n-type semiconductor layer 150 is a light-transmissive and relatively high-resistance n-type semiconductor layer that serves as a carrier of electrons in contrast to the light absorption layer 130 that serves as a carrier of holes. Further, the n-type semiconductor layer 150 prevents the decrease in the open end voltage.
The n-type semiconductor layer 150 is formed by, for instance, subjecting In and zinc (Zn) to DC sputtering or vapor deposition in an atmosphere of appropriate oxygen concentration, or by subjecting a composition containing indium oxide and zinc oxide as primary components to DC sputtering or vapor deposition. Incidentally, the composition of the n-type semiconductor layer 150 is not limited to ($In_2O_3$ + ZnO) but may contain additional conductive metal oxide such as $SnO_2$.

The n-type semiconductor layer 150 is formed by a sputtering using a mixture gas of, for instance, argon (Ar) and oxygen ($O_2$) under (especially in DC sputtering) at least one of the conditions of: oxygen partial pressure $pO_2$ being in a range from $1 \times 10^{-2}$ to 0.2 Pa; and substrate temperature in a range from 100 to 200 degrees Celsius. The n-type semiconductor layer 150 is made as an amorphous film with a film stress of $\pm 1 \times 10^9$ Pa or less. The substrate temperature is a temperature of a surface of the substrate on which the buffer layer 140 has been formed and the n-type semiconductor layer 150 is to be formed.

When the oxygen partial pressure $pO_2$ is lower than $1 \times 10^{-2}$ Pa, a low-resistance film may be formed. On the other hand, when the oxygen partial pressure $pO_2$ is higher than 0.2 Pa, plasma discharge in DC sputtering film-forming process may become unstable, so that the film may not be stably formed. Further, when the substrate temperature falls below 100 degrees Celsius, interfacial reaction between the component of n-type buffer layer 140 (e.g. sulfur(S)) and the n-type semiconductor layer 150 may not progress, so that the n-type semiconductor layer 150 may not exhibit a high resistance. On the other hand, when the substrate temperature exceeds 200 degrees Celsius, the n-type buffer layer 140 may be degraded.

The n-type semiconductor layer 150 preferably has a thickness in a range from 0.01 to 1 $\mu$m, more preferably from 0.1 to 1 $\mu$m. When n-type semiconductor layer 150 is thinner than 0.01 $\mu$m, the hole-blocking effect generated in the light absorption layer 130 may be reduced. On the other hand, when the n-type semiconductor layer 150 is thicker than 1 $\mu$m, the external light absorption of the light absorption layer 130 may be hindered. Thus, the thickness of the n-type semiconductor layer 150 is set in a range from 0.01 to 1 $\mu$m, preferably from 0.1 to 1 $\mu$m.

Further, as described above, the n-type semiconductor layer 150 is divided together with the light absorption layer 130 and the buffer layer 140 when the mechanical scribing is applied on the light absorption layer 130 and the buffer layer 140 as described above. A groove that is formed by the mechanical scribing and exposes the backside electrode layer 120 between the light absorption layers 130, the buffer layers 140 and the n-type semiconductor layer 150 is illustrated in Fig. 1 as a first process groove 131.

Transparent Electrode Layer

The transparent electrode layer 160 is thinly layered from an upper side of the n-type semiconductor layer 150 into the first process groove 131 that extends through the scribed light absorption layer 130, buffer layer 140 and n-type semiconductor layer 150 to the backside electrode layer 120.

The transparent electrode layer 160 is made of the same material as the n-type semiconductor layer 150, i.e. made of a material with ($In_2O_3$ + ZnO) as primary components and is made into an amorphous thin film by DC sputtering or vapor deposition. In other words, the same material of the transparent electrode layer 160 allows the transparent electrode layer 160 being formed by the same (common) apparatus.

The transparent electrode layer 160 is formed by a sputtering using a mixture gas of, for instance, argon (Ar) and oxygen ($O_2$) under (especially in DC sputtering similar to the formation of the n-type semiconductor layer 150) at least one of the conditions of: oxygen partial pressure $pO_2$ being in a range from $1 \times 10^{-3}$ to $5 \times 10^{-2}$ Pa; and substrate temperature in a range from 100 to 200 degrees Celsius, so that the transparent electrode layer 160 is made as an amorphous film with a film stress of $\pm 1 \times 10^9$ Pa or less. The substrate temperature is the temperature of a surface of the substrate on which the n-type semiconductor layer 150 has been formed and the transparent electrode layer 160 is to be formed.

When the oxygen partial pressure $pO_2$ is lower than $1 \times 10^{-3}$ Pa, transmissivity may be deteriorated. On the other hand, when the oxygen partial pressure $pO_2$ is higher than $5 \times 10^{-2}$ Pa, the resistance of the transparent electrode layer 160 may be unfavorably increased. Further, when the substrate temperature falls below 100 degrees Celsius, the stability of the transparent electrode layer 160 may be lowered. On the other hand, when the substrate temperature exceeds 200 degrees Celsius, the n-type buffer layer 140 may be degraded.

The transparent electrode layer 160 preferably has a thickness in a range from 0.01 to 1 $\mu$m, more preferably from 0.1 to 1 $\mu$m. When the transparent electrode layer 160 is thinner than 0.01 $\mu$m, a desired low-resistance film may not be obtained. On the other hand, when the transparent electrode layer 160 is thicker than 1 $\mu$m, the light absorption efficiency of the light absorption layer 130 may be decreased. Thus, the thickness of the transparent electrode layer 160 is set in a range from 0.01 to 1 $\mu$m, preferably from 0.1 to 1 $\mu$m

The transparent electrode layer 160 is divided after a below-described surface transparent electrode layer 170 is formed by, for instance, mechanical scribing so that the n-type semiconductor layer 150 is exposed to provide a serial connection of the photovoltaic element 100.

Surface Transparent Electrode Layer

The surface transparent electrode layer 170 has a refractivity smaller than that of the transparent electrode layer 160 and is thinly provided on an upper side of the transparent electrode layer 160 by the same material as that of the transparent electrode layer 160, i.e. made of a material with ($In_2O_3$ + ZnO) as primary components and is made as an amorphous film with a film stress of $\pm 1 \times 10^9$ Pa or less.

The surface transparent electrode layer 170 is formed by a sputtering using a mixture gas of, for instance, argon (Ar) and oxygen ($O_2$ under (especially in DC sputtering similar to the formation of the n-type semiconductor layer 150 and the transparent electrode layer 160) at least one of the conditions of: oxygen partial pressure $pO_2$ being in a range from $1 \times 10^{-3}$ to $5 \times 10^{-2}$ Pa; and substrate temperature in a range from 100 to 200 degrees Celsius, so that the surface transparent electrode layer 170 is made as an amorphous film. The substrate temperature is temperature of a surface of the substrate on which the transparent electrode layer 160 has been formed and the surface transparent electrode layer 170 is to be formed.

When the oxygen partial pressure $pO_2$ is lower than $1 \times 10^{-3}$ Pa, transmissivity may be deteriorated. On the other hand, when the oxygen partial pressure $pO_2$ is higher than $5 \times 10^{-2}$ Pa, the resistance of the surface transparent electrode layer 170 may be unfavorably increased. Further, when the substrate temperature falls below 100 degrees Celsius, the stability of the surface transparent electrode layer 170 may be lowered. On the other hand, when the substrate temperature exceeds 200 degrees Celsius, the n-type buffer layer 140 may be degraded.

The surface transparent electrode layer 170 preferably has a thickness in a range from 0.01 to 1 $\mu$m, more preferably from 0.1 to 1 $\mu$m. When the surface transparent electrode layer 170 is thinner than 0.01 $\mu$m, the anti-reflective effect is reduced, so that the external light entering on the light absorption layer 130 may be blocked to reduce the light absorption of the light absorption layer 130. When the surface transparent electrode layer 170 is thicker than 1 $\mu$m, the transmissivity is reduced, so that the external light entering on the light absorption layer 130 may be blocked to reduce the light absorption of the light absorption layer 130. Thus, the thickness of the surface transparent electrode layer 170 is set in a range from 0.01 to 1 $\mu$m, preferably from 0.1 to 1 $\mu$m.

The surface transparent electrode layer 170 is divided together with the transparent electrode layer 160 when the mechanical scribing is applied on the transparent electrode layer 160 as described above. A groove that is formed by the mechanical scribing and exposes the n-type semiconductor layer 150 between the transparent electrode layer 160 and the surface transparent electrode layer 170 is illustrated in Fig. 1 as a second process groove 171.

Manufacture Operation of Photovoltaic Element

Next, an operation for manufacturing the photovoltaic element 100 will be described below.

In order to manufacture the photovoltaic element 100, a backside electrode layer forming step, a light absorption layer forming step, a buffer layer forming step, an n-type semiconductor layer forming step, a first scribing step, a transparent electrode-layer forming step, a surface transparent electrode-layer forming step and a second scribing step are sequentially performed.

Backside Electrode Layer Forming Step

In the backside electrode layer forming step, the backside electrode layer 120 is thinly formed on the glass substrate 110.

Specifically, an electrode material such as Mo (molybdenum) is formed into a film on the glass substrate 110 in thickness in a range from 0.01 to 1 $\mu$m, preferably from 0.1 to 1 $\mu$m by various film-forming processes such as DC sputtering. Then, after the film formation, the dividing groove 121 is formed at a width of the insulation distance by laser-beam irradiation, mechanical scribing, etching and the like so as to parallely divide and provide the backside electrode layer 120 with a predetermined planar area.

Light Absorption Layer Forming Step

In the light absorption layer forming step, the light absorption layer 130 is thinly formed on the backside electrode layer 120 formed on the glass substrate 110 during the backside electrode layer forming step in a manner bridging the dividing groove 121. Incidentally, in this exemplary embodiment, though the light absorption layer 130 is formed by dividing during the below-described first scribing after the film-formation substantially all over a side of the glass substrate 110, the forming step of the light absorption layer 130 is represented by the step in which the each of the layers is formed, for the convenience of explanation.

When the film is formed, a group-II-VI semiconductor such as ZnSe, CdS and ZnO, group-III-V semiconductor such as GaAs, InP and GaN, group-IV semiconductor such as SiC and SiGe and chalcopyrite semiconductor (group I-III-VI semiconductor) such as $Cu(In,Ga)Se_2$, $Cu(In,Ga)(Se,S)_2$ and $CuInS_2$ are used. The semiconductor material is formed into a film in the structure of chalcopyrite in a thickness in a range from 0.1 to 10 $\mu$m, preferably from 0.5 to 5 $\mu$m by various film-forming processes such as sputtering and vapor deposition.

Buffer Layer Forming Step

In the buffer layer forming step, the light-transmissive n-type buffer layer 140 that forms a p-n junction with the light absorption layer 130 is formed on the light absorption layer 130 formed during the light absorption layer forming step. Incidentally, in this exemplary embodiment, though the buffer layer 140 is formed simultaneously with the light absorption layer 130 after forming a film to be the light absorption layer 130 substantially all over a side of the glass substrate 110 and dividing together with the light absorption layer 130 during the below-described first scribing in a manner similar to the above-described light absorption layer 130, the forming step of the buffer layer 140 is represented by the step in which the each of the layers is formed, for the convenience of explanation.
The buffer layer 140 is thinly provided by solution growth of, for instance, InS under the manufacturing condition of CBD (Chemical Bath Deposition) to have a thickness in a range from 0.01 to 0.5 $\mu$m, preferably from 0.1 to 0.5 $\mu$m.

N-Type Semiconductor Layer Forming Step

In the n-type semiconductor layer forming step, the light-transmissive amorphous n-type semiconductor layer 150 that exhibits a higher resistance than the buffer layer 140 and is n-type against the light absorption layer 130 is thinly formed on the buffer layer 140 formed during the buffer layer forming step. Incidentally, in this exemplary embodiment, though the n-type semiconductor layer 150 is formed simultaneously with the light absorption layer 130 and the buffer layer 140 after forming a film to be the buffer layer 140 substantially all over a side of the glass substrate 110 and dividing together with the light absorption layer 130 and the buffer layer 140 during the first scribing in a manner similar to the above-described light absorption layer 130 and the buffer layer 140, the forming step of the n-type semiconductor layer 150 is represented by the step in which the each of the layers is formed, for the convenience of explanation.
In order to form the n-type semiconductor layer 150, for instance, In and zinc (Zn) are used under a predetermined condition. Specifically, the n-type semiconductor layer 150 is formed by vapor deposition or a sputtering using a mixture gas of, for instance, argon (Ar) and oxygen ($O_2$) under (especially in DC sputtering) at least one of the conditions of: oxygen partial pressure $pO_2$ being in a range from $1 \times 10^{-2}$ to 0.2 Pa; and substrate temperature in a range from 100 to 200 degrees Celsius. Alternatively, the n-type semiconductor layer 150 is provided by DC sputtering or vapor deposition using a composition with indium oxide and zinc oxide as primary components.
The n-type semiconductor layer 150 is thus formed in an amorphous film having a thickness in a range from 0.01 to 1 $\mu$m, preferably from 0.1 to 1 $\mu$m and a film stress of $\pm 1 \times 10^9$ Pa or less.

First Scribing Step

The first scribing step is a mechanical scribing for providing an element that generates an electromotive force at an effective area at which the backside electrode layer 120 and the light absorption layer 130 are opposed after the buffer layer 140 is formed on the light absorption layer 130 during the buffer layer forming step.
For instance, the layered n-type semiconductor layer 150, buffer layer 140 and light absorption layer 130 are scribed by laser beam irradiation using a 248-nm excimer laser to form the first process groove 131 and device the light absorption layer 130 and the buffer layer 140, thereby exposing the surface of the backside electrode layer 120.

Surface Transparent Electrode Layer Forming Step

In the transparent electrode-layer forming step, the amorphous transparent electrode layer 160 is thinly formed over an area ranging from the upper side of the n-type semiconductor layer 150 that is divided into plural sections by the first process groove 131 to a side of the backside electrode layer 120 facing an interior of the first process groove 131.
The transparent electrode layer 160 is formed by the same material and the same apparatus as that used for forming the n-type semiconductor layer 150. Specifically, the transparent electrode layer 160 is formed by a sputtering (especially DC sputtering) using a mixture gas of argon (Ar) and oxygen ($O_2$) under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius.
The transparent electrode layer 160 is thus formed in an amorphous film of which primary component is ($In_2O_3+ZnO$), so that the amorphous film has a thickness in a range from 0.01 to 1 $\mu$m, preferably from 0.1 to 1 $\mu$m and a film stress of $\pm 1 \times 10^9$ Pa or less.

Surface Transparent Electrode Layer Forming Step

In the surface transparent electrode-layer forming step, a layer of the same material as those of the n-type semiconductor layer 150 and the transparent electrode layer 160 is formed on an upper side of the transparent electrode layer 160 formed during the transparent electrode-layer forming step using the same apparatus. Specifically, the surface transparent electrode layer 170 is formed by a sputtering (especially DC sputtering) using a mixture gas of argon (Ar) and oxygen ($O_2$) under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius.
The surface transparent electrode layer 170 is thus formed in an amorphous film of which primary component is ($In_2O_3$+ZnO), the amorphous film having a thickness in a range from 0.01 to 1 $\mu$m, preferably from 0.1 to 1 $\mu$m and a film stress of $\pm 1 \times 10^9$ Pa or less.

Second Scribing Step

The second scribing step is a mechanical scribing for, after the surface transparent electrode layer 170 is formed during the surface transparent electrode-layer forming step, dividing the transparent electrode layer 160 and the surface transparent electrode layer 170 to provide an element with a serial connection.
The layered transparent electrode layer 160 and the surface transparent electrode layer 170 are scribed by, for instance, a mechanical scribing using a metal needle to form the second process groove 171 and divide the transparent electrode layer 160 and the surface transparent electrode layer 170, thereby exposing the surface of the n-type semiconductor layer 150. After this step, the adjacent photovoltaic elements 100 (thin-film layered semiconductors) on the glass substrate 110 are serially connected.

Advantages of the First Exemplary Embodiment

As described above, the photovoltaic element 100 according to this exemplary embodiment includes: the glass substrate 110; the backside electrode layers 120 provided on a side of the glass substrate 110 in a pair; the p-type conductive light absorption layer 130 provided by a compound having a chalcopyrite-structure, the light absorption layer 130 being layered bridging the backside electrode layers 120; the light-transmissive n-type buffer layer 140 that forms a p-n junction with the light absorption layer 130, the buffer layer 140 being layered on the light absorption layer 130; and the light-transmissive transparent electrode layer 160 being layered on the buffer layer 140 and extending along one side of the light absorption layer 130 and the buffer layer 140 to one of the backside electrode layers 120, where the transparent electrode layer 160 is formed in an amorphous thin film containing indium oxide and zinc oxide as primary components.
Thus, the transparent electrode that collects the electromotive force generated when a light is incident on the p-n junction can be favorably processed by the easily processable mechanical scribing without causing crackings and damages. Accordingly, productivity can be improved, the yield rate can be increased and production cost can be reduced (advantage 1-1).
Further, since the transparent electrode is provided by an amorphous material containing indium oxide and zinc oxide as primary components, excellent heat-resistance and light-resistance and consequent stable characteristics with less change in the optical characteristics can be provided to the transparent electrode, thus providing stable energy conversion efficiency for a long time. In addition, since the surface area at the interface between the bonded layers is increased, high reliability for the connecting at the interface can be provided (advantage 1-2).
The transparent electrode layer 160 is formed by a sputtering using the mixture gas of Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius, so that the transparent electrode layer 160 is made as an amorphous film with a film stress of $\pm 1 \times 10^9$ Pa or less.
Thus, accurate pattern processing is possible by a mechanical scribing using, for instance, simple metal needle, so that productivity can be enhanced (advantage 1-3).
Further, the light-transmissive n-type semiconductor layer 150 that exhibits a higher resistance than the buffer layer 140 and is n-type against the light absorption layer 130 is layered on the buffer layer 140.
Accordingly, the decrease in the open end voltage can be avoided (advantage 1-4).
The n-type semiconductor layer 150 is formed in a high resistance by a sputtering under a predetermined oxygen concentration using the mixture gas of Ar and $O_2$ under at least one of the conditions of: oxygen partial pressure $pO_2$ being in a range from $1 \times 10^{-2}$ to 0.2 Pa; and substrate temperature in a range from 100 to 200 degrees Celsius so that the n-type semiconductor layer 150 is made as an amorphous film with a film stress of $\pm 1 \times 10^9$ Pa or less.
Accordingly, a layer that avoids the decrease in the open end voltage can be easily obtained (advantage 1-5).
Further, the n-type semiconductor layer 150 is provided by the same material as the transparent electrode layer 160.

Accordingly, the n-type semiconductor layer 150 and the transparent electrode layer 160 can be formed by the same apparatus, so that productivity can be enhanced and, consequently, the production cost can be reduced. In addition, since the n-type semiconductor layer 150 and the transparent electrode layer 160 can be successively formed by the same (common) sputtering apparatus, the transparent electrode layer 160 can be successively formed without leaving open to the atmosphere, so that performance deterioration of the bonding interface on account of surface contamination can be avoided (advantage 1-6).

The n-type semiconductor layer 150 and the transparent electrode layer 160 are provided by indium oxide and zinc oxide.

Accordingly, an amorphous conductive thin film can be formed at a relatively low temperature. In addition, cracking and the like are not likely to be caused, high adhesion with the backside electrode layer 120 can be ensured and production at a favorable yield rate is possible (advantage 1-7).

Further, the conductive and light-transmissive surface transparent electrode layer 170 that is made of the same material as the transparent electrode layer 160 and has smaller refractivity than that of the transparent electrode layer 160 is layered on the transparent electrode layer.

Accordingly, the light can be efficiently entered, so that the light energy can be efficiently converted into the electric energy. In addition, as described above, since the surface transparent electrode layer 170 and the transparent electrode layer 160 can be successively formed by the same sputtering apparatus, the surface transparent electrode layer 170 can be successively formed without leaving open to the atmosphere, so that performance deterioration of the bonding interface on account of surface contamination can be avoided (advantage 1-8).

Examples of the First Exemplary Embodiment

Next, specific explanation of the present exemplary embodiment will be given below with reference to Examples. It should be understood that the scope of the present exemplary embodiment is by no means limited to the contents covered by the examples.

Preparation of Element Substrate

The backside electrode layer 120 containing Mo (molybdenum) as a primary component was formed in 0.1 $\mu$m thick on the soda-lime glass substrate 110 of 10 cm in height and width at room temperature using a DC magnetron sputtering system. The light absorption layer 130 containing CIGS as a primary component was formed thereon in 1 $\mu$m thick at 350 degrees Celsius by a coevaporation using a molecular beam epitaxy device from an evaporation source of CuS, InS, GaS and SeS. Further, the buffer layer 140 containing InS as a primary component was formed thereon in 0.1 $\mu$m thick at 100 degrees Celsius by a CBD method to provide an element substrate.

Measurement of Thickness

The thicknesses of the respective layers provided on the above element substrate and element substrates in the following Examples were measured by: providing a soda-lime glass provided with a thickness-measuring mask for each of the film-forming steps in addition to the element substrate; providing a step portion by removing the mask after each of the layers were formed; and measuring by a stylus (used instrument: DEKTAK3030 from SLOAN TECHNOLOGY).

Measurement of Film Stress

The film stresses of the n-type semiconductor layer 150, transparent electrode layer 160 and surface transparent electrode layer 170 in the following Examples were measured by: disposing a slide glass for measuring the film stress in each of the film-forming steps; fixing an end of the substrate; and measuring a displacement $\delta$ of a free end of the slide glass (cantilever method), thereby measuring the displacement of the slide glass before and after the film-formation.

$$\text{Film Stress } \sigma = ED^2\delta/(3(1-\upsilon)L^2d)$$

E: Young's modulus
$\upsilon$ : Poisson ratio of the substrate
D : thickness of the substrate
d : thickness of the thin film

L : length of the substrate

Scribing Test

In the scribing tests in the following Examples, a micro scratch tester (used instrument: MST from Centre Suisse d'Electronique et Microtechnique SA) was used to scratch by a scratch needle (diameter: 200 $\mu$m) at a load of 2N to observe film peeling after pattern-forming and generation of crackings under an optical microscope.

Example 1-1

Formation of N-Type Semiconductor Layer 150

The n-type semiconductor layer 150 was formed on the element substrate in 0.1 $\mu$m thick at room temperature using a DC magnetron sputtering system and an IZO target ($In_2O_3$: ZnO = 90 [mass%] : 10 [mass%]) at a sputtering pressure of 0.5 Pa and in a mixture gas of argon (Ar) and oxygen ($O_2$) with oxygen partial pressure being 0.2 Pa.

Formation of Transparent Electrode Layer 160

The transparent electrode layer 160 was formed on the n-type semiconductor layer 150 in 0.2 $\mu$m thick at room temperature using an IZO target ($In_2O_3$: ZnO = 90 [mass%] : 10 [mass%]) at a sputtering pressure of 0.5 Pa and in a mixture gas of argon (Ar) and oxygen ($O_2$) with oxygen partial pressure being 0.001 Pa.

Formation of Surface Transparent Electrode Layer 170

The surface transparent electrode layer 170 was formed on the transparent electrode layer 160 in 0.1 $\mu$m thick at 200 degrees Celsius using an IZO target ($In_2O_3$: ZnO = 90 [mass%] : 10 [mass%]) at a sputtering pressure of 0.5 Pa and in a mixture gas of argon (Ar) and oxygen ($O_2$) with oxygen partial pressure being 0.001 Pa.

Measurement of Film Stress

The film stresses of the n-type semiconductor layer 150, the transparent electrode layer 160 and the surface transparent electrode layer 170 were measured by the cantilever method using a slide glass. As a result, the film stress of the n-type semiconductor layer 150 was +0.2 $\times$ 10$^9$ Pa while the film stress of each of the transparent electrode layer 160 and the surface transparent electrode layer 170 was -0.1 $\times$ 10$^9$ Pa as shown in the following Table 1. Incidentally, n layer in the Tables represents the n-type semiconductor layer 150, TCO represents the transparent electrode layer 160 and S-TCO represents the surface transparent electrode layer 170.

Scribing Test

When the substrate in which the n-type semiconductor layer 150, the transparent electrode layer 160 and the surface transparent electrode layer 170 were formed on the element substrate was subjected to a scribing test for dividing the layered films of the transparent electrode layer 160 and the surface transparent electrode layer 170, no film-peeling and cracking were observed.

Examples 1-2 to 1-48 and Comparative Examples 1-1 to 1-24

The n-type semiconductor layer 150, the transparent electrode layer 160 and the surface transparent electrode layer 170 were formed on the element substrate in the same manner as the Example 1-1 except for the film-forming condition, composition of target and presence/absence of the surface transparent electrode layer 170, which were subjected to the film stress test and the scribing test. The results are shown in Tables 1 to 4.
Table 1

| | Classification | Layer | Target In2O3: ZnO (mass%) | Film-Forming Condition | | | | Film Stress ( × 10⁹Pa) | Scribing Test |
|---|---|---|---|---|---|---|---|---|---|
| | | | | Tsub (°C) | Total Pressure (Pa) | pO2 (Pa) | Film Thickness (nm) | | |
| Example 1-1 | n-PO2 | n layer | 90:10mass% | R. T. | 0.5 | 0.2 | 100 | 0.2 | |
| | | TCO | 90:10mass% | R. T. | 0.5 | 0.001 | 200 | -0.1 | No peeling and cracking |
| | | S-TCO | 90:10mass% | 200 | 0.5 | 0.001 | 100 | -0.1 | |
| Example 1-2 | n-PO2 | n layer | 90:10mass% | R. T. | 0.5 | 0.01 | 100 | -0.95 | |
| | | TCO | 90:10mass% | R. T. | 0.5 | 0.001 | 200 | -0.1 | No peeling and cracking |
| | | S-TCO | 90:10mass% | 200 | 0.5 | 0.001 | 100 | -0.1 | |
| Example 1-3 | n-Tsub | n layer | 90:10mass% | 100 | 0.5 | 0.009 | 100 | -0.9 | |
| | | TCO | 90:10mass% | R. T. | 0.5 | 0.001 | 200 | -0.1 | No peeling and cracking |
| | | S-TCO | 90:10mass% | 200 | 0.5 | 0.001 | 100 | -0.1 | |
| Example 1-4 | n-Tsub | n layer | 90:10mass% | 200 | 0.5 | 0.008 | 100 | -0.9 | |
| | | TCO | 90:10mass% | R. T. | 0.5 | 0.001 | 200 | -0.1 | No peeling and cracking |
| | | S-TCO | 90:10mass% | 200 | 0.5 | 0.001 | 100 | -0.1 | |
| Example 1-5 | n-Tsub | n layer | 90:10mass% | 100 | 0.5 | 0.01 | 100 | -0.8 | |
| | | TCO | 90:10mass% | R. T. | 0.5 | 0.001 | 200 | -0.1 | No peeling and cracking |
| | | S-TCO | 90:10mass% | 200 | 0.5 | 0.001 | 100 | -0.1 | |
| Example 1-6 | n-Tsub | n laver | 90:10mass% | 200 | 0.5 | 0.01 | 100 | -0.7 | |
| | | TCO | 90:10mass% | R. T. | 0.5 | 0.001 | 200 | -0.1 | No peeling and cracking |
| | | S-TCO | 90:10mass% | 200 | 0.5 | 0.001 | 100 | -0.1 | |
| Example 1-7 | n-PO2 | n layer | 90:10mass% | R. T. | 0.5 | 0.007 | 100 | -0.5 | |
| | | TCO | 90:10mass% | R. T. | 0.5 | 0.001 | 200 | -0.1 | No peeling and cracking |
| | | S-TCO | 90:10mass% | 200 | 0.5 | 0.001 | 100 | -0.1 | |

| | Classification | Layer | Target In2O3: ZnO (mass%) | Film-Forming Condition | | | | Film Stress ( × 10⁹Pa) | Scribing Test |
|---|---|---|---|---|---|---|---|---|---|
| | | | | Tsub (˚C) | Total Pressure (Pa) | pO2 (Pa) | Film Thickness (nm) | | |
| Example 1-8 | TCO-Tsub | n laver | 90:10mass% | 200 | 0.5 | 0.01 | 100 | -0.8 | |
| | | TCO | 90:10mass% | R. T. | 0.5 | 0.06 | 200 | -0.5 | No peeling and cracking |
| | | S-TCO | 90:10mass% | 200 | 0.5 | 0.001 | 100 | -0.1 | |
| Example 1-9 | STCO-Tsub | n layer | 90:10mass% | 200 | 0.5 | 0.01 | 100 | -0.8 | |
| | | TCO | 90:10mass% | R. T. | 0.5 | 0.001 | 200 | -0.1 | No peeling and cracking |
| | | S-TCO | 90:10mass% | 205 | 0.5 | 0.06 | 100 | -0.5 | |
| Comp. Example 1-1 | n-PO2 | n layer | 90:10mass% | R. T. | 0.5 | 0.009 | 100 | -1.1 | |
| | | TCO | 90:10mass% | R. T. | 0.5 | 0.001 | 200 | -0.1 | Peeling and cracking |
| | | S-TCO | 90:10mass% | 200 | 0.5 | 0.001 | 100 | -0.1 | |
| Comp. Example 1-2 | n-Tsub | n layer | 90:10mass% | 250 | 0.5 | 0.009 | 100 | -1.1 | |
| | | TCO | 90:10mass% | R. T. | 0.5 | 0.001 | 200 | -0.1 | Peeling and cracking |
| | | S-TCO | 90:10mass% | 200 | 0.5 | 0.001 | 100 | -0.1 | |

EP 2 360 733 A1

Table 2

| | Classification | Layer | Target In2O3: ZnO (mass%) | Film-Forming Condition | | | | Film Stress (× 10⁹Pa) | Scribing Test |
| | | | | Tsub (˚C) | Total Pressure (Pa) | pO2 (Pa) | Film Thickness (nm) | | |
|---|---|---|---|---|---|---|---|---|---|
| Example 1-10 | TCO-PO2 | n layer | 90:10mass% | R. T. | 0.5 | 0.2 | 100 | 0.2 | |
| | | TCO | 90:10mass% | R. T. | 0.5 | 0.05 | 200 | -0.5 | No peeling and cracking |
| | | S-TCO | 90:10mass% | 200 | 0.5 | 0.001 | 100 | -0.1 | |
| Example 1-11 | TCO-Tsub | n layer | 90:10mass% | R. T. | 0.5 | 0.2 | 100 | 0.2 | |
| | | TCO | 90:10mass% | 200 | 0.5 | 0.05 | 200 | -0.5 | No peeling and cracking |
| | | S-TCO | 90:10mass% | 200 | 0.5 | 0.001 | 100 | -0.1 | |
| Example 1-12 | TCO-Tsub | n layer | 90:10mass% | R. T. | 0.5 | 0.2 | 100 | 0.2 | |
| | | TCO | 90:10mass% | 200 | 0.5 | 0.06 | 200 | -0.5 | No peeling and cracking |
| | | S-TCO | 90:10mass% | 200 | 0.5 | 0.001 | 100 | -0.1 | |
| Example 1-13 | TCO-Tsub | n layer | 90:10mass% | R. T. | 0.5 | 0.2 | 100 | 0.2 | |
| | | TCO | 90:10mass% | 100 | 0.5 | 0.05 | 200 | -0.5 | No peeling and cracking |
| | | S-TCO | 90:10mass% | 200 | 0.5 | 0.001 | 100 | -0.1 | |
| Example 1-14 | TCO-Tsub | n layer | 90:10mass% | R. T. | 0.5 | 0.2 | 100 | 0.2 | |
| | | TCO | 90:10mass% | 100 | 0.5 | 0.06 | 200 | -0.5 | No peeling and cracking |
| | | S-TCO | 90:10mass% | 200 | 0.5 | 0.001 | 100 | -0.1 | |
| Comp.Example 1-3 | TCO-PO2 | n layer | 90:10mass% | R. T. | 0.5 | 0.2 | 100 | 0.2 | |
| | | TCO | 90:10mass% | R. T. | 0.5 | 0.06 | 200 | -1.05 | Peeling and cracking |
| | | S-TCO | 90:10mass% | 200 | 0.5 | 0.001 | 100 | -0.1 | |
| Comp.Example 1-4 | TCO-Tsub | n laver | 90:10mass% | R. T. | 0.5 | 0.2 | 100 | 0.2 | |
| | | TCO | 90:10mass% | 250 | 0.5 | 0.06 | 200 | -1.05 | Peeling and cracking |
| | | S-TCO | 90:10mass% | 200 | 0.5 | 0.001 | 100 | -0.1 | |

(continued)

| | Classification | Layer | Target In2O3: ZnO (mass%) | Film-Forming Condition | | | | Film Stress (× 10⁹Pa) | Scribing Test |
|---|---|---|---|---|---|---|---|---|---|
| | | | | Tsub (°C) | Total Pressure (Pa) | pO2 (Pa) | Film Thickness (nm) | | |
| Example 1-15 | TCO-Composition | n layer | 50:50mass% | R. T. | 0.5 | 0.2 | 100 | 0.2 | No peeling and cracking |
| | | TCO | 50:50mass% | R. T. | 0.5 | 0.001 | 200 | -0.1 | |
| | | S-TCO | 50:50mass% | 200 | 0.5 | 0.001 | 100 | -0.1 | |
| Example 1-16 | TCO-Composition | n layer | 95:5mass% | R. T. | 0.5 | 0.2 | 100 | -0.5 | No peeling and cracking |
| | | TCO | 95:5mass% | R. T. | 0.5 | 0.001 | 200 | -0.3 | |
| | | S-TCO | 95:5mass% | 100 | 0.5 | 0.001 | 100 | -0.3 | |
| Example 1-17 | TCO-Composition | n layer | 70:10:20mass% (SnO2) | R. T. | 0.5 | 0.2 | 100 | 0.2 | No peeling and cracking |
| | | TCO | 70:10: 20mass%SnO2) | R. T. | 0.5 | 0.001 | 200 | -0.1 | |
| | | S-TCO | 70:10:20mass% (SnO2) | 200 | 0.5 | 0.001 | 100 | -0.1 | |
| Comp.Example 1-5 | TCO-Composition | n layer | 45:55mass% | R. T. | 0.5 | 0.2 | 100 | -0.3 | Peeling and cracking |
| | | TCO | 45:55mass% | R. T. | 0.5 | 0.001 | 200 | -1.1 | |
| | | S-TCO | 45:55mass% | 200 | 0.5 | 0.001 | 100 | -1.2 | |
| Comp.Example 1-6 | TCO-Composition | n layer | 96:4mass% | R. T. | 0.5 | 0.2 | 100 | -0.8 | Peeling and cracking |
| | | TCO | 96:4mass% | R. T. | 0.5 | 0.001 | 200 | -1.3 | |
| | | S-TCO | 96:4mass% | 200 | 0.5 | 0.001 | 100 | -1.5 | |
| Comp.Example 1-7 | TCO-Composition | n laver | 68:10:22mass% (SnO2) | R. T. | 0.5 | 0.2 | 100 | -0.3 | Peeling and cracking |
| | | TCO | 68:10:22mass% (SnO2) | R. T. | 0.5 | 0.001 | 200 | -1.1 | |
| | | S-TCO | 68:10:22mass% (SnO2) | 200 | 0.5 | 0.001 | 100 | -1.2 | |

Table 3

| | Classification | Layer | Target In2O3: ZnO (mass%) | Film-Forming Condition | | | | Film Stress (× 10⁹Pa) | Scribing Test |
|---|---|---|---|---|---|---|---|---|---|
| | | | | Tsub (°C) | Total Pressure (Pa) | pO2 (Pa) | Film Thickness (nm) | | |
| Example 1-18 | n-PO2 | n layer | 90:10mass% | R. T. | 0.5 | 0.2 | 100 | 0.2 | No peeling and cracking |
| | | TCO | 90:10mass% | R. T. | 0.5 | 0.001 | 300 | -0.1 | |
| Example 1-19 | n-PO2 | n layer | 90:10mass% | R. T. | 0.5 | 0.01 | 100 | -0.95 | No peeling and cracking |
| | | TCO | 90:10mass% | R. T. | 0.5 | 0.001 | 300 | -0.1 | |
| Example 1-20 | n-Tsub | n layer | 90:10mass% | 100 | 0.5 | 0.009 | 100 | -0.9 | No peeling and cracking |
| | | TCO | 90:10mass% | R. T. | 0.5 | 0.001 | 300 | -0.1 | |
| Example 1-21 | n-Tsub | n layer | 90:10mass% | 200 | 0.5 | 0.008 | 100 | -0.9 | No peeling and cracking |
| | | TCO | 90:10mass% | R. T. | 0.5 | 0.001 | 300 | -0.1 | |
| Example 1-22 | n-Tsub | n laver | 90:10mass% | 100 | 0.5 | 0.01 | 100 | -0.8 | No peeling and cracking |
| | | TCO | 90:10mass% | R. T. | 0.5 | 0.001 | 300 | -0.1 | |
| Example 1-23 | n-Tsub | n layer | 90:10mass% | 200 | 0.5 | 0.01 | 100 | -0.7 | No peeling and cracking |
| | | TCO | 90:10mass% | R. T. | 0.5 | 0.001 | 300 | -0.1 | |
| Comp. Example 1-8 | n-PO2 | n layer | 90:10mass% | R. T. | 0.5 | 0.009 | 100 | -1.1 | Peeling and cracking |
| | | TCO | 90:10mass% | R. T. | 0.5 | 0.001 | 300 | -0.1 | |
| Comp. Example 1-9 | n-Tsub | n laver | 90:10mass% | 250 | 0.5 | 0.009 | 100 | -1.1 | Peeling and cracking |
| | | TCO | 90:10mass% | R. T. | 0.5 | 0.001 | 300 | -0.1 | |
| Example 1-24 | TCO-PO2 | n layer | 90:10mass% | R. T. | 0.5 | 0.2 | 100 | 0.2 | No peeling and cracking |
| | | TCO | 90:10mass% | R. T. | 0.5 | 0.05 | 300 | -0.5 | |
| Example 1-25 | TCO-Tsub | n laver | 90:10mass% | R. T. | 0.5 | 0.2 | 100 | 0.2 | No peeling and cracking |
| | | TCO | 90:10mass% | 200 | 0.5 | 0.05 | 300 | -0.5 | |
| Example 1-26 | TCO-Tsub | n layer | 90:10mass% | R. T. | 0.5 | 0.2 | 100 | 0.2 | No peeling and cracking |
| | | TCO | 90:10mass% | 200 | 0.5 | 0.06 | 300 | -0.5 | |

| | Classification | Layer | Target In2O3: ZnO (mass%) | Film-Forming Condition | | | | Film Stress (× 10⁹Pa) | Scribing Test |
|---|---|---|---|---|---|---|---|---|---|
| | | | | Tsub (˚C) | Total Pressure (Pa) | pO2 (Pa) | Film Thickness (nm) | | |
| Example 1-27 | TCO-Tsub | n layer | 90:10mass% | R. T. | 0.5 | 0.2 | 100 | 0.2 | No peeling and cracking |
| | | TCO | 90:10mass% | 100 | 0.5 | 0.05 | 300 | -0.5 | |
| Example 1-28 | TCO-Tsub | n layer | 90:10mass% | R. T. | 0.5 | 0.2 | 100 | 0.2 | No peeling and cracking |
| | | TCO | 90:10mass% | 100 | 0.5 | 0.06 | 300 | -0.5 | |
| Comp. Example 1-10 | TCO-PO2 | n layer | 90:10mass% | R. T. | 0.5 | 0.2 | 100 | 0.2 | Peeling and cracking |
| | | TCO | 90:10mass% | R. T. | 0.5 | 0.06 | 300 | -1.05 | |
| Comp. Example 1-11 | TCO-Tsub | n laver | 90:10mass% | R. T. | 0.5 | 0.2 | 100 | 0.2 | Peeling and cracking |
| | | TCO | 90:10mass% | 250 | 0.5 | 0.06 | 300 | -1.05 | |
| Example 1-29 | TCO-Composition | n layer | 50:50mass% | R. T. | 0.5 | 0.2 | 100 | 0.2 | No peeling and cracking |
| | | TCO | 50:50mass% | R. T. | 0.5 | 0.001 | 300 | -0.1 | |
| Example 1-30 | TCO-Composition | n laver | 95:5mass% | R. T. | 0.5 | 0.2 | 100 | -0.5 | No peeling and cracking |
| | | TCO | 95:5mass% | R. T. | 0.5 | 0.001 | 300 | -0.3 | |
| Example 1-31 | TCO-Composition | n layer | 70:10: 20mass% (SnO2) | R. T. | 0.5 | 0.2 | 100 | 0.2 | No peeling and cracking |
| | | TCO | 70:10: 20mass% (SnO2) | R. T. | 0.5 | 0.001 | 300 | -0.1 | |
| Comp. Example 1-12 | TCO-Composition | n laver | 45:55mass% | R. T. | 0.5 | 0.2 | 100 | -0.3 | Peeling and cracking |
| | | TCO | 45:55mass% | R. T. | 0.5 | 0.001 | 300 | -1.1 | |
| Comp. Example 1-13 | TCO-Composition | n layer | 96:4mass% | R. T. | 0.5 | 0.2 | 100 | -0.8 | Peeling and cracking |
| | | TCO | 96:4mass% | R. T. | 0.5 | 0.001 | 300 | -1.3 | |

EP 2 360 733 A1

22

(continued)

| | Classification | Layer | Target In2O3:ZnO (mass%) | Film-Forming Condition | | | | Film Stress (× 10⁹Pa) | Scribing Test |
|---|---|---|---|---|---|---|---|---|---|
| | | | | Tsub (˚C) | Total Pressure (Pa) | pO2 (Pa) | Film Thickness (nm) | | |
| Comp. Example 1-14 | TCO-Composition | n layer | 68:10:22mass% (SnO2) | R. T. | 0.5 | 0.2 | 100 | -0.3 | Peeling and cracking |
| | | TCO | 68:10:22mass% (SnO2) | R. T. | 0.5 | 0.001 | 300 | -1.1 | |

Table 4

| | Classification | Layer | Target In2O3: ZnO (mass%) | Film-Forming Condition | | | | Film Stress (× 109Pa) | Scribing Test |
|---|---|---|---|---|---|---|---|---|---|
| | | | | Tsub (˚C) | Total Pressure | pO2 (Pa) | Film Thickness | | |
| Example 1-32 | TCO-PO2 | TCO | 90:10mass% | R. T. | 0.5 | 0.05 | 200 | -0.5 | No peeling and cracking |
| | | S-TCO | 90:10mass% | 200 | 0.5 | 0.001 | 100 | -0.1 | |
| Example 1-33 | TCO-Tsub | TCO | 90:10mass% | 200 | 0.5 | 0.05 | 200 | -0.5 | No peeling and cracking |
| | | S-TCO | 90:10mass% | 200 | 0.5 | 0.001 | 100 | -0.1 | |
| xample 1-34 | TCO-Tsub | TCO | 90:10mass% | 200 | 0.5 | 0.06 | 200 | -0.5 | No peeling and cracking |
| | | S-TCO | 90:10mass% | 200 | 0.5 | 0.001 | 100 | -0.1 | |
| Example 1-35 | TCO-Tsub | TCO | 90:10mass% | 100 | 0.5 | 0.05 | 200 | -0.5 | No peeling and cracking |
| | | S-TCO | 90:10mass% | 200 | 0.5 | 0.001 | 100 | -0.1 | |
| Example 1-36 | TCO-Tsub | TCO | 90:10mass% | 100 | 0.5 | 0.06 | 200 | -0.5 | No peeling and cracking |
| | | S-TCO | 90:10mass% | 200 | 0.5 | 0.001 | 100 | -0.1 | |
| Comp. Example 15 | TCO-PO2 | TCO | 90:10mass% | R. T. | 0.5 | 0.06 | 200 | -1.05 | Peeling and cracking |
| | | S-TCO | 90:10mass% | 200 | 0.5 | 0.001 | 100 | -0.1 | |
| Comp. Example -16 | TCO-Tsub | TCO | 90:10mass% | 250 | 0.5 | 0.06 | 200 | -1.05 | Peeling and cracking |
| | | S-TCO | 90:10mass% | 200 | 0.5 | 0.001 | 100 | -0.1 | |
| Example 1-37 | TCO-Composition | TCO | 50:50mass% | R. T. | 0.5 | 0.001 | 200 | -0.1 | No peeling and cracking |
| | | S-TCO | 50:50mass% | 200 | 0.5 | 0.001 | 100 | -0.1 | |
| Example 1-38 | TCO-Composition | TCO | 95:5mass% | R. T. | 0.5 | 0.001 | 200 | -0.3 | No peeling and cracking |
| | | S-TCO | 95:5mass% | 100 | 0.5 | 0.001 | 100 | -0.3 | |
| Example 1-39 | TCO-Composition | TCO | 70:10mass% (SnO2) | R. T. | 0.5 | 0.001 | 200 | -0.1 | No peeling and cracking |
| | | S-TCO | 70:10: 20mass% (SnO2) | 200 | 0.5 | 0.001 | 100 | -0.1 | |
| Comp. Example 1-17 | TCO-Composition | TCO | 45:55mass% | R. T. | 0.5 | 0.001 | 200 | -1.1 | Peeling and cracking |
| | | S-TCO | 45:55mass% | 200 | 0.5 | 0.001 | 100 | -1.2 | |

| | Classification | Layer | Target In2O3: ZnO (mass%) | Film-Forming Condition | | | | Film Stress (× 109Pa) | Scribing Test |
|---|---|---|---|---|---|---|---|---|---|
| | | | | Tsub (°C) | Total Pressure | pO2 (Pa) | Film Thickness | | |
| Comp. Example 1-18 | TCO-Composition | TCO | 96:4mass% | R. T. | 0.5 | 0.001 | 200 | -1.3 | Peeling and cracking |
| | | S-TCO | 96:4mass% | 200 | 0.5 | 0.001 | 100 | -1.5 | |
| Comp. Example 1-19 | TCO-Composition | TCO | 68:10: 22mass% (SnO2) | R. T. | 0.5 | 0.001 | 200 | -1.1 | Peeling and cracking |
| | | S-TCO | 68:10: 22mass% (SnO2) | 200 | 0.5 | 0.001 | 100 | -1.2 | |
| Example 1-40 | TCO-PO2 | TCO | 90:10mass% | R. T. | 0.5 | 0.001 | 300 | 10 | No peeling and cracking |
| Example 1-41 | TCO-PO2 | TCO | 90:10mass% | R. T. | 0.5 | 0.05 | 300 | 10 | No peeling and cracking |
| Example 1-42 | TCO-Tsub | TCO | 90:10mass% | 100 | 0.5 | 0.001 | 300 | 10 | No peeling and cracking |
| Exxample 1-43 | TCO-Tsub | TCO | 90:10mass% | 200 | 0.5 | 0.001 | 300 | 10 | No peeling and cracking |
| Example 1-44 | TCO-Tsub | TCO | 90:10mass% | 100 | 0.5 | 0.06 | 300 | 10 | No peeling and cracking |
| Example 1-45 | TCO-Tsub | TCO | 90:10mass% | 200 | 0.5 | 0.06 | 300 | 10 | No peeling and cracking |
| Comp. Example 1-20 | TCO-PO2 | TCO | 90:10mass% | R. T. | 0.5 | 0.0005 | 300 | -1.1 | Peeling and cracking |
| Comp. Example 1-21 | TCO-Tsub | TCO | 90:10mass% | R. T. | 0.5 | 0.06 | 300 | -1.2 | Peeling and cracking |
| Example 1-46 | TCO-Composition | TCO | 50:50mass% | R. T. | 0.5 | 0.001 | 300 | 10 | No peeling and cracking |
| Example 1-47 | TCO-Composition | TCO | 95:5mass% | R. T. | 0.5 | 0.001 | 300 | 10 | No peeling and cracking |

EP 2 360 733 A1

| | Classification | Layer | Target In2O3: ZnO (mass%) | Film-Forming Condition | | | | Film Stress (× 109Pa) | Scribing Test |
|---|---|---|---|---|---|---|---|---|---|
| | | | | Tsub (˚C) | Total Pressure | pO2 (Pa) | Film Thickness | | |
| Example 1-48 | TCO-Composition | TCO | 70:10: 20mass% (SnO2) | R. T. | 0.5 | 0.001 | 300 | 10 | No peeling and cracking |
| Comp. Example 1-22 | TCO-Composition | TCO | 45:55mass% | R. T. | 0.5 | 0.001 | 300 | -1.5 | Peeling and cracking |
| Comp. Example 1-23 | TCO-Composition | TCO | 96:4mass% | R. T. | 0.5 | 0.001 | 300 | -1.1 | Peeling and cracking |
| Comp. Example 1-24 | TCO-Composition | TCO | 68:10: 22mass% (SnO2) | R. T. | 0.5 | 0.001 | 300 | -1.2 | Peeling and cracking |

EP 2 360 733 A1

Results

According to the results of the experiments shown in Tables 1 to 4, it was found that electrode peeling and generation of crackings after the scribing test could be restrained by reducing the film stress.

Second Exemplary Embodiment

Next, a second exemplary embodiment of the invention will be described in detail below. Incidentally, the same components as those in the first exemplary embodiment will be denoted by the same reference numeral to omit or simplify the explanation thereof. Further, duplicate explanation of the first exemplary embodiment is also omitted or simplified.

Arrangement of Photovoltaic Element

Fig. 1 is a cross section schematically showing a photovoltaic element of a solar battery according to the invention, in which reference numeral 100A denotes the photovoltaic element that generates an electromotive force by a light incident thereon.
Incidentally, in this exemplary embodiment, a part of the n-type semiconductor layer, the transparent electrode layer and the surface transparent electrode layer of the photovoltaic element are different from those in the first exemplary embodiment.
The backside electrode layer, the light absorption layer and the buffer layer are arranged in the same manner as those in the first exemplary embodiment, of which details will not be mentioned herein.

N-Type Semiconductor Layer

An n-type semiconductor layer 150A has a resistance value in a range from 10 k$\Omega$/□ and 1000 k$\Omega$/□. When the resistance value is smaller than 100 k$\Omega$/□, the electrons formed in the light absorption layer are easily transferred toward the anode, so that the open end voltage may be decreased to cause reduction in the photoelectric conversion efficiency. On the other hand, when the resistance value exceeds 1000 k$\Omega$/□, though the open end voltage is increased, the drive voltage of the photoelectric converter may be raised. Thus, the resistance value of the n-type semiconductor layer 150A is set in a range from 10 k$\Omega$/□ and 1000 k$\Omega$/□.
The n-type semiconductor layer 150A is formed by a sputtering (especially DC sputtering) using a mixture gas of, for instance, argon (Ar) and oxygen ($O_2$) under at least one of the conditions of: oxygen partial pressure $pO_2$ being in a range from $1 \times 10^{-2}$ to 0.2 Pa; and substrate temperature in a range from 100 to 200 degrees Celsius, so that the n-type semiconductor layer 150A is made as an amorphous film with a grain size of 0.001 $\mu$m or less measured by observing a surface thereof by an atomic force microscope.
Further, in order to form the n-type semiconductor layer 150A, indium oxide and zinc oxide are used as primary components for forming the amorphous layer having a grain size of 0.001 $\mu$m or less measured by observing a surface thereof by an atomic force microscope. When the grain size obtained by surface-measurement of AFM (Atomic Force Microscope) exceeds 0.001 $\mu$m, interferential coupling properties against the n-type buffer layer 140 may be lowered to generate an energy barrier. Thus, the grain size obtained by surface measurement of AFM is set at 0.001 $\mu$m or less.

Transparent Electrode Layer

The transparent electrode layer 160A is made of the same material as the n-type semiconductor layer 150A, i.e. made of a material with ($In_2O_3$ + ZnO) as primary components and is made into an amorphous thin film having a grain size of 0.001 $\mu$m or less measured by observing a surface thereof by an atomic force microscope by DC sputtering or vapor deposition. In other words, the transparent electrode layer 160A is made of the same material to allow film formation by the same (common) apparatus.
Further, the resistance value of the transparent electrode layer 160A is in a range from 5 $\Omega$/□ and 20 $\Omega$/□. When the resistance value is smaller than 5 $\Omega$/□, the thickness of the film becomes too large so that the transmissivity may be lowered. On the other hand, when the resistance value exceeds 20 $\Omega$/□, a threshold voltage sufficient for transferring the electrons and holes formed in the light absorption layer 130 and the like cannot be applied, so that energy conversion efficiency may be lowered. Thus, the resistance value of the transparent electrode layer 160A is set in a range from 5 $\Omega$/□ and 20 $\Omega$/□.
The transparent electrode layer 160A is formed by a sputtering (especially DC sputtering similar to the formation of the n-type semiconductor layer 150A) using a mixture gas of, for instance, Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius so that the transparent electrode layer 160A is made as an amorphous film with a grain size of 0.001 $\mu$m or less obtained by surface measurement by an atomic force microscope.

Further, in order to form the transparent electrode layer 160A, indium oxide and zinc oxide are used as primary components for forming the amorphous layer having a grain size of 0.001 $\mu$m or less measured by observing a surface thereof by an atomic force microscope. When the grain size obtained by surface-measurement of AFM exceeds 0.001 $\mu$m, interferential coupling properties against the n-type semiconductor layer 150A may be lowered to generate an energy barrier. Thus, the grain size obtained by surface measurement of AFM is set at 0.001 $\mu$m or less.

Surface Transparent Electrode Layer

The surface transparent electrode layer 170A has a refractivity smaller than that of the transparent electrode layer 160A and is thinly provided on an upper side of the transparent electrode layer 160A by the same material as that of the transparent electrode layer 160A, i.e. made of a material with ($In_2O_3$ + ZnO) as primary components, so that the surface transparent electrode layer 170A is made as an amorphous film with a grain size of 0.001 $\mu$m or less obtained by surface measurement by an atomic force microscope.

Further, the resistance value of the surface transparent electrode layer 170A is in a range from 100 $\Omega/\square$ or less. When the resistance value exceeds 100 $\Omega/\square$, a connection resistance between the surface transparent electrode layer and a metal extraction electrode formed when the element is produced may be increased. Thus, the resistance value of the surface transparent electrode layer 170A is set at 100 $\Omega/\square$ or less.

The surface transparent electrode layer 170A is formed by a sputtering (especially DC sputtering similar to the formation of the n-type semiconductor layer 150A and the transparent electrode layer 160A) using a mixture gas of, for instance, Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius so that the surface transparent electrode layer 170A is made as an amorphous film with a grain size of 0.001 $\mu$m or less obtained by surface measurement by an atomic force microscope.

Manufacture Operation of Photovoltaic Element

Next, an operation for manufacturing the photovoltaic element 100A will be described below. Incidentally, in this exemplary embodiment, a part of the forming steps of the n-type semiconductor layer, the transparent electrode layer and the surface transparent electrode layer of the photovoltaic element are different from those in the first exemplary embodiment.

N-Type Semiconductor Layer Forming Step

In the n-type semiconductor layer forming step, in order to form the n-type semiconductor layer 150A, for instance, In and zinc (Zn) are used under a predetermined condition. Specifically, the n-type semiconductor layer 150A is formed by vapor deposition or a sputtering using a mixture gas of, for instance, argon (Ar) and oxygen ($O_2$) under (especially in DC sputtering) at least one of the conditions of: oxygen partial pressure $pO_2$ being in a range from $1 \times 10^{-2}$ to 0.2 Pa; and substrate temperature in a range from 100 to 200 degrees Celsius. Alternatively, the n-type semiconductor layer 150A is provided by DC sputtering or vapor deposition using a composition with indium oxide and zinc oxide as primary components.

The n-type semiconductor layer 150A is thus formed of ($In_2O_3$+ZnO) as primary components in an amorphous film having a thickness in a range from 0.01 to 1 $\mu$m, preferably from 0.1 to 1 $\mu$m. According to the above manufacturing conditions, the n-type semiconductor layer 150A is formed in the amorphous layer having a grain size of 0.001 $\mu$m or less measured by observing a surface thereof by an atomic force microscope.

Surface Transparent Electrode- Layer Forming Step

In the transparent electrode-layer forming step, in order to form the transparent electrode layer 160A, the same material as the n-type semiconductor layer 150A is used in accordance with the same process. Specifically, the transparent electrode layer 160A is formed by a sputtering (especially DC sputtering) using a mixture gas of Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius.

The transparent electrode layer 160A is thus formed of ($In_2O_3$+ZnO) as primary components in an amorphous film having a thickness in a range from 0.01 to 1 $\mu$m, preferably from 0.1 to 1 $\mu$m. According to the above manufacturing condition, the transparent electrode layer 160A is formed in the amorphous layer having a grain size of 0.001 $\mu$m or less measured by observing a surface thereof by an atomic force microscope.

Surface Transparent Electrode Layer Forming Step

In the surface transparent electrode-layer forming step, a layer of the same material as the n-type semiconductor layer 150A and the transparent electrode layer 160A is formed on an upper side of the transparent electrode layer 160A formed during the transparent electrode-layer forming step according to the same film-forming process. Specifically, the surface transparent electrode layer 170A is formed by a sputtering (especially DC sputtering) using a mixture gas of Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius.
The surface transparent electrode layer 170A is thus formed of ($In_2O_3$+ZnO) as primary components in an amorphous film having a thickness in a range from 0.01 to 1 $\mu$m, preferably from 0.1 to 1 $\mu$m. According to the above manufacturing condition, the surface transparent electrode layer 170A is formed in the amorphous layer having a grain size of 0.001 $\mu$m or less measured by observing a surface thereof by an atomic force microscope.

Advantages of the Second Exemplary Embodiment

As described above, the photovoltaic element 100A according to this exemplary embodiment includes: the glass substrate 110; the backside electrode layers 120 provided on a side of the glass substrate 110 in a pair; the p-type conductive light absorption layer 130 provided by a compound having a chalcopyrite-structure, the light absorption layer 130 being layered bridging the backside electrode layers 120; the light-transmissive n-type buffer layer 140 that forms a p-n junction with the light absorption layer 130, the buffer layer 140 being layered on the light absorption layer 130; and the light-transmissive transparent electrode layer 160A being layered on the buffer layer 140 and extending along one side of the light absorption layer 130 and the buffer layer 140 to one of the backside electrode layers 120, where the transparent electrode layer 160A is formed in an amorphous thin film containing indium oxide and zinc oxide as primary components.
Accordingly, the same advantages as the advantages 1-1 and 1-2 in the first exemplary embodiment can be obtained.
The transparent electrode layer 160A is formed by a sputtering using the mixture gas of Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius, so that the transparent electrode layer 160A is made as an amorphous film.
Accordingly, the same advantage as the advantage 1-3 in the first exemplary embodiment can be obtained.
Further, when the transparent electrode layer 160A is formed, the transparent electrode layer 160A is formed in the amorphous layer using a component having a grain size of 0.001 $\mu$m or less measured by observing a surface thereof by an atomic force microscope.
Accordingly, the coupling properties with the n-type semiconductor layer 150A can be enhanced, so that the energy barrier can be reduced, the stability of the coupling can be improved and durability can be enhanced (advantage 2-1).
Further, the resistance value of the transparent electrode layer 160A is in a range from 5 $\Omega/\square$ and 20 $\Omega/\square$.
Accordingly, a threshold voltage sufficient for transferring the electrons and holes formed in the light absorption layer 130 and the like can be applied, so that energy conversion efficiency can be improved (advantage 2-2).
The n-type semiconductor layer 150A is formed in a high resistance by a sputtering under a predetermined oxygen concentration using the mixture gas of Ar and $O_2$ under at least one of the conditions of: oxygen partial pressure $pO_2$ being in a range from $1 \times 10^{-2}$ to 0.2 Pa; and substrate temperature in a range from 100 to 200 degrees Celsius so that the n-type semiconductor layer 150A is made as an amorphous film.
Accordingly, a layer that avoids the decrease in the open end voltage can be easily obtained in the same manner as the advantage 1-5 in the first exemplary embodiment.
Further, in this exemplary embodiment, the advantages 1-4, 1-6, 1-7 and 1-8 in the first exemplary embodiment can be obtained as well as the above advantages.

Examples of the Second Exemplary Embodiment

Next, specific explanation of the present exemplary embodiment will be given below with reference to Examples. It should be understood that the scope of the present exemplary embodiment is by no means limited to the contents covered by the examples.

Preparation of Element Substrate

The backside electrode layer 120 containing Mo (molybdenum) as a primary component was formed in 0.1 $\mu$m thick on the soda-lime glass substrate 110 of 10 cm in height and width at room temperature using a DC magnetron sputtering system. The light absorption layer 130 containing CIGS as a primary component was formed thereon in 1

μm thick at 350 degrees Celsius by a coevaporation using a molecular beam epitaxy device from an evaporation source of CuS, InS, GaS and SeS. Further, the buffer layer 140 containing InS as a primary component was formed thereon in 0.1 μm thick at 100 degrees Celsius by a CBD method to provide an element substrate.

Measurement of Thickness

The thicknesses of the respective layers provided on the above element substrate and element substrates in the following Examples were measured by: providing a soda-lime glass provided with a thickness-measuring mask for each of the film-forming steps; providing a step portion by removing the mask after each of the layers were formed; and measuring by a stylus (used instrument: DEKTAK3030 from SLOAN TECHNOLOGY).

Measurement of Sheet Resistance

The sheet resistance of each of the n-type semiconductor layer 150A, the transparent electrode layer 160A and the surface transparent electrode layer 170A of the photovoltaic element manufactured in the following Examples was measured by providing a soda-lime glass substrate for measuring the thickness in addition to the element substrate for each of the film-forming steps of the respective layers after each of the layers were formed according to four-stylus method (used instrument: LORESTA-FP from Mitsubishi Petrochemical Co., Ltd).

Measurement of Grain Size

The grain size of each of the n-type semiconductor layer 150A, the transparent electrode layer 160A and the surface transparent electrode layer 170A of the photovoltaic element manufactured in the following Examples was measured by observing the surface by an atomic force microscope (AFM) using the film-formed substrates used for measuring the sheet resistance.

Evaluation of Element

The photoelectric conversion efficiency of the photovoltaic element manufactured in the following Examples was calculated by: providing an anode by the transparent electrode layer or the surface transparent electrode layer and a cathode by Mo; forming an extraction electrode of 30 μm□, 0.5 μm thick on the transparent electrode layer or the surface transparent electrode layer and on Mo layer by a screen printing using an Ag paste; and evaluating an open voltage (Voc), short-circuit current density (Isc) and a fill factor (FF). Incidentally, a light from a xenon lamp that was adjusted by a predetermined optical filter (solar simulation) was used as a light source.

High-Temperature and High-Humidity Test

A high-temperature and high-humidity test of the photovoltaic element manufactured in the following Examples was performed by: prior to the Ag paste printing on the photovoltaic element, exposing the photovoltaic element in a high-temperature and high-humidity bath of 80 degrees Celsius and 85 %RH for 1000 hours; printing the Ag past according to the step in the above element evaluation; and evaluating an open voltage (Voc), short-circuit current density (Isc) and a fill factor (FF) to calculate the photoelectric conversion efficiency.

Example 2-1

Formation of N-Type Semiconductor Layer 150A

The n-type semiconductor layer 150A was formed on the element substrate in 0.1 μm thick at room temperature using a DC magnetron sputtering system and an IZO target ($In_2O_3$: ZnO = 90 [mass%] : 10 [mass%]) at a sputtering pressure of 0.5 Pa and in a mixture gas of argon (Ar) and oxygen ($O_2$) with oxygen partial pressure being 0.2 Pa. The grain size of the n-type semiconductor layer 150A formed on the soda-lime glass disposed on a film-forming apparatus simultaneously with the element substrate was 0.7 nm after a measurement by surface-observation by an AFM.

Formation of Transparent Electrode Layer 160A

The transparent electrode layer 160A was formed on the n-type semiconductor layer 150 in 0.2 μm thick at room temperature using an IZO target ($In_2O_3$: ZnO = 90 [mass%] : 10 [mass%]) at a sputtering pressure of 0.5 Pa and in a mixture gas of argon (Ar) and oxygen ($O_2$) with oxygen partial pressure being 0.001 Pa.

The sheet resistance and the grain size of the transparent electrode layer 160A formed on the soda-lime glass disposed on a film-forming apparatus simultaneously with the element substrate were measured respectively by a four-stylus method and a surface-observation by an AFM. As a result, the sheet resistance was 15 $\Omega/\square$ and the grain size was 0.3 nm.

Formation of Surface Transparent Electrode Layer 170A

The surface transparent electrode layer 170A was formed on the transparent electrode layer 160A in 0.1 $\mu$m thick at 200 degrees Celsius using an IZO target ($In_2O_3$: ZnO = 90 [mass%] : 10 [mass%]) at a sputtering pressure of 0.5 Pa and in a mixture gas of argon (Ar) and oxygen ($O_2$) with oxygen partial pressure being 0.001 Pa. The grain size of the surface transparent electrode layer 170A formed on the soda-lime glass disposed on a film-forming apparatus simultaneously with the element substrate was 0.3 nm after a measurement by surface-observation by an AFM as shown in Table 5.

An extraction electrode was formed on the surface transparent electrode layer 170A and the Mo backside electrode layer 120 of a first photovoltaic element 100A on which the n-type semiconductor layer 150A, the transparent electrode layer 160A and the surface transparent electrode layer 170A were layered on an element substrate by a screen printing using an Ag paste. When the photoelectric conversion efficiency was measured, Voc was 620 mv, Isc was 39 mA and FF (fill factor) / Pin (standard incident power) was 0.67 as shown in Table 5, so that the photoelectric conversion efficiency calculated based on the above values was 16.2 %.

A second photovoltaic element 100A on which the n-type semiconductor layer 150A, the transparent electrode layer 160A and the surface transparent electrode layer 170A were layered by a screen printing using an Ag paste was exposed in an exposure test in a high-temperature and high-humidity condition of 80 degrees Celsius and 85 %RH for 1000 hours. Then, when an extraction electrode was formed on the surface transparent electrode layer 170A and the Mo backside electrode layer 120 that had been subjected to the test by a screen printing using an Ag paste and the photoelectric conversion efficiency was measured, Voc was 619 mv, Isc was 39 mA and FF / Pin was 0.67, so that the photoelectric conversion efficiency calculated based on the above values was 16.2 %.

Incidentally, n layer in the Tables represents the n-type semiconductor layer 150A, TCO represents the transparent electrode layer 160A and S-TCO represents the surface transparent electrode layer 170A.

Examples 2-2 to 2-48 and Comparative Examples 2-1 to 2-24

The n-type semiconductor layer 150A, the transparent electrode layer 160A and the surface transparent electrode layer 170A were formed on the element substrate in the same manner as the Example 2-1 except for the film-forming condition, composition of target and presence/absence of the surface transparent electrode layer 170A. Then, the grain size of each of the layers, the sheet resistance of the transparent electrode layer 160A, the initial element evaluation and element evaluation after being subjected to the high-temperature and high-humidity test were measured, of which results are shown in Tables 5 to 8.

Table 5

| | Classification | layer | Target In2O3:ZnO (mass%) | Film-Formation Condition | | | | Single-Film Evaluation | | Element Evaluation (Initial) | | | | Element Evaluation (80°C/ 85%RH×1000h) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-1 | n-PO2 | n layer | 90:10mass% | R. T. | 0.5 | 0.2 | 100 | | 0.7 | 620 | 39 | 0.67 | 16.2 | 619 | 39 | 0.67 | 16.2 |
| | | TCO | 90:10mass% | R. T. | 0.5 | 0.001 | 200 | 15 | 0.3 | | | | | | | | |
| | | 8-TCO | 90:10mass% | 200 | 0.5 | 0.001 | 100 | | 0.3 | | | | | | | | |
| Example2-2 | n-PO2 | n layer | 90:10mass% | R. T. | 0.5 | 0.01 | 100 | | 0.5 | 630 | 38 | 0.67 | 16.0 | 628 | 38 | 0.67 | 16.0 |
| | | TCO | 90:10mass% | R. T. | 0.5 | 0.001 | 200 | 15 | 0.3 | | | | | | | | |
| | | S-TCO | 90:10mass% | 200 | 0.5 | 0.001 | 100 | | 0.3 | | | | | | | | |
| Example2-3 | n-Tsub | n layer | 90:10mass% | 100 | 0.5 | 0.009 | 100 | | 0.8 | 670 | 41 | 0.67 | 18.4 | 669 | 41 | 0.67 | 13.4 |
| | | TCO | 90:10mass% | R. T. | 0.5 | 0.001 | 200 | 15 | 0.3 | | | | | | | | |
| | | S-TCO | 90:10mass% | 200 | 0.5 | 0.001 | 100 | | 0.3 | | | | | | | | |
| Example2-4 | n-Tsub | n layer | 90:10mass% | 200 | 0.5 | 0.008 | 100 | | 0.9 | 625 | 38 | 0.67 | 15.9 | 620 | 38 | 0.67 | 15.8 |
| | | TCO | 90:10mass% | R. T. | 0.5 | 0.001 | 200 | 15 | 0.3 | | | | | | | | |
| | | S-TCO | 90:10mass% | 200 | 0.5 | 0.001 | 100 | | 0.3 | | | | | | | | |

| | Classification | layer | Target In2O3:ZnO (mass%) | Film-Formation Condition | | | | Single-Film Evaluation | | Element Evaluation (Initial) | | | | Element Evaluation (80°C/85%RH×1000h) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-5 | n-Tsub | n layer | 90:10mass% | 100 | 0.5 | 0.01 | 100 | | 0.5 | 630 | 38 | 0.67 | 16.0 | 627 | 38 | 0.67 | 16.0 |
| | | TCO | 90:10mass% | R. T. | 0.5 | 0.001 | 200 | 15 | 0.3 | | | | | | | | |
| | | S-TCO | 90:10mass% | 200 | 0.5 | 0.001 | 100 | | 0.3 | | | | | | | | |
| Example2-6 | n-Tsub | n layer | 90:10mass% | 200 | 0.5 | 0.01 | 100 | | 0.5 | 640 | 36 | 0.67 | 15.4 | 630 | 37 | 0.67 | 15.6 |
| | | TCO | 90:10mass% | R. T. | 0.5 | 0.001 | 200 | 15 | 0.3 | | | | | | | | |
| | | S-TCO | 90:10mass% | 200 | 0.5 | 0.001 | 100 | | 0.3 | | | | | | | | |
| Example2-7 | n-PO2 | n layer | 90:10mass% | R. T. | 0.5 | 0.007 | 100 | | 0.7 | 601 | 30 | 0.67 | 12.5 | 591 | 29 | 0.67 | 11.5 |
| | | TCO | 90:10mass% | R. T. | 0.5 | 0.001 | 200 | 15 | 0.3 | | | | | | | | |
| | | S-TCO | 90:10mass% | 200 | 0.5 | 0.001 | 100 | | 0.3 | | | | | | | | |
| Example2-8 | TCO-Tsub | n layer | 90:10mass% | 200 | 0.5 | 0.01 | 100 | | 0.5 | 606 | 32 | 0.67 | 13.0 | 603 | 32 | 0.67 | 12.9 |
| | | TCO | 90:10mass% | R. T. | 0.5 | 0.06 | 200 | 15 | 0.3 | | | | | | | | |
| | | S-TCO | 90:10mass% | 200 | 0.5 | 0.001 | 100 | | 0.3 | | | | | | | | |

(continued)

| | Classification | layer | Target In2 O3:ZnO (mass%) | Film-Formation Condition | | | | Single-Film Evaluation | | Element Evaluation (Initial) | | | | Element Evaluation (80°C/ 85%RH×1000h) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-9 | STCO-Tsub | n layer | 90: 10mass% | 200 | 0.5 | 0.01 | 100 | | 0.5 | 604 | 32 | 0.67 | 12.9 | 603 | 32 | 0.67 | 12.9 |
| | | TCO | 90: 10mass% | R. T. | 0.5 | 0.001 | 200 | 15 | 0.3 | | | | | | | | |
| | | S-TCO | 90: 10mass% | 205 | 0.5 | 0.06 | 100 | | 0.7 | | | | | | | | |
| Comp. Example2-1 | n-PO2 | n layer | 90: 10mass% | R. T. | 0.5 | 0.009 | 100 | | 1.1 | 54C | 26 | 0.67 | 9.4 | 460 | 20 | 0.67 | 6.2 |
| | | TCO | 90: 10mass% | R. T. | 0.5 | 0.001 | 200 | 15 | 0.3 | | | | | | | | |
| | | S-TCO | 90: 10mass% | 200 | 0.5 | 0.001 | 100 | | 0.3 | | | | | | | | |
| Comp. Example2-2 | n-Tsub | n layer | 90: 10mass% | 250 | 0.5 | 0.009 | 100 | | 1.2 | 54C | 26 | 0.67 | 9.4 | 430 | 17 | 0.67 | 4.9 |
| | | TCO | 90: 10mass% | R. T. | 0.5 | 0.001 | 200 | 15 | 0.3 | | | | | | | | |
| | | S-TCO | 90: 10mass% | 200 | 0.5 | 0.001 | 100 | | 0.3 | | | | | | | | |

Table 6

| Classification | layer | Target In2O3:ZnO (mass%) | Film-Formation Condition | | | | Single-Film Evaluation | | Element Evaluation (Initial) | | | | Element Evaluation(80°C/85%RH×1000h) | | | |
|---|---|---|---|---|---|---|---|---|---|---|---|---|---|---|---|---|
| | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-10 TCO-PO2 | n layer | 90:10mass% | R. T. | 0.5 | 0.2 | 100 | | 0.7 | | | | | | | | |
| | TCO | 90:10mass% | R. T. | 0.5 | 0.05 | 200 | 15 | 0.9 | 627 | 39 | 0.67 | 16.4 | 624 | 39 | 0.67 | 16.3 |
| | S-TCO | 90:10mass% | 200 | 0.5 | 0.001 | 100 | | 0.3 | | | | | | | | |
| Example2-11 TCO-Tsub | n layer | 90:10mass% | R. T. | 0.5 | 0.2 | 100 | | 0.7 | | | | | | | | |
| | TCO | 90:10mass% | 200 | 0.5 | 0.05 | 200 | 15 | 0.9 | 632 | 38 | 0.67 | 16.1 | 631 | 38 | 0.67 | 16.1 |
| | S-TCO | 90:10mass% | 200 | 0.5 | 0.001 | 100 | | 0.3 | | | | | | | | |
| Example2-12 TCO-Tsub | n layer | 90:10mass% | R. T. | 0.5 | 0.2 | 100 | | 0.7 | | | | | | | | |
| | TCO | 90:10mass% | 200 | 0.5 | 0.06 | 200 | 15 | 0.95 | 650 | 41 | 0.67 | 17.9 | 647 | 41 | 0.67 | 17.8 |
| | S-TCO | 90:10mass% | 200 | 0.5 | 0.001 | 100 | | 0.3 | | | | | | | | |
| Example2-13 TCO-Tsub | n layer | 90:10mass% | R. T. | 0.5 | 0.2 | 100 | | 0.7 | | | | | | | | |
| | TCO | 90:10mass% | 100 | 0.5 | 0.05 | 200 | 15 | 0.9 | 635 | 38 | 0.67 | 16.2 | 633 | 38 | 0.67 | 16.1 |
| | S-TCO | 90:10mass% | 200 | 0.5 | 0.001 | 100 | | 0.3 | | | | | | | | |

(continued)

| | Classification | layer | Target In2O3: ZnO (mass%) | Film-Formation Condition | | | | Single-Film Evaluation | | Element Evaluation (Initial) | | | | Element Evaluation(80°C/ 85%RH×1000h) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Sheet Resistance ($\Omega/\square$) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-14 | TCO-Tsub | n layer | 90: 10mass% | R. T. | 0.5 | 0.2 | 100 | | 0.7 | 630 | 39 | 0.67 | 16.5 | 627 | 39 | 0.67 | 16.4 |
| | | TCO | 90: 10mass% | 100 | 0.5 | 0.06 | 200 | 15 | 0.5 | | | | | | | | |
| | | S-TCO | 90: 10mass% | 200 | 0.5 | 0.001 | 100 | | 0.3 | | | | | | | | |
| Comp. Example2-3 | TCO-PO2 | n layer | 90: 10mass% | R. T. | 0.5 | 0.2 | 100 | | 0.7 | 530 | 29 | 0.67 | 10.3 | 502 | 26 | 0.67 | 8.7 |
| | | TCO | 90: 10mass% | R. T. | 0.5 | 0.06 | 200 | 15 | 1.1 | | | | | | | | |
| | | S-TCO | 90: 10mass% | 200 | 0.5 | 0.001 | 100 | | 0.3 | | | | | | | | |
| Comp. Example2-4 | TCO-Tsub | n layer | 90: 10mass% | R. T. | 0.5 | 0.2 | 100 | | 0.5 | 535 | 28 | 0.67 | 10.0 | 507 | 26 | 0.67 | 8.8 |
| | | TCO | 90: 10mass% | 250 | 0.5 | 0.06 | 200 | 15 | 1.1 | | | | | | | | |
| | | S-TCO | 90: 10mass% | 200 | 0.5 | 0.001 | 100 | | 0.3 | | | | | | | | |
| Example2-15 | TCO- Composition | n layer | 50: 50mass% | R. T. | 0.5 | 0.2 | 100 | | 0.7 | 629 | 41 | 0.67 | 17.3 | 627 | 41 | 0.67 | 17.2 |
| | | TCO | 50: 50mass% | R. T. | 0.5 | 0.001 | 200 | 15 | 0.3 | | | | | | | | |
| | | S-TCO | 50: 50mass% | 200 | 0.5 | 0.001 | 100 | | 0.3 | | | | | | | | |

| | Classification | layer | Target In2O3: ZnO (mass%) | Film-Formation Condition | | | | Single-Film Evaluation | | Element Evaluation (Initial) | | | | Element Evaluation(80˚C/ 85%RH×1000h) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-16 | TCO-Composition | n layer | 95: 5mass% | R. T. | 0.5 | 0.2 | 100 | | 0.7 | 631 | 40 | 0.67 | 16.9 | 630 | 40 | 0.67 | 16.9 |
| | | TCO | 95: 5mass% | R. T. | 0.5 | 0.001 | 200 | 15 | 0.3 | | | | | | | | |
| | | S-TCO | 95: 5mass% | 100 | 0.5 | 0.001 | 100 | | 0.3 | | | | | | | | |
| Example2-17 | TCO-Composition | n layer | 70:10: 20mass% (SnO2) | R. T. | 0.5 | 0.2 | 100 | | 0.7 | 641 | 39 | 0.67 | 16.7 | 636 | 39 | 0.67 | 16.6 |
| | | TCO | 70:10: 20mass% (SnO2) | R. T. | 0.5 | 0.001 | 200 | 15 | 0.3 | | | | | | | | |
| | | S-TCO | 70:10: 20mass% (SnO2) | 200 | 0.5 | 0.001 | 100 | | 0.3 | | | | | | | | |
| Comp. Example2-5 | TCO-Composition | n layer | 45: 55mass% | R. T. | 0.5 | 0.2 | 100 | | 1.1 | 520 | 30 | 0.67 | 10.5 | 500 | 25 | 0.67 | 8.4 |
| | | TCO | 45: 55mass% | R. T. | 0.5 | 0.001 | 200 | 15 | 1.1 | | | | | | | | |
| | | S-TCO | 45: 55mass% | 200 | 0.5 | 0.001 | 100 | | 1.3 | | | | | | | | |
| Comp. Example2-6 | TCO-Composition | n layer | 96: 4mass% | R. T. | 0.5 | 02 | 100 | | 1.2 | 523 | 29 | 0.67 | 10.2 | 501 | 24 | 0.67 | 8.1 |
| | | TCO | 96: 4mass% | R. T. | 0.5 | 0.001 | 200 | 15 | 1.3 | | | | | | | | |
| | | S-TCO | 96: 4mass% | 200 | 0.5 | 0.001 | 100 | | 2 | | | | | | | | |

| | Classification | layer | Target In2O3: ZnO (mass%) | Film-Formation Condition | | | | Single-Film Evaluation | | Element Evaluation (Initial) | | | | Element Evaluation(80˚C/ 85%RH×1000h) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Sheet Resistance (Ω/□ ) | Grain Size (nm) | Voc (mV) | Isc (mA) | FF/Pin | Conversion Efficiency (%) | Voc (mV) | Isc (mA) | FF/Pin | Conversion Efficiency (%) |
| Comp. Example2-7 | TCO- Composition | n layer | 68:10: 22mass% (SnO2) | R. T. | 0.5 | 0.2 | 100 | | 1.1 | 510 | 32 | 0.67 | 10.9 | 495 | 28 | 0.67 | 9.3 |
| | | TCO | 68:1 0: 22mass% (SnO2) | R. T. | 0.5 | 0.001 | 200 | 15 | 1.1 | | | | | | | | |
| | | S-TCO | 68:10: 22mass% (SnO2) | 200 | 0.5 | 0.001 | 100 | | 1.2 | | | | | | | | |

Table 7

| | Classification | layer | Target In2O3:ZnO (mass%) | Film-Formation Condition | | | | Single-Film Evaluation | | Element Evaluation (Initial) | | | | Element Evaluation(80°C/85%RH×1000h) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-18 | n-PO2 | n layer | 90:10mass% | R.T. | 0.5 | 0.2 | 100 | | 0.7 | 620 | 39 | 0.67 | 16.2 | 619 | 39 | 0.67 | 16.2 |
| | | TCO | 90:10mass% | R.T. | 0.5 | 0.001 | 300 | 15 | 0.3 | | | | | | | | |
| Example2-19 | n-PO2 | n layer | 90:10mass% | R.T. | 0.5 | 0.01 | 100 | | 0.5 | 630 | 38 | 0.67 | 16.0 | 628 | 38 | 0.67 | 16.0 |
| | | TCO | 90:10mass% | R.T. | 0.5 | 0.001 | 300 | 15 | 0.3 | | | | | | | | |
| Example2-20 | n-Tsub | n layer | 90:10mass% | 100 | 0.5 | 0.009 | 100 | | 0.8 | 670 | 41 | 0.67 | 18.4 | 669 | 41 | 0.67 | 18.4 |
| | | TCO | 90:10mass% | R.T. | 0.5 | 0.001 | 300 | 15 | 0.3 | | | | | | | | |
| Example2-21 | n-Tsub | n layer | 90:10mass% | 200 | 0.5 | 0.008 | 100 | | 0.9 | 625 | 38 | 0.67 | 15.9 | 620 | 38 | 0.67 | 15.8 |
| | | TCO | 90:10mass% | R.T. | 0.5 | 0.001 | 300 | 15 | 0.3 | | | | | | | | |
| Example2-22 | n-tub | n layer | 90:10mass% | 100 | 0.5 | 0.01 | 100 | | 0.5 | 630 | 38 | 0.67 | 16.0 | 627 | 38 | 0.67 | 16.0 |
| | | TCO | 90:10mass% | R.T. | 0.5 | 0.001 | 300 | 15 | 0.3 | | | | | | | | |
| Example2-23 | n-Tsub | n layer | 90:10mass% | 200 | 0.5 | 0.01 | 100 | | 0.5 | 640 | 36 | 0.67 | 15.4 | 630 | 37 | 0.67 | 15.6 |
| | | TCO | 90:10mass% | R.T. | 0.5 | 0.001 | 300 | 15 | 0.3 | | | | | | | | |

EP 2 360 733 A1

| | Classification | layer | Target In2O3: ZnO (mass%) | Film-Formation Condition | | | | Single-Film Evaluation | | Element Evaluation (Initial) | | | | Element Evaluation(80°C/ 85%RH×1000h) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Comp. Example2-8 | n-PO2 | n layer | 90: 10mass% | R. T. | 0.5 | 0.009 | 100 | | 0.7 | 540 | 26 | 0.67 | 9.4 | 460 | 20 | 0.67 | 6.2 |
| | | TCO | 90: 10mass% | R. T. | 0.5 | 0.001 | 200 | 15 | 1.1 | | | | | | | | |
| Comp. Example2-9 | n-Tsub | n layer | 90: 10mass% | 250 | 0.5 | 0.009 | 100 | | 0.5 | 540 | 26 | 0.67 | 9.4 | 430 | 17 | 0.67 | 4.9 |
| | | TCO | 90: 10mass% | R. T. | 0.5 | 0.001 | 200 | 15 | 1.1 | | | | | | | | |
| Example2-24 | TCO-PO2 | n layer | 90: 10mass% | R. T. | 0.5 | 0.2 | 100 | | 0.7 | 627 | 39 | 0.67 | 16.4 | 624 | 39 | 0.67 | 16.3 |
| | | TCO | 90: 10mass% | R. T. | 0.5 | 0.05 | 200 | 15 | 0.9 | | | | | | | | |
| Example2-25 | TCO-Tsub | n layer | 90: 10mass% | R. T. | 0.5 | 0.2 | 100 | | 0.7 | 632 | 38 | 0.67 | 16.1 | 631 | 38 | 0.67 | 16.1 |
| | | TCO | 90: 10mass% | 200 | 0.5 | 0.05 | 200 | 15 | 0.9 | | | | | | | | |
| Example2-26 | TCO-Tsub | n layer | 90: 10mass% | R. T. | 0.5 | 0.2 | 100 | | 0.7 | 650 | 41 | 0.67 | 17.9 | 647 | 41 | 0.67 | 17.8 |
| | | TCO | 90: 10mass% | 200 | 0.5 | 0.06 | 200 | 15 | 0.95 | | | | | | | | |
| Example2-27 | TCO-Tsub | n layer | 90: 10mass% | R. T. | 0.5 | 0.2 | 100 | | 0.7 | 635 | 38 | 0.67 | 16.2 | 633 | 38 | 0.67 | 16.1 |
| | | TCO | 90: 10mass% | 100 | 0.5 | 0.05 | 200 | 15 | 0.9 | | | | | | | | |

| Classification | layer | Target In2O3: ZnO (mass%) | Film-Formation Condition | | | | Single-Film Evaluation | | Element Evaluation (Initial) | | | | Element Evaluation(80°C/ 85%RH×1000h) | | | |
| --- | --- | --- | --- | --- | --- | --- | --- | --- | --- | --- | --- | --- | --- | --- | --- | --- |
| | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example2-28 TCO-Tsub | n layer | 90: 10mass% | R. T. | 0.5 | 0.2 | 100 | | 0.7 | 630 | 39 | 0.67 | 16.5 | 627 | 39 | 0.67 | 1 6.4 |
| | TCO | 90: 10mass% | 100 | 0.5 | 0.06 | 200 | 15 | 0.5 | | | | | | | | |
| Comp. Example2-10 TCO-PO2 | n layer | 90: 10mass% | R. T. | 0.5 | 0.2 | 100 | | 0.7 | 530 | 29 | 0.67 | 10.3 | 502 | 26 | 0.67 | 8.7 |
| | TCO | 90: 10mass% | R. T. | 0.5 | 0.06 | 200 | 15 | 1.1 | | | | | | | | |
| Comp. Example2-11 TCO-Tsub | n layer | 90: 10mass% | R. T. | 0.5 | 0.2 | 100 | | 0.5 | 535 | 28 | 0.67 | 10.0 | 507 | 26 | 0.67 | 8.8 |
| | TCO | 90: 10mass% | 250 | 0.5 | 0.06 | 200 | 15 | 1.1 | | | | | | | | |
| Example2-29 TCO-Composition | n layer | 50: 50mass% | R. T. | 0.5 | 0.2 | 100 | | 0.7 | 629 | 41 | 0.67 | 17.3 | 627 | 41 | 0.67 | 172 |
| | TCO | 50: 50mass% | R. T. | 0.5 | 0.001 | 200 | 15 | 0.3 | | | | | | | | |
| Example2-30 TCO-Composition | n layer | 95: 5mass% | R. T. | 0.5 | 0.2 | 100 | | 0.7 | 631 | 40 | 0.67 | 16.9 | 630 | 4C | 0.67 | 16.9 |
| | TCO | 95: 5mass% | R. T. | 0.5 | 0.001 | 200 | 15 | 0.3 | | | | | | | | |
| Example2-31 TCO-Composition | n layer | 70:10: 20mass% (SnO2) | R. T. | 0.5 | 0.2 | 100 | | 0.7 | 641 | 39 | 0.67 | 16.7 | 636 | 39 | 0.67 | 16.6 |
| | TCO | 70:10: 20mass% (SnO2) | R. T. | 0.5 | 0.001 | 200 | 15 | 0.3 | | | | | | | | |

| | Classification | layer | Target In2O3: ZnO (mass%) | Film-Formation Condition | | | | Single-Film Evaluation | | Element Evaluation (Initial) | | | | Element Evaluation(80˚C/ 85%RH×1000h) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Comp. Example2-12 | TCO- Composition | n layer | 45: 55mass% | R. T. | 0.5 | 0.2 | 100 | | 1.1 | 520 | 30 | 0.67 | 105 | 500 | 25 | 0.67 | 8.4 |
| | | TCO | 45: 55mass% | R. T. | 0.5 | 0.001 | 200 | 15 | 1.1 | | | | | | | | |
| Comp. Example2-13 | TCO- Composition | n layer | 96: 4mass% | R. T. | 0.5 | 0.2 | 100 | | 1.2 | 523 | 29 | 0.67 | 10.2 | 501 | 24 | 0.67 | 8.1 |
| | | TCO | 96: 4mass% | R. T. | 0.5 | 0.001 | 200 | 15 | 1.3 | | | | | | | | |
| Comp. Example2-14 | TCO- Composition | n layer | 68:10: 22mass% (SnO2) | R. T. | 0.5 | 0.2 | 100 | | 1.1 | 510 | 32 | 0.67 | 10.9 | 495 | 28 | 0.67 | 93 |
| | | TCO | 68:10: 22mass% (SnO2) | R. T. | 0.5 | 0.001 | 200 | 15 | 1.1 | | | | | | | | |

Table 8

| | Classification | layer | Target In2O3: ZnO (mass%) | Film-Formation Condition | | | | Single-Film Evaluation | | Element Evaluation (Initial) | | | | Element Evaluation (80˚C/85%RH × 1000h) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example 2-32 | TCO-PO2 | TCO | 90: 10mass% | R. T. | 0.5 | 0.05 | 200 | 15 | 0.9 | 627 | 39 | 0.67 | 16.4 | 624 | 39 | 0.67 | 16.3 |
| | | S-TCO | 90: 10mass% | 200 | 0.5 | 0.001 | 100 | | 0.3 | | | | | | | | |
| Example 2-33 | TCO-Tsub | TCO | 90: 10mass% | 200 | 0.5 | 0.05 | 200 | 15 | 0.9 | 632 | 38 | 0.67 | 16.1 | 631 | 38 | 0.67 | 16.1 |
| | | S-TCO | 90: 10mass% | 200 | 0.5 | 0.001 | 100 | | 03 | | | | | | | | |
| Example 2-34 | TCO-Tsub | TCO | 90: 10mass% | 200 | 0.5 | 0.06 | 200 | 15 | 0.95 | 650 | 41 | 0.67 | 17.9 | 647 | 41 | 0.67 | 17.8 |
| | | S-TCO | 90: 10mass% | 200 | 0.5 | 0.001 | 100 | | 0.3 | | | | | | | | |
| Example 2-35 | TCO-Tsub | TCO | 90: 10mass% | 100 | 0.5 | 0.05 | 200 | 15 | 0.9 | 635 | 38 | 0.67 | 16.2 | 633 | 38 | 0.67 | 16.1 |
| | | S-TCO | 90: 10mass% | 200 | 0.5 | 0.001 | 100 | | 0.3 | | | | | | | | |
| Example 2-36 | TCO-Tsub | TCO | 90: 10mass% | 100 | 0.5 | 0.06 | 200 | 15 | 0.5 | 630 | 39 | 0.67 | 16.5 | 627 | 39 | 0.67 | 16.4 |
| | | S-TCO | 90: 10mass% | 200 | 0.5 | 0.001 | 100 | | 0.3 | | | | | | | | |
| Comp. Example 2-15 | TCO-PO2 | TCO | 90: 10mass% | R. T. | 0.5 | 0.06 | 200 | 15 | 1.1 | 530 | 29 | 0.67 | 10.3 | 502 | 27 | 0.67 | 8.7 |
| | | S-TCO | 90: 10mass% | 200 | 0.5 | 0.001 | 100 | | 0.3 | | | | | | | | |
| Comp. Example 2-16 | TCO-Tsub | TCO | 90: 10mass% | 250 | 0.5 | 0.06 | 200 | 15 | 1.1 | 535 | 28 | 0.67 | 10.0 | 507 | 26 | 0.67 | 8.8 |
| | | S-TCO | 90: 10mass% | 200 | 0.5 | 0.001 | 100 | | 0.3 | | | | | | | | |

(continued)

| Classification | layer | Target In2O3:ZnO (mass%) | Film-Formation Condition | | | | Single-Film Evaluation | | Element Evaluation (Initial) | | | | Element Evaluation (80°C/85%RH × 1000h) | | | |
|---|---|---|---|---|---|---|---|---|---|---|---|---|---|---|---|---|
| | | | Tsub (°C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example 2-37 TCO-Composition | TCO | 50:50mass% | R. T. | 0.5 | 0.001 | 200 | 15 | 0.3 | 629 | 41 | 0.67 | 17.3 | 627 | 41 | 0.67 | 17.2 |
| | S-TCO | 50:50mass% | 200 | 0.5 | 0.001 | 100 | | 0.3 | | | | | | | | |
| Example 2-38 TCO-Composition | TCO | 95:5mass% | R. T. | 0.5 | 0.001 | 200 | 15 | 0.3 | 631 | 40 | 0.67 | 16.9 | 630 | 41 | 0.67 | 16.9 |
| | S-TCO | 95:5mass% | 100 | 0.5 | 0.001 | 100 | | 0.3 | | | | | | | | |
| Example 2-39 TCO-Composition | TCO | 70:10:20mass% (SnO2) | R. T. | 0.5 | 0.001 | 200 | 15 | 0.3 | 641 | 39 | 0.67 | 16.7 | 636 | 39 | 0.67 | 16.6 |
| | S-TCO | 70:10:20mass% (SnO2) | 200 | 0.5 | 0.001 | 100 | | 0.3 | | | | | | | | |
| Comp. Example 2-17 TCO-Composition | TCO | 45:55mass% | R. T. | 0.5 | 0.001 | 200 | 15 | 1.1 | 520 | 30 | 0.67 | 10.5 | 499 | 25 | 0.67 | 8.4 |
| | S-TCO | 45:55mass% | 200 | 0.5 | 0.001 | 100 | | 1.3 | | | | | | | | |
| Comp. Example 2-18 TCO-Composition | TCO | 96:4mass% | R. T. | 0.5 | 0.001 | 200 | 15 | 1.3 | 523 | 29 | 0.67 | 10.2 | 501 | 24 | 0.67 | 8.1 |
| | S-TCO | 96:4 mass% | 200 | 0.5 | 0.001 | 100 | | 2 | | | | | | | | |
| Comp. Example 2-19 TCO-Composition | TCO | 68:10:22mass% (SnO2) | R. T. | 0.5 | 0.001 | 200 | 15 | 1.1 | 510 | 32 | 0.67 | 10.9 | 495 | 28 | 0.67 | 9.3 |
| | S-TCO | 68:10:22mass% (SnO2) | 200 | 0.5 | 0.001 | 100 | | 1.2 | | | | | | | | |
| Example 2-40 TCO-PO2 | TCO | 90:10mass% | R. T. | 0.5 | 0.001 | 300 | 10 | 0.3 | 619 | 39 | 0.67 | 16.2 | 619 | 39 | 0.67 | 16.2 |

(continued)

| | Classification | layer | Target In2O3:ZnO (mass%) | Film-Formation Condition | | | | Single-Film Evaluation | | Element Evaluation (Initial) | | | | Element Evaluation (80˚C/85%RH × 1000h) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Example 2-41 | TCO-PO2 | TCO | 90:10mass% | R. T. | 0.5 | 0.05 | 300 | 10 | 0.3 | 629 | 38 | 0.67 | 16.0 | 628 | 38 | 0.67 | 16.0 |
| Example 2-42 | TCO-Tsub | TCO | 90:10mass% | 100 | 0.5 | 0.001 | 300 | 10 | 0.3 | 669 | 41 | 0.67 | 18.4 | 669 | 41 | 0.67 | 18.4 |
| Example 2-43 | TCO-Tsub | TCO | 90:10mass% | 200 | 0.5 | 0.001 | 300 | 10 | 0.3 | 624 | 38 | 0.67 | 15.9 | 620 | 38 | 0.67 | 15.8 |
| Example 2-44 | TCO-Tsub | TCO | 90:10mass% | 100 | 0.5 | 0.06 | 300 | 10 | 0.3 | 629 | 36 | 0.67 | 16.0 | 627 | 37 | 0.67 | 16.0 |
| Example 2-45 | TCO-Tsub | TCO | 90:10mass% | 200 | 0.5 | 0.06 | 300 | 10 | 0.3 | 639 | 36 | 0.67 | 15.4 | 630 | 37 | 0.67 | 15.6 |
| Comp. Example 2-20 | TCO-PO2 | TCO | 90:10mass% | R. T. | 0.5 | 0.0005 | 300 | 10 | 1.1 | 539 | 26 | 0.67 | 9.4 | 460 | 20 | 0.67 | 6.2 |
| Comp. Example 2-21 | TCO-Tsub | TCO | 90:10mass% | R. T. | 0.5 | 0.06 | 300 | 10 | 1.1 | 541 | 26 | 0.67 | 9.4 | 430 | 17 | 0.67 | 4.9 |
| Example 2-46 | TCO-Composition | TCO | 50:50mass% | R. T. | 05 | 0.001 | 300 | 10 | 0.3 | 629 | 41 | 0.67 | 17.3 | 627 | 41 | 0.67 | 17.2 |
| Example 2-47 | TCO-Composition | TCO | 95:5mass% | R. T. | 0.5 | 0.001 | 300 | 10 | 0.3 | 631 | 40 | 0.67 | 16.9 | 630 | 40 | 0.67 | 16.9 |
| Example 2-48 | TCO-Composition | TCO | 70:10:20mass% (SnO2) | R. T. | 05 | 0.001 | 300 | 10 | 03 | 641 | 39 | 0.67 | 16.7 | 636 | 39 | 0.67 | 16.6 |
| Comp. Example 2-22 | TCO-Composition | TCO | 45:55mass% | R. T. | 0.5 | 0.001 | 300 | 10 | 1.1 | 519 | 30 | 0.67 | 10.5 | 500 | 25 | 0.67 | 8.4 |
| Comp. Example 2-23 | TCO-Composition | TCO | 96:4mass% | R. T. | 0.5 | 0.001 | 300 | 10 | 1.3 | 522 | 29 | 0.67 | 10.2 | 501 | 24 | 0.67 | 8.1 |

(continued)

| | Classification | layer | Target In2O3: ZnO (mass%) | Film-Formation Condition | | | | Single-Film Evaluation | | Element Evaluation (Initial) | | | | Element Evaluation (80˚C/85%RH × 1000h) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Sheet Resistance (Ω/□) | Grain Size (nm) | Voc (mV) | Isc (mA) | FF/Pin | Conversion Efficiency (%) | Voc (mV) | Isc (mA) | FF/Pin | Conversion Efficiency (%) |
| Comp. Example 2-24 | TCO-Composition | TCO | 68:10: 22mass% (SnO2) | R. T. | 0.5 | 0.001 | 300 | 10 | 1.1 | 509 | 32 | 0.67 | 10.9 | 495 | 28 | 0.67 | 9.3 |

Results

According to the results of the experiments shown in the above Tables 5 to 8, by regulating the grain size of the respective layers according to the optimized film-forming conditions to be 0.001 $\mu$m or less, the energy conversion efficiency can be improved and reduction in the energy conversion efficiency after the high-temperature and high-humidity test can be restrained to the minimum.

Third Exemplary Embodiment

Next, a third exemplary embodiment of the invention will be described in detail below.
Incidentally, the same components as those in the first and second exemplary embodiments will be denoted by the same reference numeral to omit or simplify the explanation thereof. Further, the duplicate explanation of the first and second exemplary embodiments is also omitted or simplified.

Arrangement of Photovoltaic Element

Fig. 1 is a cross section schematically showing a photovoltaic element of a solar battery according to the invention, in which reference numeral 100B denotes the photovoltaic element that generates an electromotive force by a light incident thereon.
Incidentally, in this exemplary embodiment, a part of the light absorption layer, the buffer layer, the n-type semiconductor layer, the transparent electrode layer and the surface transparent electrode layer of the photovoltaic element are different from those in the first and second exemplary embodiments.
The backside electrode layer is arranged in the same manner as that in the first and second exemplary embodiments, of which details will not be mentioned herein.

Light Absorption Layer

The light absorption layer 130B has a work function in a range from 3 to 7 eV, preferably in a range from 4 to 7 eV and an energy band gap in a range from 1 to 2 eV.

Buffer Layer

The buffer layer 140B has a work function in a range from 4 to 5 eV, preferably in a range from 4.2 to 5 eV and an energy band gap in a range from 3 to 4 eV.

N-Type Semiconductor Layer

The n-type semiconductor layer 150B has a work function in a range from 4 to 5.2 eV, preferably in a range from 4.2 to 5.2 eV. When the work function is smaller than 4 eV, the hole-blocking effect generated in the light absorption layer 130B may be reduced. On the other hand, when the work function exceeds 5.2 eV, an energy barrier may be generated between the n-type semiconductor layer 150B and the transparent electrode layer 160B layered thereon, so that movement of electrons toward the anode may be impeded. Thus, the work function of the n-type semiconductor layer 150B is set in a range from 4 to 5.2 eV, preferably in a range from 4.2 to 5.2 eV.
Further, an energy band gap of the n-type semiconductor layer 150B is set in a range from 3 to 4 eV, preferably in a range from 3.3 to 4 eV. When the energy band gap is smaller than 3 eV, the hole-blocking effect generated in the light absorption layer 130B may be reduced on account of rise in an upper end of valence band (work function + band gap) in a band structure. On the other hand, when the energy band gap exceeds 4 eV, conductivity is significantly lowered to impair the function of n-type semiconductor. Thus, the energy band gap of the n-type semiconductor layer 150B is set in a range from 3 to 4 eV, preferably in a range from 3.3 to 4 eV.
The n-type semiconductor layer 150B is formed by a sputtering (especially DC sputtering) using a mixture gas of, for instance, argon (Ar) and oxygen ($O_2$) under at least one of the conditions of: oxygen partial pressure $pO_2$ being in a range from $1 \times 10^{-2}$ Pa to 0.2 Pa; and substrate temperature in a range from 100 to 200 degrees Celsius, so that the n-type semiconductor layer 150B is made as an amorphous film.

Transparent Electrode Layer

The work function of the transparent electrode layer 160B is larger than that of the n-type semiconductor layer 150B with a difference less than 0.3 eV, which, for instance, is in a range from 4 to 5.5 eV, preferably in a range from 4.5 to 5.5 eV. When the work function is smaller than 4 eV, the hole-blocking effect generated in the light absorption layer 130B may be reduced. On the other hand, when the work function exceeds 5.5 eV, an energy barrier may be generated against the surface transparent electrode layer that is layered thereon or a contact metal layer that is optionally layered thereon as necessary, so that movement of electrons toward the anode may be impeded. Thus, the work function of the transparent electrode layer 160B is set in a range from 4 to 5.5 eV, preferably in a range from 4.5 to 5.5 eV.

Further, the difference in the energy band gap between the transparent electrode layer 160B and the n-type semiconductor layer 150B is 0.2 eV or less. The energy band gap of the transparent electrode layer 160B is set, for instance, in a range from 3 to 4 eV, preferably in a range from 3.3 to 4 eV. When the energy band gap is smaller than 3 eV, the hole-blocking effect generated in the light absorption layer 130B may be reduced. On the other hand, when the energy band gap exceeds 4 eV, an energy barrier may be generated against the surface transparent electrode layer that is layered thereon and the contact metal layer that is optionally layered thereon as necessary, so that movement of electrons toward the anode may be impeded. Thus, the energy band gap of the transparent electrode layer 160B is set in a range from 3 to 4 eV, preferably in a range from 3.3 to 4 eV.

The transparent electrode layer 160B is formed by a sputtering (especially DC sputtering similar to the formation of the n-type semiconductor layer 150B) using a mixture gas of, for instance, Ar and $O_2$ under at least one of the conditions of: oxygen partial pressure $pO_2$ being in a range from $1 \times 10^{-3}$ Pa to $5 \times 10^{-2}$ Pa; and substrate temperature in a range from 100 to 200 degrees Celsius, so that the transparent electrode layer 160B is made as an amorphous film.

Surface Transparent Electrode Layer

The surface transparent electrode layer 170B has a refractivity smaller than that of the transparent electrode layer 160B and is thinly provided on an upper side of the transparent electrode layer 160B by the same material as that of the transparent electrode layer 160B, i.e. made of a material with ($In_2O_3$ + ZnO) as a primary component and is made into an amorphous thin film.

Further, the difference in the work function between the surface transparent electrode layer 170B and n-type semiconductor layer 150B or the transparent electrode layer 160B is less than 0.3 eV. The work function of the surface transparent electrode layer 170B is set, for instance, in a range from 4 to 5.5 eV, preferably in a range from 4.5 to 5.5 eV. When the work function is smaller than 4 eV, the hole-blocking effect generated in the light absorption layer 130B may be reduced. On the other hand, when the work function exceeds 5.5 eV, an energy barrier may be generated against the contact metal layer that is optionally layered thereon as necessary, so that movement of electrons toward the anode may be impeded. Thus, the work function of the surface transparent electrode layer 170B is set in a range from 4 to 5.5 eV, preferably in a range from 4.5 to 5.5 eV.

Further, the difference in the energy band gap between the surface transparent electrode layer 170B and the n-type semiconductor layer 150B or the transparent electrode layer 160B is less than 0.2 eV. The energy band gap of the surface transparent electrode layer 170B is set, for instance, in a range from 3 to 4 eV, preferably in a range from 3.3 to 4 eV. When the energy band gap is smaller than 3 eV, the hole-blocking effect generated in the light absorption layer 130B may be reduced. On the other hand, when the energy band gap exceeds 4 eV, an energy barrier may be generated against the contact metal layer layered thereon, so that movement of electrons toward the anode may be impeded. Thus, the energy band gap of the surface transparent electrode layer 170B is set in a range from 3 to 4 eV, preferably in a range from 3.3 to 4 eV.

The surface transparent electrode layer 170B is formed by a sputtering (especially DC sputtering similar to the formation of the n-type semiconductor layer 150B and the transparent electrode layer 160B) using a mixture gas of, for instance, Ar and $O_2$ under at least one of the conditions of: oxygen partial pressure $pO_2$ being in a range from $1 \times 10^{-3}$ Pa to $5 \times 10^{-2}$ Pa; and substrate temperature in a range from 100 to 200 degrees Celsius, so that the surface transparent electrode layer 170B is made as an amorphous film.

Manufacture Operation of Photovoltaic Element

Next, an operation for manufacturing the photovoltaic element 100B will be described below.

In this exemplary embodiment, a part of the forming steps of the light absorption layer, the buffer layer, the n-type semiconductor layer, the transparent electrode layer and the surface transparent electrode layer of the photovoltaic element are different from those in the first and the second exemplary embodiments.

Light Absorption Layer Forming Step

In the light absorption layer forming step, a group-II-VI semiconductor such as ZnSe, CdS and ZnO, group-III-V semiconductor such as GaAs, InP and GaN, group-IV semiconductor such as SiC and SiGe and chalcopyrite semiconductor (group I-III-VI semiconductor) such as $Cu(In, Ga)Se_2$, $Cu(In, Ga)(Se,S)_2$ and $CuInS_2$ are used. The semicon-

ductor material is formed into a film in the structure of chalcopyrite in a thickness in a range from 0.1 to 10 $\mu$m, preferably from 0.5 to 5 $\mu$m by various film-forming processes such as sputtering and vapor deposition so that the film exhibit a work function in a range from 3 eV to 7 eV, preferably in a range from 4 eV to 7 eV and an energy band gap in a range from 1 eV to 2 eV.

Buffer Layer Forming Step

In the buffer layer forming step, the buffer layer is thinly provided by solution growth of, for instance, InS under the manufacturing condition of CBD (Chemical Bath Deposition) to have a thickness in a range from 0.01 to 0.5 $\mu$m, preferably from 0.1 to 0.5 $\mu$m so that the film exhibit a work function in a range from 4 eV to 5 eV, preferably in a range from 4.2 eV to 5 eV and an energy band gap in a range from 3 eV to 4 eV.

N-Type Semiconductor Layer Forming Step

In the n-type semiconductor layer forming step, in order to form the n-type semiconductor layer 150B, for instance, In and zinc (Zn) are used under a predetermined condition. Specifically, the n-type semiconductor layer 150B is formed by vapor deposition or a sputtering using a mixture gas of, for instance, argon (Ar) and oxygen ($O_2$) under (especially in DC sputtering) at least one of the conditions of: oxygen partial pressure $pO_2$ being in a range from $1 \times 10^{-2}$ Pa to 0.2 Pa; and substrate temperature in a range from 100 to 200 degrees Celsius. Alternatively, the n-type semiconductor layer 150B is provided by DC sputtering or vapor deposition using a composition with indium oxide and zinc oxide as primary components.
The n-type semiconductor layer 150B is thus formed of ($In_2O_3$+ZnO) as primary components in an amorphous film having a thickness in a range from 0.01 to 1 $\mu$m, preferably from 0.1 to 1 $\mu$m. According to the manufacturing condition, the n-type semiconductor layer 150B is formed in an amorphous film having a work function in a range from 4 to 5.2 eV, preferably in a range from 4.2 to 5.2 eV and an energy band gap in a range from 3 to 4 eV.

Surface Transparent Electrode Layer Forming Step

In the transparent electrode-layer forming step, in order to form the transparent electrode layer 160B, the same material as that of the n-type semiconductor layer 150B is used as well as the same film-forming apparatus. Specifically, the transparent electrode layer 160B is formed by a sputtering (especially DC sputtering) using a mixture gas of Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius.
The transparent electrode layer 160B is thus formed of ($In_2O_3$+ZnO) as primary components in an amorphous film having a thickness in a range from 0.01 to 1 $\mu$m, preferably from 0.1 to 1 $\mu$m. According to the manufacturing condition, the transparent electrode layer 160B is formed in an amorphous film having a work function in a range from 4 to 5.5 eV, preferably in a range from 4.5 to 5 eV and an energy band gap in a range from 3 to 4 eV. The difference in the work function between the transparent electrode layer 160B and the n-type semiconductor layer 150B is less than 0.3 eV, and the difference in the energy band gap between the transparent electrode layer 160B and the n-type semiconductor layer 150B is less than 0.2 eV.

Surface Transparent Electrode Layer Forming Step

In the surface transparent electrode-layer forming step, a layer of the same material as the n-type semiconductor layer 150B and the transparent electrode layer 160B is formed on an upper side of the transparent electrode layer 160B formed during the transparent electrode-layer forming step using the same film-forming apparatus. Specifically, the surface transparent electrode layer is formed by a sputtering (especially DC sputtering) using a mixture gas of Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius.
The surface transparent electrode layer 170B is thus formed of ($In_2O_3$+ZnO) as primary components in an amorphous film having a thickness in a range from 0.01 to 1 $\mu$m, preferably from 0.1 to 1 $\mu$m. According to the manufacturing condition, the surface transparent electrode layer 170B is formed in an amorphous film having a work function in a range from 4 to 5.5 eV, preferably in a range from 4.5 to 5 eV and an energy band gap in a range from 3 to 4 eV. The difference in the work function between the surface transparent electrode layer 170B and the n-type semiconductor layer 150B or the transparent electrode layer 160B is less than 0.3 eV, and the difference in the energy band gap between the surface transparent electrode layer 170B and the n-type semiconductor layer 150B or the transparent electrode layer 160B is less than 0.2 eV.

Advantages of the Third Exemplary Embodiment

As described above, the photovoltaic element 100B according to this exemplary embodiment includes: the glass substrate 110; the backside electrode layers 120 provided on a side of the glass substrate 110 in a pair; the p-type conductive light absorption layer 130B provided by a compound having a chalcopyrite-structure, the light absorption layer 130B being layered bridging the backside electrode layers 120; the light-transmissive n-type buffer layer 140B that forms a p-n junction with the light absorption layer 130B, the buffer layer 140B being layered on the light absorption layer 130B; the n-type semiconductor layer 150B that has higher resistance than the buffer layer 140B and forms a p-n junction with the light absorption layer 130B, the n-type semiconductor layer 150B being layered on the buffer layer 140B; and the light-transmissive transparent electrode layer 160B being layered on the n-type semiconductor layer 150B and extending along one side of the light absorption layer 130B, the buffer layer 140B and the n-type semiconductor layer 150B to one of the backside electrode layers 120, where the n-type semiconductor layer 150B is formed in an amorphous thin film containing indium oxide and zinc oxide as primary components that has a work function in a range from 4 eV to 5.2 eV and an energy band gap in a range from 3 eV to 4 eV. Accordingly, simply by providing the n-type semiconductor layer that prevents the reduction in the predetermined high-resistance open end voltage, the movement of the holes and electrons can be effectively controlled and high energy conversion efficiency can be achieved (advantage 3-1).

The n-type semiconductor layer 150B is formed in an amorphous film using indium oxide and zinc oxide as primary components by a sputtering using the mixture gas of Ar and $O_2$ under at least one of the conditions of: oxygen partial pressure $pO_2$ being in a range from $1 \times 10^{-2}$ to 0.2 Pa; and substrate temperature in a range from 100 to 200 degrees Celsius.

Thus, the n-type semiconductor layer 150B that exhibits the above-described favorable properties can be easily formed (advantage 3-2).

Further, the transparent electrode layer 160B is formed in an amorphous film containing indium oxide and zinc oxide as primary components.

Accordingly, the same advantages as the advantages 1-1 and 1-2 in the first exemplary embodiment can be obtained.

The transparent electrode layer 160B is formed by a sputtering using the mixture gas of Ar and $O_2$ under at least one of the conditions of: oxygen partial pressure $pO_2$ being in a range from $1 \times 10^{-3}$ to $5 \times 10^{-2}$ Pa; and substrate temperature in a range from 100 to 200 degrees Celsius, so that the transparent electrode layer 160B is made as an amorphous film.

Accordingly, the same advantage as the advantage 1-3 in the first exemplary embodiment can be obtained.

Further, in this exemplary embodiment, the advantages 1-6, 1-7 and 1-8 in the first exemplary embodiment can be obtained as well as the above advantages.

Examples of the Third Exemplary Embodiment

Next, specific explanation of the present exemplary embodiment will be given below with reference to Examples. It should be understood that the scope of the present exemplary embodiment is by no means limited to the contents covered by the examples.

Preparation of Element Substrate

The backside electrode layer 120 containing Mo (molybdenum) as a primary component was formed in 0.1 $\mu$m thick on the soda-lime glass substrate 110 of 10 cm in height and width at room temperature using a DC magnetron sputtering system. The light absorption layer 130B containing CIGS as a primary component was formed thereon in 1 $\mu$m thick at 350 degrees Celsius by a coevaporation using a molecular beam epitaxy device from an evaporation source of CuS, InS, GaS and SeS. Further, the buffer layer 140B containing InS as a primary component was formed thereon in 0.1 $\mu$m thick at 100 degrees Celsius by a CBD method to provide an element substrate.

Measurement of Thickness

The thicknesses of the respective layers provided on the above element substrate and element substrates in the following Examples were measured by: providing a soda-lime glass provided with a thickness-measuring mask for each of the film-forming steps; providing a step portion by removing the mask after each of the layers were formed; and measuring by a stylus (used instrument: DEKTAK3030 from SLOAN TECHNOLOGY).

Measurement of Work Function

In the following Examples, the work function of each of the respective layers provided on the element substrate was measured by: providing a soda-lime glass for measuring the work function for each of the film-forming steps in addition to the element substrate; and measuring by a work-function measuring instrument after the respective layers were formed (used instrument: AC-1 manufactured by RIKEN KEIKI Co., Ltd).

Measurement of Band Gap

In the following Examples, the band gap of the respective layers provided on the element substrate was measured by: providing a soda-lime glass for measuring the band gap for each of the film-forming steps in addition to the element substrate; and measuring by a spectroscopy after the respective layers were formed (used instrument: U3210 manufactured by Hitachi, Ltd).

Evaluation of Element

The photoelectric conversion efficiency of the photovoltaic element manufactured in the following Examples was calculated by: providing an anode by the transparent electrode layer or the surface transparent electrode layer and a cathode by Mo; forming an extraction electrode of 30 $\mu$m□, 0.5 $\mu$m thick on the transparent electrode layer or the surface transparent electrode layer and on Mo layer by a screen printing using an Ag paste; and evaluating an open voltage (Voc), short-circuit current density (Isc) and a fill factor (FF). Incidentally, a light from a xenon lamp that was adjusted by a predetermined optical filter (solar simulation) was used as a light source.

High Temperature and High Humidity Test

A high-temperature and high-humidity test of the photovoltaic element manufactured in the following Examples was performed by: prior to the Ag paste printing on the photovoltaic element, exposing the photovoltaic element in a high-temperature and high-humidity bath of 80 degrees Celsius and 85 %RH for 1000 hours; printing the Ag past according to the step in the above element evaluation; and evaluating an open voltage (Voc), short-circuit current density (Isc) and a fill factor (FF) to calculate the photoelectric conversion efficiency.

Example 3-1

Formation of N-Type Semiconductor Layer 150B

The n-type semiconductor layer 150B was formed on the element substrate in 0.1 $\mu$m thick at room temperature using a DC magnetron sputtering system and an IZO target ($In_2O_3$: ZnO = 90 [mass%] : 10 [mass%]) at a sputtering pressure of 0.5 Pa and in a mixture gas of argon (Ar) and oxygen ($O_2$) with oxygen partial pressure being 0.2 Pa.
The band gap and the work function of the n-type semiconductor layer 150B formed on the soda-lime glass disposed on a film-forming apparatus simultaneously with the element substrate were measured by spectroscopy and the work-function measuring instrument respectively. The band gap was 3.6 eV and the work function was 5.2 eV.

Formation of Transparent Electrode Layer 160B

The transparent electrode layer 160B was formed on the n-type semiconductor layer 150 in 0.2 $\mu$m thick at room temperature using an IZO target ($In_2O_3$: ZnO = 90 [mass%] : 10 [mass%]) at a sputtering pressure of 0.5 Pa in a mixture gas of argon (Ar) and oxygen ($O_2$) with oxygen partial pressure being 0.001 Pa.
The band gap and the work function of the transparent electrode layer 160B formed on the soda-lime glass disposed on a film-forming apparatus simultaneously with the element substrate were measured by spectroscopy and the work-function measuring instrument respectively. The band gap was 3.6 eV and the work function was 5.1 eV.

Formation of Surface Transparent Electrode Layer 170B

The surface transparent electrode layer 170B was formed on the transparent electrode layer 160B in 0.1 $\mu$m thick at 200 degrees Celsius using an IZO target ($In_2O_3$: ZnO = 90 [mass%] : 10 [mass%]) at a sputtering pressure of 0.5 Pa in a mixture gas of argon (Ar) and oxygen ($O_2$) with oxygen partial pressure being 0.001 Pa.
The band gap and the work function of the surface transparent electrode layer 170B formed on the soda-lime glass disposed on a film-forming apparatus simultaneously with the element substrate were measured by spectroscopy and the work-function measuring instrument respectively. The band gap was 3.5 eV and the work function was 5.1 eV as shown in Table 9.

An extraction electrode was formed on the surface transparent electrode layer 170B and the Mo backside electrode layer 120 of a first photovoltaic element on which the n-type semiconductor layer 150B, the transparent electrode layer 160B and the surface transparent electrode layer 170B were layered by a screen printing using an Ag paste. When the photoelectric conversion efficiency was measured, Voc was 620 mv, Isc was 39 mA and FF (fill factor) / Pin (standard incident power) was 0.67, so that the photoelectric conversion efficiency calculated based on the above values was 16.2 %.

A second photovoltaic element on which the n-type semiconductor layer 150B, the transparent electrode layer 160B and the surface transparent electrode layer 170B were layered by a screen printing using an Ag paste was exposed in an exposure test in a high-temperature and high-humidity condition of 80 degrees Celsius and 85 %RH for 1000 hours. Then, when an extraction electrode was formed on the surface transparent electrode layer and the Mo backside electrode layer that had been subjected to the test by a screen printing using an Ag paste and the photoelectric conversion efficiency was measured, Voc was 619 mv, Isc was 39 mA and FF / Pin was 0.67, so that the photoelectric conversion efficiency calculated based on the above values was 16.2 %.

Incidentally, n layer in the Tables represents the n-type semiconductor layer 150B, TCO represents the transparent electrode layer 160B and S-TCO represents the surface transparent electrode layer 170B.

Examples 3-2 to 3-38 and Comparative Examples 3-1 to 3-14

The n-type semiconductor layer 150B, the transparent electrode layer 160B and the surface transparent electrode layer 170B were formed on the element substrate in the same manner as the Example 3-1 except for the film-forming condition, composition of target and presence/absence of the surface transparent electrode layer 170B. Then, the band gap and work function of each of the layers, the initial element evaluation and element evaluation after being subjected to the high-temperature and high-humidity test were measured, of which results are shown in Tables 9 to 11.

Table 9

| Classification | | Layer | Target In2O3:ZnO (mass%) | Film-Forming Condition | | | | Single Layer Evaluation | | Element Evaluation (initial) | | | | Element Evaluation(80˚C /85%RH × 1000H) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
| Example 3-1 | n-PO2 | n-layer | 90:10mass% | R. T. | 0.5 | 0.2 | 100 | 3.6 | 5.2 | 620 | 39 | 0.67 | 16.2 | 619 | 39 | 0.67 | 16.2 |
| | | TCO | 90:10mass% | R. T. | 0.5 | 0.001 | 200 | 3.6 | 5.1 | | | | | | | | |
| | | S-TCO | 90:10mass% | 200 | 0.5 | 0.001 | 100 | 3.5 | 5.1 | | | | | | | | |
| Example 3-2 | n-PO2 | n-layer | 90:10mass% | R. T. | 0.5 | 0.01 | 100 | 3.6 | 5.2 | 630 | 38 | 0.67 | 16.0 | 628 | 38 | 0.67 | 16.0 |
| | | TCO | 90:10mass% | R. T. | 0.5 | 0.001 | 200 | 3.6 | 5.1 | | | | | | | | |
| | | S-TCO | 90:10mass% | 200 | 0.5 | 0.001 | 100 | 3.5 | 5.1 | | | | | | | | |
| Example 3-3 | n-Tsub | n-layer | 90:10mass% | 100 | 0.5 | 0.009 | 100 | 3.6 | 5.2 | 670 | 41 | 0.67 | 18.4 | 669 | 41 | 0.67 | 18.4 |
| | | TCO | 90:10mass% | R. T. | 0.5 | 0.001 | 200 | 3.6 | 5.1 | | | | | | | | |
| | | S-TCO | 90:10mass% | 200 | 0.5 | 0.001 | 100 | 3.5 | 5.1 | | | | | | | | |
| Example 3-4 | n-Tsub | n-layer | 90:10mass% | 200 | 0.5 | 0.008 | 100 | 3.6 | 5.2 | 625 | 38 | 0.67 | 15.9 | 620 | 38 | 0.67 | 15.8 |
| | | TCO | 90:10mass% | R. T. | 0.5 | 0.001 | 200 | 3.6 | 5.1 | | | | | | | | |
| | | S-TCO | 9010mass% | 200 | 0.5 | 0.001 | 100 | 3.5 | 5.1 | | | | | | | | |
| Example 3-5 | n-Tsub | n-layer | 90:10mass% | 100 | 0.5 | 0.01 | 100 | 3.6 | 5.2 | 630 | 38 | 0.67 | 16.0 | 627 | 38 | 0.67 | 16.0 |
| | | TCO | 90:10mass% | R. T. | 0.5 | 0.001 | 200 | 3.6 | 5.1 | | | | | | | | |
| | | S-TCO | 90:10mass% | 200 | 0.5 | 0.001 | 100 | 3.5 | 5.1 | | | | | | | | |
| Example 3-6 | n-Tsub | n-layer | 90:10mass% | 200 | 0.5 | 0.01 | 100 | 3.6 | 5.2 | 640 | 36 | 0.67 | 15.4 | 630 | 37 | 0.67 | 15.6 |
| | | TCO | 90:10mass% | R. T. | 0.5 | 0.001 | 200 | 3.6 | 5.1 | | | | | | | | |
| | | S-TCO | 90:10mass% | 200 | 0.5 | 0.001 | 100 | 3.5 | 5.1 | | | | | | | | |

| Classification | | Layer | Target In2O3:ZnO (mass%) | Film-Forming Condition | | | | Single Layer Evaluation | | Element Evaluation (initial) | | | | Element Evaluation(80°C /85%RH × 1000H) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
| Example 3-7 | n-PO2 | n-layer | 90:10mass% | R. T. | 0.5 | 0.007 | 100 | 3.6 | 5.3 | 600 | 31 | 0.67 | 12.5 | 590 | 29 | 0.67 | 11.5 |
| | | TCO | 90:10mass% | R. T. | 0.5 | 0.001 | 200 | 3.6 | 5.1 | | | | | | | | |
| | | S-TCO | 90:10mass% | 200 | 0.5 | 0.001 | 100 | 3.5 | 5.1 | | | | | | | | |
| Example 3-8 | TCO-Tsub | n-layer | 90:10mass% | 200 | 0.5 | 0.01 | 100 | 3.6 | 5.2 | 605 | 32 | 0.67 | 13.0 | 603 | 32 | 0.67 | 12.9 |
| | | TCO | 90:10mass% | R. T. | 0.5 | 0.06 | 200 | 3.6 | 5.1 | | | | | | | | |
| | | S-TCO | 90:10mass% | 200 | 0.5 | 0.001 | 100 | 3.5 | 5.1 | | | | | | | | |
| Example 3-9 | STCO-Tsub | n-layer | 90:10mass% | 200 | 0.5 | 0.01 | 100 | 3.6 | 5.2 | 603 | 32 | 0.67 | 12.9 | 602 | 32 | 0.67 | 12.9 |
| | | TCO | 90:10mass% | R. T. | 0.5 | 0.001 | 200 | 3.6 | 5.1 | | | | | | | | |
| | | S-TCO | 90:10mass% | 205 | 0.5 | 0.06 | 100 | 3.5 | 5.1 | | | | | | | | |
| Comp. Example 3-1 | n-PO2 | n-layer | 90:10mass% | R. T. | 0.5 | 0.009 | 100 | 3.7 | 5.4 | 540 | 26 | 0.67 | 9.4 | 460 | 20 | 0.67 | 6.2 |
| | | TCO | 90:10mass% | R. T. | 0.5 | 0.001 | 200 | 3.6 | 5.1 | | | | | | | | |
| | | S-TCO | 90:10mass% | 200 | 05 | 0.001 | 100 | 3.5 | 5.1 | | | | | | | | |
| Comp. Example 3-2 | n-Tsub | n-layer | 90:10mass% | 250 | 0.5 | 0.009 | 100 | 3.7 | 5.4 | 540 | 26 | 0.67 | 9.4 | 430 | 17 | 0.67 | 4.9 |
| | | TCO | 90:10mass% | R. T. | 0.5 | 0.001 | 200 | 3.6 | 5.1 | | | | | | | | |
| | | S-TCO | 90:10mass% | 200 | 0.5 | 0.001 | 100 | 3.5 | 5.1 | | | | | | | | |

EP 2 360 733 A1

Table 10

| | Classification | Layer | Target In2O3: ZnO (mass%) | Film-Forming Condition | | | | Single Layer Evaluation | | Element Evaluation(initial) | | | | Element Evaluation(80˚C /85%RH × 1000H) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
| Example 3-10 | TCO-PO2 | n-layer | 90:10mass% | R. T. | 0.5 | 0.2 | 100 | 3.6 | 52 | 627 | 39 | 0.67 | 16.4 | 624 | 39 | 0.67 | 16.3 |
| | | TCO | 90:10mass% | R. T. | 0.5 | 0.05 | 200 | 3.6 | 51 | | | | | | | | |
| | | S-TCO | 90:10mass% | 200 | 0.5 | 0.001 | 100 | 3.5 | 5.1 | | | | | | | | |
| Example 3-11 | TCO-Tsub | n-layer | 90:10mass% | R. T. | 0.5 | 0.2 | 100 | 3.6 | 5.2 | 632 | 38 | 0.67 | 16.1 | 631 | 38 | 0.67 | 16.1 |
| | | TCO | 90:10mass% | 200 | 0.5 | 0.05 | 200 | 3.6 | 5.1 | | | | | | | | |
| | | S-TCO | 90:10mass% | 200 | 0.5 | 0.001 | 100 | 3.5 | 51 | | | | | | | | |
| Example 3-12 | TCO-Tsub | n-layer | 90:10mass% | R. T. | 0.5 | 0.2 | 100 | 3.6 | 5.2 | 650 | 41 | 0.67 | 17.9 | 647 | 41 | 0.67 | 17.8 |
| | | TCO | 90:10mass% | 200 | 0.5 | 0.06 | 200 | 3.6 | 5.1 | | | | | | | | |
| | | S-TCO | 90:10mass% | 200 | 0.5 | 0.001 | 100 | 3.5 | 5.1 | | | | | | | | |
| Example3-13 | TCO-Tsub | n-layer | 90:10mass% | R. T. | 0.5 | 0.2 | 100 | 3.6 | 5.2 | 635 | 38 | 0.67 | 16.2 | 633 | 38 | 0.67 | 16.1 |
| | | TCO | 90:10mass% | 100 | 0.5 | 0.05 | 200 | 3.6 | 5.1 | | | | | | | | |
| | | S-TCO | 90:10mass% | 200 | 0.5 | 0.001 | 100 | 3.5 | 51 | | | | | | | | |
| Example 3-14 | TCO-Tsub | n-layer | 90:10mass% | R. T. | 0.5 | 0.2 | 100 | 3.6 | 52 | 630 | 39 | 0.67 | 16.5 | 627 | 39 | 0.67 | 16.4 |
| | | TOO | 90:10mass% | 100 | 0.5 | 0.06 | 200 | 3.6 | 5.1 | | | | | | | | |
| | | S-TCO | 90:10mass% | 200 | 0.5 | 0.001 | 100 | 3.5 | 5.1 | | | | | | | | |
| Comp. Example 3-3 | TCO-PO2 | n-layer | 90:10mass% | R. T. | 0.5 | 0.2 | 100 | 3.6 | 5.2 | 530 | 29 | 0.67 | 10.3 | 502 | 26 | 0.67 | 8.7 |
| | | TCO | 90:10mass% | R. T. | 0.5 | 0.06 | 200 | 3.7 | 5.5 | | | | | | | | |
| | | S-TCO | 90:10mass% | 200 | 0.5 | 0.001 | 100 | 3.5 | 5.1 | | | | | | | | |

(continued)

| | Classification | Layer | Target In2O3: ZnO (mass%) | Film-Forming Condition | | | | Single Layer Evaluation | | Element Evaluation(initial) | | | | Element Evaluation(80˚C /85%RH × 1000H) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
| Comp. Example 3-4 | TCO-Tsub | n-layer | 90:10mass% | R. T. | 0.5 | 0.2 | 100 | 3.6 | 5.2 | 535 | 28 | 0.67 | 10.0 | 507 | 26 | 0.67 | 8.8 |
| | | TOO | 90:10mass% | 250 | 0.5 | 0.06 | 200 | 3.7 | 5.5 | | | | | | | | |
| | | S-TCO | 90:10mass% | 200 | 0.5 | 0.001 | 100 | 3.5 | 5.1 | | | | | | | | |
| Example 3-15 | TCO-Composition | n-layer | 50:50mass% | R. T. | 0.5 | 0.2 | 100 | 3.6 | 5.2 | 629 | 41 | 0.67 | 17.3 | 627 | 41 | 0.67 | 17.2 |
| | | TCO | 50.50mass% | R. T. | 0.5 | 0.001 | 200 | 3.6 | 5.1 | | | | | | | | |
| | | S-TCO | 50:50mass% | 200 | 0.5 | 0.001 | 100 | 3.5 | 5.1 | | | | | | | | |
| Example 3-16 | TCO-Composition | n-layer | 95:5 mass% | R. T. | 0.5 | 0.2 | 100 | 3.6 | 5.2 | 631 | 40 | 0.67 | 16.9 | 630 | 40 | 0.67 | 16.9 |
| | | TCO | 95:5mass% | R. T. | 0.5 | 0.001 | 200 | 3.6 | 5.1 | | | | | | | | |
| | | S-TCO | 95:5mass% | 100 | 0.5 | 0.001 | 100 | 3.5 | 5.1 | | | | | | | | |
| Example 3-17 | TCO-Composition | n-layer | 70:10: 20mass% (SnO2) | R. T. | 0.5 | 0.2 | 100 | 3.6 | 5.2 | 641 | 39 | 0.67 | 16.7 | 636 | 39 | 0.67 | 16.6 |
| | | TCO | 70:10: 20mass% (SnO2) | R. T. | 0.5 | 0.001 | 200 | 3.6 | 5.1 | | | | | | | | |
| | | S-TCO | 70:10: 20mass% (SnO2) | 200 | 0.5 | 0.001 | 100 | 3.5 | 5.1 | | | | | | | | |
| Example 3-18 | TCO-Composition | n-layer | 45:55mass% | R. T. | 0.5 | 0.2 | 100 | 3.7 | 54 | 601 | 31 | 0.67 | 12.5 | 590 | 29 | 0.67 | 11.5 |
| | | TCO | 90:10mass% | 200 | 0.5 | 0.001 | 200 | 3.6 | 52 | | | | | | | | |
| | | S-TCO | 90:10mass% | 200 | 0.5 | 0.001 | 100 | 3.5 | 51 | | | | | | | | |
| Example 3-19 | TCO-Composition | n-laver | 90:10mass% | R. T. | 0.5 | 0.2 | 100 | 3.7 | 54 | 604 | 32 | 0.67 | 13.0 | 603 | 32 | 0.67 | 12.9 |
| | | TCO | 45:55mass% | 200 | 0.5 | 0.001 | 200 | 3.6 | 52 | | | | | | | | |
| | | S-TCO | 90:10mass% | 200 | 0.5 | 0.001 | 100 | 3.5 | 5.1 | | | | | | | | |

(continued)

| | Classification | Layer | Target In2O3: ZnO (mass%) | Film-Forming Condition | | | | Single Layer Evaluation | | Element Evaluation(initial) | | | | Element Evaluation(80˚C /85%RH × 1000H) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
| Example 3-20 | TCO-Composition | n-layer | 90:10mass% | R. T. | 0.5 | 0.2 | 100 | 3.7 | 5.4 | 603 | 32 | 0.67 | 12.9 | 602 | 32 | 0.67 | 12.9 |
| | | TCO | 90:10mass% | 200 | 0.5 | 0.001 | 200 | 3.6 | 5.2 | | | | | | | | |
| | | S-TCO | 45:55mass% | 200 | 0.5 | 0.001 | 100 | 3.5 | 5.1 | | | | | | | | |
| Comp. Example 3-5 | TCO-Composition | n-layer | 45:55mass% | R. T. | 0.5 | 0.2 | 100 | 3.7 | 5.4 | 520 | 30 | 0.67 | 10.5 | 500 | 25 | 0.67 | 8.4 |
| | | TCO | 45:55mass% | R. T. | 0.5 | 0.001 | 200 | 3.6 | 5.1 | | | | | | | | |
| | | S-TCO | 45:55mass% | 200 | 0.5 | 0.001 | 100 | 3.5 | 5.1 | | | | | | | | |
| Comp. Example 3-6 | TCO-Composition | n-layer | 96:4mass% | R. T. | 0.5 | 0.2 | 100 | 3.7 | 5.4 | 523 | 29 | 0.67 | 10.2 | 501 | 24 | 0.67 | 8.1 |
| | | TCO | 96:4mass% | R. T. | 0.5 | 0.001 | 200 | 3.6 | 5.1 | | | | | | | | |
| | | S-TCO | 96:4mass% | 200 | 0.5 | 0.001 | 100 | 3.5 | 5.1 | | | | | | | | |
| Comp. Example 3-7 | TCO-Composition | n-layer | 68:10: 22mass% (SnO2) | R. T. | 0.5 | 0.2 | 100 | 3.7 | 5.4 | 510 | 32 | 0.67 | 10.9 | 495 | 28 | 0.67 | 9.3 |
| | | TCO | 68:10: 22mass% (SnO2) | R. T. | 0.5 | 0.001 | 200 | 3.6 | 5.1 | | | | | | | | |
| | | S-TCO | 68:10: 22mass% (SnO2) | 200 | 0.5 | 0.001 | 100 | 3.5 | 5.1 | | | | | | | | |

Table 11

| | Classification | Layer | Target In2O3: ZnO (mass%) | Film-Forming Condition | | | | Single Layer Evaluation | | Element Evaluation(initial) | | | | Element Evaluation(80°C/ 85%RH×1000H) | | | |
| | | | | Tsub (°C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
|---|---|---|---|---|---|---|---|---|---|---|---|---|---|---|---|---|---|
| Example3-21 | n-PO2 | n-layer | 90:10mass% | R. T. | 0.5 | 0.2 | 100 | 3.6 | 5.2 | 620 | 39 | 0.67 | 16.2 | 619 | 39 | 0.67 | 16.2 |
| | | TCO | 90.10mass% | R. T. | 0.5 | 0.001 | 200 | 3.6 | 51 | | | | | | | | |
| Example3-22 | n-PO2 | n-layer | 90:10mass% | R. T. | 0.5 | 0.01 | 100 | 3.6 | 5.2 | 630 | 38 | 0.67 | 16.0 | 628 | 38 | 0.67 | 16.0 |
| | | TCO | 90.10mass% | R. T. | 0.5 | 0.001 | 200 | 3.6 | 5.1 | | | | | | | | |
| Example3-23 | n-Tsub | n-layer | 90:10mass% | 100 | 0.5 | 0.009 | 100 | 3.6 | 5.2 | 670 | 41 | 0.67 | 18.4 | 669 | 41 | 0.67 | 18.4 |
| | | TCO | 90.10mass% | R. T. | 0.5 | 0.001 | 200 | 3.6 | 5.1 | | | | | | | | |
| Example3-24 | n-Tsub | n-layer | 90:10mass% | 200 | 0.5 | 0.008 | 100 | 3.6 | 5.2 | 625 | 38 | 0.67 | 15.9 | 620 | 38 | 0.67 | 15.8 |
| | | TCO | 90.10mass% | R. T. | 0.5 | 0.001 | 200 | 3.6 | 5.1 | | | | | | | | |
| Example3-25 | n-Tsub | n-layer | 90:10mass% | 100 | 0.5 | 0.01 | 100 | 3.6 | 5.2 | 630 | 38 | 0.67 | 16.0 | 627 | 38 | 0.67 | 16.0 |
| | | TCO | 90.10mass% | R. T. | 0.5 | 0.001 | 200 | 3.6 | 5.1 | | | | | | | | |
| Example3-26 | n-Tsub | n-layer | 90:10mass% | 200 | 0.5 | 0.01 | 100 | 3.6 | 5.2 | 640 | 36 | 0.67 | 15.4 | 630 | 37 | 0.67 | 15.6 |
| | | TCO | 90.10mass% | R. T. | 0.5 | 0.001 | 200 | 36 | 5.1 | | | | | | | | |
| Example3-27 | n-PO2 | n-layer | 90:10mass% | R. T. | 0.5 | 0.007 | 100 | 3.6 | 5.3 | 600 | 31 | 0.67 | 12.5 | 590 | 29 | 0.67 | 11.5 |
| | | TCO | 90.10mass% | R. T. | 0.5 | 0.001 | 200 | 36 | 5.1 | | | | | | | | |
| Example3-28 | TCO-Tsub | n-layer | 90:10mass% | 200 | 0.5 | 0.01 | 100 | 3.6 | 5.2 | 605 | 32 | 0.67 | 13.0 | 603 | 32 | 0.67 | 12.9 |
| | | TCO | 90.10mass% | R. T. | 0.5 | 0.06 | 200 | 3.6 | 5.1 | | | | | | | | |
| Comp. Example3-8 | n-PO2 | n-layer | 90:10mass% | R. T. | 0.5 | 0.009 | 100 | 3.7 | 5.4 | 540 | 26 | 0.67 | 9.4 | 460 | 20 | 0.67 | 6.2 |
| | | TCO | 90.10mass% | R. T. | 0.5 | 0.001 | 200 | 3.5 | 5.1 | | | | | | | | |

| | Classification | Layer | Target In2O3:ZnO (mass%) | Film-Forming Condition | | | | Single Layer Evaluation | | Element Evaluation(initial) | | | | Element Evaluation(80˚C/85%RH×1000H) | | | |
|---|---|---|---|---|---|---|---|---|---|---|---|---|---|---|---|---|---|
| | | | | Tsub (˚C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
| Comp. Example3-9 | n-Tsub | n-layer | 90:10mass% | 250 | 0.5 | 0.009 | 100 | 3.7 | 5.4 | 540 | 26 | 0.67 | 9.4 | 430 | 17 | 0.67 | 4.9 |
| | | TCO | 90:10mass% | R. T. | 0.5 | 0.001 | 200 | 3.5 | 5.1 | | | | | | | | |
| Example3-29 | TCO-PO2 | n-layer | 90:10mass% | R. T. | 0.5 | 0.2 | 100 | 3.6 | 5.2 | 627 | 39 | 0.67 | 16.4 | 624 | 39 | 0.67 | 16.3 |
| | | TCO | 90:10mass% | R. T. | 0.5 | 0.05 | 200 | 3.6 | 5.1 | | | | | | | | |
| Example3-30 | TCO-Tsub | n-layer | 90:10mass% | R. T. | 0.5 | 0.2 | 100 | 3.6 | 5.2 | 632 | 38 | 0.67 | 16.1 | 631 | 38 | 0.67 | 16.1 |
| | | TCO | 90:10mass% | 200 | 0.5 | 0.05 | 200 | 3.6 | 5.1 | | | | | | | | |
| Example3-31 | TCO-Tsub | n-layer | 90:10mass% | R. T. | 0.5 | 0.2 | 100 | 3.6 | 5.2 | 650 | 41 | 0.67 | 17.9 | 647 | 41 | 0.67 | 17.8 |
| | | TCO | 90:10mass% | 200 | 0.5 | 0.06 | 200 | 3.6 | 5.1 | | | | | | | | |
| Example3-32 | TCO-Tsub | n-layer | 90:10mass% | R. T. | 0.5 | 0.2 | 100 | 3.6 | 5.2 | 635 | 38 | 0.67 | 16.2 | 633 | 38 | 0.67 | 16.1 |
| | | TCO | 90:10mass% | 100 | 0.5 | 0.05 | 200 | 3.6 | 5.1 | | | | | | | | |
| Example3-33 | TCO-Tsub | n-layer | 90:10mass% | R. T. | 0.5 | 0.2 | 100 | 3.6 | 5.2 | 630 | 39 | 0.67 | 16.5 | 627 | 39 | 0.67 | 16.4 |
| | | TCO | 90:10mass% | 100 | 0.5 | 0.06 | 200 | 3.6 | 5.1 | | | | | | | | |
| Comp. Example3-10 | TCO-PO2 | n-layer | 90:10mass% | R. T. | 0.5 | 0.2 | 100 | 3.7 | 5.4 | 530 | 29 | 0.67 | 10.3 | 502 | 26 | 0.67 | 8.7 |
| | | TCO | 90:10mass% | R. T. | 0.5 | 0.06 | 200 | 3.5 | 5.1 | | | | | | | | |
| Comp. Example3-11 | TCO-Tsub | n- layer | 90:10mass% | R. T. | 0.5 | 0.2 | 100 | 3.7 | 5.4 | 535 | 28 | 0.67 | 10.0 | 507 | 26 | 0.67 | 8.8 |
| | | TCO | 90:10mass% | 250 | 0.5 | 0.06 | 200 | 3.5 | 5.1 | | | | | | | | |
| Examples3-34 | TCO-Composition | n-layer | 50:50mass% | R. T. | 0.5 | 0.2 | 100 | 3.6 | 5.2 | 629 | 41 | 0.67 | 17.3 | 627 | 41 | 0.67 | 17.2 |
| | | TCO | 50:50mass% | R. T. | 0.5 | 0.001 | 200 | 3.6 | 5.1 | | | | | | | | |
| Example3-35 | TCO-Composition | n-layer | 95:5mass% | R. T. | 0.5 | 0.2 | 100 | 3.6 | 5.2 | 631 | 40 | 0.67 | 16.9 | 630 | 40 | 0.67 | 16.9 |
| | | TCO | 95:5mass% | R. T. | 0.5 | 0.001 | 200 | 3.6 | 5.1 | | | | | | | | |

| | Classification | Layer | Target In2O3: ZnO (mass%) | Film-Forming Condition | | | | Single Layer Evaluation | | Element Evaluation(initial) | | | | Element Evaluation(80°C/ 85%RH×1000H) | | | |
|---|---|---|---|---|---|---|---|---|---|---|---|---|---|---|---|---|---|
| | | | | Tsub (°C) | Total Pressure (Pa) | pO2 (Pa) | Thickness (nm) | Eg (eV) | Wf (eV) | Voc (mV) | Isc (mA) | FF/Pin | Conversion Efficiency (%) | Voc (mV) | Isc (mA) | FF/Pin | Conversion Efficiency (%) |
| Example3-36 | TCO-Composition | n-layer | 70:10:20mass% (SnO2) | R. T. | 0.5 | 0.2 | 100 | 3.6 | 5.2 | 641 | 39 | 0.67 | 16.7 | 636 | 39 | 0.67 | 16.6 |
| | | TCO | 70:10:20mass% (SnO2) | R. T. | 0.5 | 0.001 | 200 | 3.6 | 5.1 | | | | | | | | |
| Example3-37 | TCO-Composition | n-layer | 45:55mass% | R. T. | 0.5 | 0.2 | 100 | 3.7 | 5.4 | 601 | 31 | 0.67 | 12.5 | 590 | 29 | 0.67 | 11.5 |
| | | TCO | 90.10mass% | 200 | 0.5 | 0.001 | 200 | 3.6 | 5.2 | | | | | | | | |
| Example3-38 | TCO-Composition | n-layer | 90:10mass% | R. T. | 0.5 | 0.2 | 100 | 3.7 | 5.4 | 604 | 32 | 0.67 | 13.0 | 603 | 32 | 0.67 | 12.9 |
| | | TCO | 45:55mass% | 200 | 0.5 | 0.001 | 200 | 36 | 5.2 | | | | | | | | |
| Comp. Example3-12 | TCO-Composition | n-layer | 45:55mass% | R. T. | 0.5 | 0.2 | 100 | 3.7 | 5.4 | 520 | 30 | 0.67 | 10.5 | 500 | 25 | 0.67 | 8.4 |
| | | TCO | 45:55mass% | R. T. | 0.5 | 0.001 | 200 | 3.5 | 5.1 | | | | | | | | |
| Comp. Examples3-13 | TCO-Composition | n-layer | 96:4mass% | R. T. | 0.5 | 0.2 | 100 | 3.7 | 5.4 | 523 | 29 | 0.67 | 10.2 | 501 | 24 | 0.67 | 8.1 |
| | | TCO | 96:4masss% | R. T. | 0.5 | 0.001 | 200 | 3.5 | 5.1 | | | | | | | | |
| Comp. Example3-14 | TCO-Composition | n-layer | 68:10:22 mass% (SnO2) | R. T. | 0.5 | 0.2 | 100 | 3.7 | 5.4 | 510 | 32 | 067 | 10.9 | 495 | 28 | 0.67 | 9.3 |
| | | TCO | 68:10:22 mass% (SnO2) | R. T. | 0.5 | 0.001 | 200 | 3.5 | 5.1 | | | | | | | | |

Results

According to the results of the experiments shown in the above Tables 9 to 11l, it is understood that the closer the work functions of the n-type semiconductor layer 150B, the transparent electrode layer 160B and the surface transparent electrode layer 170B are, the more the energy conversion efficiency is improved.

Fourth Exemplary Embodiment

Next, a fourth exemplary embodiment of the invention will be described in detail below.
Incidentally, the same components as those in the first to third exemplary embodiments will be denoted by the same reference numeral to omit or simplify the explanation thereof. Further, duplicate explanation of the first to third exemplary embodiments is also omitted or simplified.

Arrangement of Photovoltaic Element

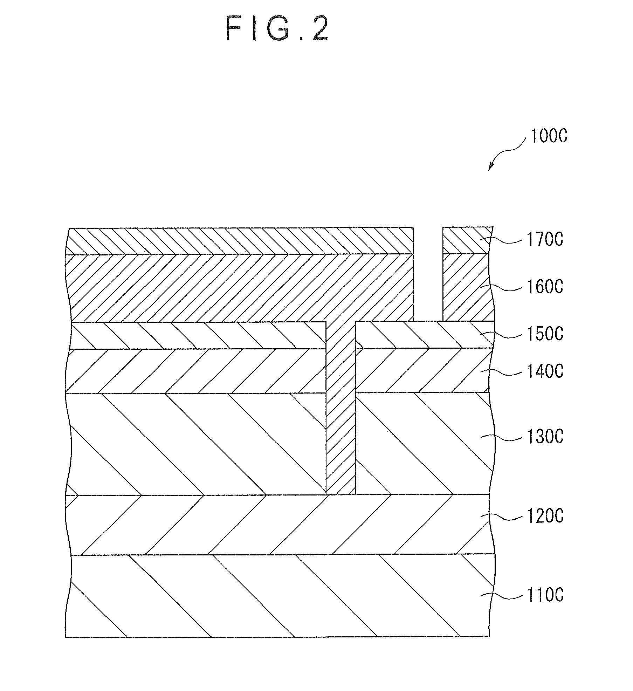

Fig. 2 is a cross section schematically showing a solar battery according to this exemplary embodiment, in which reference numeral 100C denotes a photovoltaic element that generates an electromotive force by a light incident thereon.
Incidentally, in this exemplary embodiment, a part of the light absorption layer, the buffer layer, the n-type semiconductor layer, the transparent electrode layer and the surface transparent electrode layer of the photovoltaic element is different from those in the first, second and third exemplary embodiments.
The backside electrode layer is arranged in the same manner as that in the first, second and third exemplary embodiments, of which details will not be mentioned herein.

Light Absorption Layer

The light absorption layer 130C in this exemplary embodiment is exemplarily formed as a so-called CIGS light absorption layer that is provided by Cu, In, Ga and Se in a thin film by sputtering, vapor deposition and the like. In other words, various materials are used in various film-forming processes in order to provide chalcopyrite-structure composition when being formed in a film. The CIGS light absorption layer can provide a photovoltaic element that is adapted to control a width of a forbidden band (band gap) by controlling a composition ratio of group III element such as In and Ga, so that a photovoltaic element that exhibits high photoelectric conversion efficiency can be provided.

Buffer Layer

Though the buffer layer 140C is exemplarily provided by InS in this exemplary embodiment since CIGS material is exemplarily used as the light absorption layer 130C, any material such as CdS and ZnO can be used as long as the material can favorably form a p-n junction with the light absorption layer 130C.
Further, as described above, the buffer layer 140C is divided together with the light absorption layer 130C by the mechanical scribing.
The buffer layer 140C preferably has a thickness in a range from 0.01 to 0.5 $\mu$m, more preferably from 0.1 to 0.5 $\mu$m. When the buffer layer 140C is thinner than 0.01 $\mu$m, p-n junction may become uneven. On the other hand, when the buffer layer 140C is thicker than 0.5 $\mu$m, the external light is blocked and the light absorption amount of the CIGS layer may be reduced. Thus, the thickness of the buffer layer 140C is set in a range from 0.01 to 0.5 $\mu$m, preferably from 0.1 to 0.5 $\mu$m.

N-Type Semiconductor Layer

The n-type semiconductor layer 150C can be provided by an amorphous oxide comprising at least one of indium (In), zinc (Zn), tin (Sn), aluminum (Al), gallium (Ga), tungsten (W), cerium (Ce) and titanium (Ti). For instance, though IZO ($In_2O_3$ + ZnO) is used in this exemplary embodiment, other compounds such as ZnO, $SnO_2$, $In_2O_3$, ITO ($In_2O_3$+$SnO_2$), AZO($Al_2O_3$+ZnO) and $TiO_2$ are usable as the material of the layer.
Further, the refractivity of the n-type semiconductor layer 150C is set in a range from 1.6 to 2.0, preferably in a range from 1.6 to 1.9. When the refractivity is smaller than 1.6, a light reflected by a back-side reflection electrode may be leaked out so that light containment effect may be deteriorated. On the other hand, when the reflectivity is larger than 2, an external light may be reflected before reaching to the CIGS layer. Thus, the refractivity of the n-type semiconductor layer 150C is set in a range from 1.6 to 2.0, preferably in a range from 1.6 to 1.9.
The n-type semiconductor layer 150C preferably has a thickness in a range from 0.01 to 1 $\mu$m, more preferably from

0.1 to 1 $\mu$m. When the n-type semiconductor layer 150C is thinner than 0.01 $\mu$m, the hole-blocking effect generated in the CIGS layer may be reduced. On the other hand, when the n-type semiconductor layer 150C is thicker than 1 $\mu$m, the light absorption of the external light may be hindered. Thus, the thickness of the n-type semiconductor layer 150C is set in a range from 0.01 to 1 $\mu$m, preferably from 0.1 to 1 $\mu$m.

Further, the resistance value of the n-type semiconductor layer 150C is in a range from 1 k$\Omega$/$\square$ to 1000 k$\Omega$/$\square$. When the resistance value is smaller than 1 k$\Omega$/$\square$, the electrons formed in the light absorption layer are easily transferred toward the anode, so that the open end voltage may be decreased to cause reduction in the photoelectric conversion efficiency. On the other hand, when the resistance value exceeds 1000 k$\Omega$/$\square$, though the open end voltage is increased, the drive voltage of the photovoltaic element 100 may be raised. Thus, the resistance value of the n-type semiconductor layer 150C is set in a range from 1 k$\Omega$/$\square$ to 1000 k$\Omega$/$\square$.

Transparent Electrode Layer

The transparent electrode layer 160C (upper electrode) is layered in a thin film on an upper side of the n-type semiconductor layer 150C. The transparent electrode layer 160C is provided by the same material (IZO) as that of the above-described n-type semiconductor layer 150C in this exemplary embodiment. When the n-type semiconductor layer 150C is provided by an amorphous oxide material other than IZO, the transparent electrode layer 160C is provided by the same oxide material. Since the n-type semiconductor layer 150C is provided by the same material as that used for forming the transparent electrode layer 160C, the n-type semiconductor layer 150C and the transparent electrode layer 160C can be provided by the same apparatus according to the same film-forming process.

Further, the refractivity of the transparent electrode layer 160C is larger than that of the n-type semiconductor layer 150C and is set in a range from 1.8 to 2.3, preferably in a range from 2 to 2.3. When the refractivity is smaller than 1.8, a light reflected by a back-side reflection electrode may be leaked out so that light containment effect may be deteriorated. On the other hand, when the refractivity is larger than 2.3, the light absorption of the CIGS layer may be reduced on account of the reflection of the external light at the transparent electrode layer 160C. Thus, the refractivity of the transparent electrode layer 160C is set in a range from 1.8 to 2.3, preferably in a range from 2.0 to 2.3.

Surface Transparent Electrode Layer

The surface transparent electrode layer 170C is formed in a thin film on an upper side of the transparent electrode layer 160C using the same material (IZO) used for forming the n-type semiconductor layer 150C and the transparent electrode layer 160C. When the n-type semiconductor layer 150C and the transparent electrode layer 160C are provided by an amorphous oxide material other than IZO, the surface transparent electrode layer 170C is provided by the same oxide material. Since the n-type semiconductor layer 150C, the transparent electrode layer 160C and the surface transparent electrode layer 170C are provided by the same material, the n-type semiconductor layer 150C, the transparent electrode layer 160C and the surface transparent electrode layer 170C can be provided by the same apparatus according to the same film-forming process.

Further, the refractivity of the surface transparent electrode layer 170C is larger than that of the transparent electrode layer 160C and is set in a range from 1.6 to 2.0, preferably in a range from 1.6 to 1.9. When the refractivity is smaller than 1.6, a light reflected by a back-side reflection electrode may be leaked out so that light containment effect may be deteriorated. On the other hand, when the refractivity is larger than 2.0, the light absorption of the CIGS layer may be reduced on account of the reflection of the external light at the surface transparent electrode layer. Thus, the refractivity of the surface transparent electrode layer 170C is set in a range from 1.6 to 2.0, preferably in a range from 1.6 to 1.9.

The surface transparent electrode layer 170C preferably has a thickness in a range from 0.01 to 1 $\mu$m, more preferably from 0.1 to 1 $\mu$m. When the surface transparent electrode layer 170C is thinner than 0.01 $\mu$m, anti-reflection effect may be deteriorated. On the other hand, when the surface transparent electrode layer 170C is thicker than 1 $\mu$m, transmissivity may be deteriorated. Thus, the thickness of the surface transparent electrode layer 170C is set in a range from 0.01 to 1 $\mu$m, preferably from 0.1 to 1 $\mu$m.

Manufacture Operation of Photovoltaic Element

Next, an operation for manufacturing the photovoltaic element 100C will be described below.
In this exemplary embodiment, a part of the forming steps of the backside electrode layer, the light absorption layer, the buffer layer, the n-type semiconductor layer, the transparent electrode layer and the surface transparent electrode layer of the photovoltaic element are different from those in the first, second and the third exemplary embodiments.

Backside Electrode Layer Forming Step

In the backside electrode layer forming step, the backside electrode layer 120C is thinly formed on the glass substrate 110.

Specifically, an electrode material such as Mo (molybdenum) is formed into a film on the glass substrate 110 in thickness in a range from 0.01 to 1 $\mu$m, preferably from 0.1 to 1 $\mu$m by various film-forming processes such as DC sputtering.

Light Absorption Layer Forming Step

Next a light absorption layer 130C provided by a compound having the above-described chalcopyrite crystal structure is formed on the backside electrode layer 120C by vapor deposition, sputtering, plasma CVD, spraying, printing and the like. In this exemplary embodiment, the so-called CIGS light absorption layer formed of Cu, In, Ga and Se in a thin film by sputtering, vapor deposition and the like is provided. The light absorption layer 130C can be provided by various processes such as, for instance, selenization of Cu-In-Ga while annealing. Thus, the thickness of the light absorption layer 130C is set in a range from 0.1 to 10 $\mu$m, preferably from 0.5 to 5 $\mu$m.

Incidentally, after the light absorption layer 130C is formed on the backside electrode layer 120C and below-described buffer layer 140C is formed thereon, the light absorption layer 130C is divided to expose the backside electrode layer 120C by, for instance, mechanical scribing, so that the light absorption layer 130C bridges the adjacent backside electrode layers 120C.

Buffer Layer Forming Step

In the buffer layer forming step, the light-transmissive n-type buffer layer 140C that forms a p-n junction with the light absorption layer 130C is formed on the light absorption layer 130C formed during the light absorption layer forming step.

The buffer layer 140C is thinly provided by solution growth of, for instance, InS under the manufacturing condition of CBD (Chemical Bath Deposition) to have a thickness in a range from 0.01 to 0.5 $\mu$m, preferably from 0.1 to 0.5 $\mu$m so that the refractivity and the thickness of the buffer layer 140C itself come within a predetermined range.

N-Type Semiconductor Layer Forming Step

Next, the light-transmissive amorphous n-type semiconductor layer 150C that exhibits a higher resistance than the buffer layer 140C and is n-type against the light absorption layer 130C is formed on the buffer layer 140C while appropriately adjusting the film-forming conditions so that the refractivity and the thickness come within the above-described range.

In order to form the n-type semiconductor layer 150C, for instance, indium (In) and zinc (Zn) are used under a predetermined condition. Specifically, the n-type semiconductor layer 150C is formed by a sputtering (especially DC sputtering) using a mixture gas of argon (Ar) and oxygen ($O_2$) under at least one of the conditions of: oxygen partial pressure $pO_2$ being in a range from $1 \times 10^{-2}$ to 0.2 Pa; and substrate temperature in a range from 100 to 200 degrees Celsius.

The n-type semiconductor layer 150C is thus formed of ($In_2O_3$+ZnO) as primary components in an amorphous film having a thickness in a range from 0.01 to 1 $\mu$m, preferably from 0.1 to 1 $\mu$m. According to the above manufacturing conditions, the n-type semiconductor layer 150C is provided as an amorphous layer having a refractivity in a range from 1.6 to 2.0.

Surface Transparent Electrode Layer Forming Step

Next, the transparent electrode layer 160C is formed on the n-type semiconductor layer 150C by the same DC sputtering as that used in the n-type semiconductor layer forming step while appropriately adjusting the film-forming conditions so that the refractivity and the thickness come within the above-described range.

In order to form the transparent electrode layer 160C, the same material as the n-type semiconductor layer 150C is used as well as the same film-forming process. Specifically, the surface transparent electrode layer is formed by a sputtering (especially DC sputtering) using a mixture gas of Ar and $O_2$ under at least one of the conditions of: oxygen partial pressure being in a range from $1 \times 10^{-3}$ to $5 \times 10^{-2}$ Pa; and substrate temperature in a range from 100 to 200 degrees Celsius.

The surface transparent electrode layer is thus formed of ($In_2O_3$+ZnO) as primary components in an amorphous film having a thickness in a range from 0.01 to 1 $\mu$m, preferably from 0.1 to 1 $\mu$m. According to the above manufacturing conditions, the transparent electrode layer 160C is formed in an amorphous film having refractivity in a range from 1.6 to 2, preferably in a range from 1.6 to 1.9.

Surface Transparent Electrode Layer Forming Step

Next, the surface transparent electrode layer 170C is formed on the transparent electrode layer 160C by the same DC sputtering as that used in the n-type semiconductor layer forming step and the transparent electrode forming step while appropriately adjusting the film-forming conditions so that the refractivity and the thickness come within the above-described range.

In order to form the transparent electrode layer 160C, the same material as those of the n-type semiconductor layer 150C and the transparent electrode layer 160C is used as well as the same film-forming process. Specifically, the transparent electrode layer is formed by a sputtering (especially DC sputtering) using a mixture gas of Ar and $O_2$ under at least one of the conditions of: oxygen partial pressure being in a range from $1 \times 10^{-3}$ to $5 \times 10^{-2}$ Pa; and substrate temperature in a range from 100 to 200 degrees Celsius.

The surface transparent electrode layer is thus formed of $(In_2O_3+ZnO)$ as primary components in an amorphous film having a thickness in a range from 0.01 to 1 $\mu$m, preferably from 0.1 to 1 $\mu$m. According to the above manufacturing conditions, the surface transparent electrode layer 170C is formed in an amorphous film having refractivity in a range from 1.6 to 2, preferably in a range from 1.6 to 1.9.

Advantages of the Fourth Exemplary Embodiment

As described above, the following advantages are provided by the photovoltaic element 100C according to this exemplary embodiment.

The n-type semiconductor layer 150C, the transparent electrode layer 160C and the surface transparent electrode layer 170C are provided by the same layer material (IZO) as primary components and the same DC sputtering apparatus under the above described predetermined temperature and oxygen partial pressure conditions, so that the layer structure exhibits the above-described refractivity and layer thickness.

Accordingly: the refractivity of the n-type semiconductor layer 150C is in a range from 1.6 to 2.0; the refractivity of the transparent electrode layer 160C is in a range from 1.8 to 2.3; and the refractivity of the surface transparent electrode layer 170C is in a range from 1.6 to 2.0, where: the refractivity of the transparent electrode layer 160C is larger than the refractivity of the n-type semiconductor layer 150C; and the refractivity of the surface transparent electrode layer 170C is smaller than the refractivity of the transparent electrode layer 160C, so that reflection of the external light before reaching to the light absorption layer 130C can be restrained and the light incident on the transparent electrode layer 160C with large refractivity is effectively reflected thereinside, thereby enhancing light containment effect. Thus, a photovoltaic element with high photoelectric conversion efficiency can be obtained (advantage 4-1).

Further, since the n-type semiconductor layer 150C, the transparent electrode layer 160C and the surface transparent electrode layer 170C are provided by the same layer material (IZO) as primary components and the same DC sputtering apparatus under the above described predetermined temperature and oxygen partial pressure conditions, the layer structure exhibiting the above-described refractivity and layer thickness relationship can be provided without exchanging the layer material or switching the manufacturing apparatuses. Thus, a photovoltaic element with high photoelectric conversion efficiency can be obtained at a high production efficiency (advantage 4-2).

The n-type semiconductor layer 150C is formed in a high resistance by a sputtering under a predetermined oxygen partial pressure, i.e. by a sputtering using the mixture gas of Ar and $O_2$ at a predetermined oxygen partial pressure under at least one of the conditions of: oxygen partial pressure $pO_2$ being in a range from $1 \times 10^{-2}$ to 0.2 Pa; and substrate temperature in a range from 100 to 200 degrees Celsius so that the n-type semiconductor layer 150C is made as an amorphous film.

Accordingly, a layer that avoids the decrease in the open end voltage can be easily obtained in the same manner as the advantage 1-5 in the first exemplary embodiment.

Further, in this exemplary embodiment, the advantage 1-4 in the first exemplary embodiment can be obtained as well as the above advantages.

Examples of the Fourth Exemplary Embodiment

Next, specific explanation of the present exemplary embodiment will be given below with reference to Examples. In the following Examples and Comparative Examples, the photovoltaic elements were manufactured under respective manufacturing conditions and the elements were evaluated. It should be understood that the scope of the present exemplary embodiment is by no means limited to the contents covered by the examples.

Measurement of Thickness

The thicknesses of the n-type semiconductor layer, the transparent electrode layer and the surface transparent electrode layer in the photovoltaic elements in the respective Examples were measured according to a stylus method (used instrument: : DEKTAK3030 from SLOAN TECHNOLOGY) after providing a step portion for the thickness measurement.

Measurement of Refractivity

The refractivities of the n-type semiconductor layer, the transparent electrode layer and the surface transparent electrode layer in the photovoltaic elements in the respective Examples were measured according to a spectroscopic ellipsometry (used instrument: DVA-36L manufactured by Mizojiri Optical Co., Ltd.) after providing each one of the layers on a glass substrate.

Measurement of Sheet Resistance

The sheet resistances of the n-type semiconductor layer, the transparent electrode layer and the surface transparent electrode layer in the photovoltaic elements in the respective Examples were measured according to a four-stylus method (used instrument: LORESTA-FP from Mitsubishi Petrochemical Co., Ltd) after providing each one of the layers on a glass substrate.

Measurement of Incident Photoelectric Conversion Efficiency

The photoelectric conversion efficiency of the photovoltaic element manufactured in the respective Examples was calculated by: providing an anode by the transparent electrode layer or the surface transparent electrode layer and a cathode by Mo; forming an extraction electrode of 30 $\mu$m and 0.5 $\mu$m thick on IZO layer and Mo layer by a screen printing using an Ag paste; and evaluating an open voltage (Voc), short-circuit current density (Isc) and a fill factor (FF). Incidentally, a light from a xenon lamp that was adjusted by a predetermined optical filter (solar simulation) was used as a light source.

Evaluation of Each One of Layers of Photovoltaic Element

In the Examples 4-1 to 4-12 or in the Comparative Examples 4-1 to 4-2, each one of the layers of the photovoltaic element was formed in a thin film on a glass substrate or on InS layer formed on the glass substrate and the sheet resistance Rs and refractivity of each of the layers were evaluated. The results are shown in Table 12.
Incidentally, the respective layers of the n-type semiconductor layer, the transparent electrode layer and the surface transparent electrode layer were formed by DC magnetron sputtering on the glass substrate or on a buffer layer formed by a solution growth of InS by CBD (Chemical Bath Deposition) on the glass substrate.
Further, in the Examples 4-1 to 4-10 or in the Comparative Examples 4-1 to 4-2, IZO ($In_2O_3$ + ZnO) was used as the target material. In the Examples 4-11 to 4-12, the target material was provided by IZO containing a predetermined concentration of sulfur (S).
Table 12

| | Layer*1 | Substrate | Target In$_2$O$_3$: ZnO (mass%) | Film-Forming Condition | | | | Single-Layer Evaluation | | Analysis |
|---|---|---|---|---|---|---|---|---|---|---|
| | | | | Film-Forming Method *3 | Substrate Temperature (˚C) | Oxygen Partial Pressure pO2 (Pa) | Thickness (nm) | Rs (Ω/□) | Refractivity (550nm) | Element Analysis *2 Sulfur Concentration |
| Example 4-1 | n-layer | glass substrate | 90:10 | DC | R. T. | 0.100 | 100 | 380000 | 1.8 | - |
| Example 4-2 | n-layer | glass substrate | 90:10 | DC | R. T. | 0.050 | 100 | 400000 | 1.8 | - |
| Example 4-3 | n-layer | glass substrate | 90:10 | DC | R. T. | 0.030 | 100 | 4000 | 1.9 | - |
| Example 4-4 | TCO | glass substrate | 90:10 | DC | R. T. | 0.010 | 200 | 16 | 2.0 | - |
| Example 4-5 | TCO | glass substrate | 90:10 | DC | R. T. | 0.010 | 300 | 10 | 2.0 | - |
| Example 4-6 | Sur. TCO | glass substrate | 90:10 | DC | 200˚C | 0.010 | 100 | 35 | 1.8 | - |
| Example 4-7 | Sur. TCO | glass substrate | 90:10 | DC | 200˚C | 0.010 | 200 | 15 | 1.8 | - |
| Example 4-8 | Sur. TCO | glass substrate | 90:10 | DC | 200˚C | 0.010 | 300 | 9 | 1.8 | - |
| Example 4-9 | n-layer | glass substrate /InS | 90:10 | DC | 1 00˚C | 0.005 | 100 | 8000 | - | CIMS (S:50ppm) |
| Example 4-10 | n-layer | glass substrate /InS | 90:10 | DC | 200˚C | 0.005 | 100 | 200000 | - | CIMS (S:120ppm) |
| Example 4-11 | n-layer | glass substrate | 90:10 (S: 50ppm) | DC | 1 00˚C | 0.005 | 100 | 7000 | 1.8 | - |
| Example 4-12 | n-layer | glass substrate | 90:10 (S: 120ppm) | DC | 200˚C | 0.005 | 100 | 190000 | 1.8 | - |

(continued)

| | Layer*1 | Substrate | Target In$_2$O$_3$: ZnO (mass%) | Film-Forming Condition | | | | Single-Layer Evaluation | | Analysis |
| | | | | Film-Forming Method *3 | Substrate Temperature (˚C) | Oxygen Partial Pressure pO2 (Pa) | Thickness (nm) | Rs (Ω/□) | Refractivity (550nm) | Element Analysis *2 Sulfur Concentration |
|---|---|---|---|---|---|---|---|---|---|---|
| Comp. Example 4-1 | n-layer | glass substrate | 90:10 | DC | R. T. | 0.010 | 100 | 40 | 2.0 | - |
| Comp. Example 4-2 | n-layer | glass substrate /InS | 90:10 | DC | R. T. | 0.005 | 100 | 45 | | CIMS (S:<10ppm) |

* 1 n-layer: n-type semiconductor layer, TCO: transparent electrode layer, Sur. TCO: surface transparent electrode layer
*2 CIMS: Sulfur concentration in respective single layer was measured by chemical ionization mass spectrometry.
* 3 DC: DC magnetron sputtering

Evaluation of Each One of Layers of Photovoltaic Element

When the Examples 4-1 to 4-3 of the n-type semiconductor layer and the Examples 4-4 and 4-5 of the transparent electrode layer were compared, by setting the oxygen partial pressure to be low, the sheet resistance became low and the refractivity became high.
Further, by raising the substrate temperature as in the Examples 4-6 to 4-8 as compared with the conditions in the Examples 4-4 and 4-5, the refractivity became smaller while keeping the sheet resistance low.
Further, as can be understood by comparing the Examples 4-9 and 4-10 and the Comparative Example 4-2, when the n-type semiconductor layer was formed on the buffer layer (InS), the sulfur concentration in the n-type semiconductor layer was increased in accordance with increase in the substrate temperature, so that the sheet resistance became high.
Further, the comparison between the Examples 4-11 and 4-12 revealed that higher sulfur concentration in the target material increases the sheet resistance.

Evaluation of Photovoltaic Element

In the following Examples 4-13 to 4-23 and Comparative Examples 4-3 to 4-9, the photovoltaic elements were manufactured and the performance of the elements was evaluated. The results are shown in Tables 13 to 15.
Incidentally, the common element substrate was used in the above Examples and Comparative Examples. In order to provide the element substrate, a backside electrode layer composed of Mo was initially formed on the glass substrate by a DC magnetron sputtering.
Next, the CIGS light absorption layer formed of Cu, In, Ga and Se (evaporation source) was formed by coevaporation on the backside electrode layer.
Subsequently, a buffer layer was formed on the light absorption layer by solution growth of InS by CBD (chemical bath deposition) on the light absorption layer.
Then, the n-type semiconductor layer, the transparent electrode layer and the surface transparent electrode layer were formed on the buffer layer by DC magnetron sputtering or radio-frequency (RF) magnetron sputtering by the below-described various sputterings.

- **-**  Sputtering Target

      (i) IZO (In$_2$O$_3$:ZnO=90mass%:10mass%)
      (ii) ZnO
      (iii) AZO(Al$_2$O$_3$:ZnO=2mass%:98mass%)
      (iv) ITO(In$_2$O$_3$:SnO$_2$=90mass%:10mass%)

Table 13

| | Layer*1 | Substrate*2 | Target*3 (mass%) | Film-Forming Condition | | | | Single-Layer Evaluation | | Element Evaluation*5 | | | |
|---|---|---|---|---|---|---|---|---|---|---|---|---|---|
| | | | | Film-Forming Method *4 | Substrate Temperature (˚C) | Oxygen Partial Pressure pO2 (Pa) | Thickness (nm) | Rs ($\Omega/\square$) | Refractivity (550nm) | Voc (mV) | Isc (mA/cm$^2$) | FF/Pin | Conversion Efficiency (%) |
| Example 4-13 | n-layer | element substrate | IZO | DC | R. T. | 0.050 | 100 | 400000 | 1.8 | 620 | 39 | 0.67 | 16.0 |
| | TCO | | IZO | DC | R. T. | 0.010 | 300 | 10 | 2.0 | | | | |
| Example 4-14 | n-layer | element substrate | IZO | DC | 200 | 0.005 | 100 | 200000 | 1.8 | 630 | 38 | 0.67 | 16.0 |
| | TCO | | IZO | DC | R. T. | 0.010 | 300 | 10 | 2.0 | | | | |
| Example 4-15 | n-layer | element substrate | IZO | DC | R. T. | 0.050 | 100 | 400000 | 1.8 | 670 | 41 | 0.67 | 18.0 |
| | TCO | | IZO | DC | R. T. | 0.010 | 200 | - | 2.0 | | | | |
| | Sur. TCO | | IZO | DC | 200 | 0.010 | 100 | 9 | 1.8 | | | | |
| Example 4-16 | n-layer | element substrate | IZO | DC | R. T. | 0.200 | 100 | 400000 | 1.6 | 620 | 39 | 0.67 | 16.2 |
| | TCO | | IZO | DC | R. T. | 0.001 | 200 | 15 | 2.1 | | | | |
| | Sur. TCO | | IZO | DC | 200 | 0.001 | 100 | | 2.0 | | | | |

| | Layer*1 | Substrate*2 | Target*3 (mass%) | Film-Forming Condition | | | | Single-Layer Evaluation | | Element Evaluation*5 | | | |
| | | | | Film-Forming Method *4 | Substrate Temperature (°C) | Oxygen Partial Pressure pO2 (Pa) | Thickness (nm) | Rs ($\Omega/\square$) | Refractivity (550nm) | Voc (mV) | Isc (mA/cm$^2$) | FF/Pin | Conversion Efficiency (%) |
|---|---|---|---|---|---|---|---|---|---|---|---|---|---|
| Example 4-17 | n-layer | element substrate | IZO | DC | R. T. | 0.010 | 100 | 100000 | 1.8 | 630 | 38 | 0.67 | 16.0 |
| | TCO | | IZO | DC | R. T. | 0.001 | 200 | 15 | 2.1 | | | | |
| | Sur. TCO | | IZO | DC | 200 | 0.001 | 100 | | 2.0 | | | | |

\* 1 n-layer: n-type semiconductor layer, TCO: transparent electrode layer, Sur. TCO: surface transparent electrode layer
*2 Used element substrate: glass/Mo (0.1 $\mu$m)/CIGS(1$\mu$m)/Ins(0.1 $\mu$)
     Element Substrate Size: 10 cm × 10 cm
     Film-Forming Method: Mo (DC sputtering), CIGS (coevaporation), Ins (CBD method)
*3 (i) IZO (In$_2$O$_3$:ZnO=90mass%:10mass%)
     (ii)ZnO, (iii)AZO(Al$_2$O$_3$:ZnO=2mass%:98mass%)
     (iv) ITO(In$_2$O$_3$:SnO$_2$=90mass%: 10mass%)
\* 4 DC: DC magnetron sputtering, RF: radio-frequency magnetron sputtering
*5 Voc: Open voltage, Isc: short-circuit current density, Pin: standard incident power
     FF: fill factor

Table 14

| | Layer*1 | Substrate*2 | Target*3 (mass%) | Film-Forming Condition | | | | Single-Layer Evaluation | | Element Evaluation*5 | | | |
|---|---|---|---|---|---|---|---|---|---|---|---|---|---|
| | | | | Film-Forming Method *4 | Substrate Temperature (˚C) | Oxygen Partial Pressure pO2 (Pa) | Thickness (nm) | Rs ($\Omega/\square$) | Refractivity (550nm) | Voc (mV) | Isc (mAlcm$_2$) | FF/Pin | Conversion Efficiency (%) |
| Example 4-18 | n-layer | element substrate | IZD | DC | 100 | 0.009 | 100 | 1 00000 | 1.9 | 670 | 41 | 0.67 | 18.4 |
| | TCO | | IZO | DC | R. T. | 0.001 | 200 | 15 | 2.1 | | | | |
| | Sur. TCO | | IZO | DC | 200 | 0.001 | 100 | - | 2.0 | | | | |
| Example 4-1 | n-layer | element substrate | IZO | DC | 200 | 0.008 | 00 | 1 00000 | 2.0 | 625 | 38 | 0.67 | 15.9 |
| | TCO | | IZO | DC | R. T. | 0.001 | 200 | 15 | 2.1 | | | | |
| | Sur. TCO | | IZO | DC | 200 | 0.001 | 100 | | 2.0 | | | | |
| Examples 4-20 | n-layer | element substrate | IZO | DC | 100 | 0.01 | 100 | 1 00000 | 1.8 | 630 | 38 | 0.67 | 1 6.0 |
| | TCO | | IZO | DC | R. T. | 0.001 | 200 | 15 | 2.1 | | | | |
| | Sur. TCO | | IZO | DC | 200 | 0.001 | 100 | | 2.0 | | | | |
| Examples 4-21 | n-layer | element substrate | IZO | DC | 200 | 0.010 | 100 | 100000 | 1.8 | 640 | 36 | 0.67 | 15.4 |
| | CO | | IZO | DC | R. T. | 0.001 | 200 | 15 | 2.1 | | | | |
| | Sur. TCO | | IZO | DC | 200 | 0.001 | 100 | | 2.0 | | | | |

(continued)

| | Layer*1 | Substrate*2 | Target*3 (mass%) | Film-Forming Condition | | | | Single-Layer Evaluation | | Element Evaluation*5 | | | |
|---|---|---|---|---|---|---|---|---|---|---|---|---|---|
| | | | | Film-Forming Method *4 | Substrate Temperature (˚C) | Oxygen Partial Pressure pO2 (Pa) | Thickness (nm) | Rs (Ω/□) | Refractivity (550nm) | Voc (mV) | Isc (mAlcm$_2$) | FF/Pin | Conversion Efficiency (%) |
| Example 4-22 | n-layer | element substrate*6 | IZO | DC | R. T. | 0.200 | 100 | 400000 | 1.6 | 635 | 33 | 0.67 | 14.0 |
| | TCO | | IZO | DC | 200 | 0.01 | 200 | 15 | 1.8 | | | | |
| | Sur. TCO | | IZO | DC | 200 | 0.004 | 100 | | 1.6 | | | | |
| Example 4-23 | n-layer | element substrate*6 | IZO | DC | R. T. | 0.200 | 100 | 400000 | 1.6 | 625 | 33 | 0.67 | 13.8 |
| | TCO | | IZO | DC | 100 | 0.001 | 200 | 15 | 2.3 | | | | |
| | Sur. TCO | | IZO | DC | 200 | 0.004 | 100 | | 1.8 | | | | |

* 1 n-layer: n-type semiconductor layer, TCO: transparent electrode layer, Sur. TCO: surface transparent electrode layer
*2 Used element substrate: glass/Mo (0.1 $\mu$,m)/CIGS(1 $\mu$m)/Ins(0.1 $\mu$m)
    Element Substrate Size: 10 cm $\times$ 10 cm
    Film-Forming Method: Mo (DC sputtering), CIGS (coevaporation), Ins (CBD method)
*3 (i) IZO (In$_2$O$_3$:ZnO=90mass%:10mass%)
    (ii)ZnO, (iii)AZO(Al$_2$O$_3$:ZnO=2mass%:98mass%)
    (iv) ITO(In$_2$O$_3$:SnO$_2$=90mass%:10mass%)
* 4 DC: DC magnetron sputtering, RF: radio-frequency magnetron sputtering
*5 Voc: Open voltage, Isc: short-circuit current density, Pin: standard incident power
    FF: fill factor
* 6 Refractivity of InS of the element substrate used in the Examples 4-22 and 4-23 was 1.7.

Table 15

| | Layer*1 | Substrate*2 | Target*3 (mass%) | Film-Forming Condition | | | | Single-Layer Evaluation | | Element Evaluation | | | |
|---|---|---|---|---|---|---|---|---|---|---|---|---|---|
| | | | | Film-Forming Method *4 | Substrate Temperature (˚C) | Oxygen Partial Pressure pO2 (Pa) | Thickness (nm) | Rs (Ω/□) | Refractivity (550nm) | Voc (mV) | Isc (mA/cm$^2$) | FF/Pin | Conversion Efficiency (%) |
| Comp. Example 4-3 | n-layer | element substrate | IZO | DC | R.T. | 0.005 | 100 | 40 | 2.0 | 630 | 30 | 0.67 | 13.0 |
| | TCO | | IZO | DC | R.T. | 0.010 | 300 | 10 | 2.0 | | | | |
| Comp. Example 4-4 | n-layer | element substrate | IZO | DC | R.T. | 0.050 | 100 | 400000 | 1.8 | 620 | 32 | 0.67 | 13.0 |
| | TCO | | IZO | DC | 200 | 0.010 | 200 | | 1.8 | | | | |
| | Sur. TCO | | IZO | DC | 200 | 0.010 | 100 | 10 | 1.8 | | | | |
| Comp. Example 4-5 | n-layer | element substrate | IZO | RF | 200 | 0.005 | 100 | 400000 | 1.5 | 590 | 26 | 0.67 | 10.0 |
| | TCO | | IZO | DC | 200 | 0.010 | 300 | 40 | 1.7 | | | | |
| Comp. Example 4-6 | n-layer | element substrate | IZO | DC | R.T. | 0.050 | 100 | 400000 | 1.8 | 570 | 27 | 0.67 | 10.0 |
| | TCO | | IZO | DC | 200 | 0.010 | 200 | | 1.7 | | | | |
| | Sur. TCO | | IZO | DC | 200 | 0.010 | 100 | 25 | 1.8 | | | | |
| comp Example 4-7 | n-layer | element substrate | IZO | DC | R.T. | 0.050 | 100 | 400000 | 1.8 | 580 | 29 | 0.67 | 11.0 |
| | TCO | | IZO | DC | 200 | 0.010 | 200 | | 1.8 | | | | |
| | Sur. TCO | | IZO | DC | 200 | 0.010 | 100 | 10 | 1.8 | | | | |

(continued)

| | Layer*1 | Substrate*2 | Target*3 (mass%) | Film-Forming Condition | | | | Single-Layer Evaluation | | Element Evaluation | | | |
|---|---|---|---|---|---|---|---|---|---|---|---|---|---|
| | | | | Film-Forming Method *4 | Substrate Temperature (˚C) | Oxygen Partial Pressure pO2 (Pa) | Thickness (nm) | Rs (Ω/□) | Refractivity (550nm) | Voc (mV) | Isc (mA/cm²) | FF/Pin | Conversion Efficiency (%) |
| Comp. Example 4-8 | n-layer | element substrate | IZO | DC | R.T. | 0.200 | 100 | 400000 | 1.6 | 530 | 29 | 0.67 | 10.3 |
| | TCO | | IZO | DC | R.T. | 0.060 | 200 | 15 | 2.4 | | | | |
| | Sur. TCO | | IZO | DC | 200 | 0.001 | 100 | | 2.0 | | | | |
| Comp. Example 4-9 | n-layer | element substrate | IZO | DC | R.T. | 0.200 | 100 | 400000 | 1.6 | 535 | 28 | 0.67 | 10.0 |
| | TCO | | IZO | DC | 250 | 0.060 | 200 | 15 | 2.4 | | | | |
| | Sur TCO | | IZO | DC | 200 | 0.001 | 100 | | 2.0 | | | | |

* 1 n-layer: n-type semiconductor layer, TCO: transparent electrode layer, Sur. TCO: surface transparent electrode layer
*2 Used element substrate: glass/Mo (0.1 μm)/CIGS(1 μm)/Ins(0.1 μm)
　　Element Substrate Size: 10 cm × 10 cm
　　Film-Forming Method: Mo (DC sputtering), CIGS (coevaporation), Ins (CBD method)
*3 (i) IZO (In$_2$O$_3$:ZnO=90mass%:10mass%)
　　(ii)ZnO, (iii)AZO(AlO$_3$:ZnO=2mass% :98mass%)
　　(iv) ITO(In$_2$O$_3$:SnO$_2$=90mass%: 10mass%)
*4 DC: DC magnetron sputtering, RF: radio-frequency magnetron sputtering
*5 Voc: Open voltage, Isc: short-circuit current density, Pin: standard incident power
　　FF: fill factor

EP 2 360 733 A1

82

Evaluation of Photovoltaic Element

In the Example 4-13 or the Example 4-14, the n-type semiconductor layer and the transparent electrode layer were formed by IZO, where the refractivity of the transparent electrode layer was set larger than that of the n-type semiconductor layer. Though the Comparative Example 4-3 used the same target material as the above, the refractivities of the both layers were the same. As a result, the Examples 4-13 and the Example 4-14 exhibited an excellent conversion efficiency.

In the Example 4-15 to the Example 4-21, the surface transparent electrode layer was also formed by IZO as compared with the Example 4-13, where the refractivity of the surface transparent electrode layer was set smaller than that of the transparent electrode layer. As a result, the Examples 4-15 and the Example 4-18 exhibited remarkably excellent conversion efficiency as compared with the Example 4-13.

In contrast, in the Comparative Examples 4-4 and 4-7, though all of the n-type semiconductor layer, the transparent electrode layer and the surface transparent electrode layer were provided by IZO, since the refractivities of the three layers were not the same, no improvement in the conversion efficiency as those of the Examples 4-15 and 4-18 was not exhibited.

Further, in the Comparative Examples 4-8 to 4-9, though the relationship in the refractivities was the same as that in the Examples 4-15 to 4-23, since the refractivity of the transparent electrode layer was as excessively large as 2.4, the conversion efficiency was lower than those in the Examples 4-15 to 4-23.

The respective examples of the above-described photovoltaic element can be manufactured by the same manufacturing apparatus, so that it is not necessary to transfer the substrates to the other manufacturing apparatus, thus providing excellent production efficiency.

For manufacturing a photovoltaic element, the Comparative Example 4-5 employed typical layer structure while using different film-forming process and target material. The Comparative Example 4-5 showed low conversion efficiency and required considerable time for transferring the substrate, thereby lowering the production efficiency.

In the Comparative Example 4-6 and 4-7, the photovoltaic element was manufactured by using the same manufacturing apparatus while altering the target material of the transparent electrode layer to AZO or ITO respectively. In the Comparative Example 4-6, the refractivity of the transparent electrode layer is set lower than the refractivity of the n-type semiconductor layer and the surface transparent electrode layer. In the Comparative Example 4-7, all of the three layers exhibited the same refractivity. Both of the Comparative Examples 4-6 and 4-7 showed a conversion efficiency lower than those in the Examples 4-15 to 4-21.

As described above, in the photovoltaic elements in Examples 4-15 to 4-23 in which the refractivity of the transparent electrode layer was larger than those of the n-type semiconductor layer and the refractivity of the surface transparent electrode layer was smaller than those of the transparent electrode layer, the refraction of light at the surface transparent electrode layer could be restrained to the minimum, so that the light incident on the transparent electrode layer was effectively reflected thereinside, thus enhancing light containment effect and exhibiting improved conversion efficiency. Further, since the layers could be manufactured by the same manufacturing apparatus, the production efficiency could also be improved.

Modifications of Embodiment

Incidentally, it should be understood that: the above embodiments only present an aspect of the invention and the scope of the present invention is not limited to the above-described exemplary embodiments; and modifications and improvements are also included in the scope of the invention as long as the modifications and improvements are compatible with the invention. Further, the specific arrangements and configurations for implementing the invention may be altered in any manner as long as the modifications and improvements are compatible with the invention.

Specifically, though the light absorption layer 130 of the photovoltaic element of the invention is provided by so-called CIGS material, the light absorption layer 130 may alternatively be provided by chalcopyrite-structure compound such as CIS.

Further, though the n-type semiconductor layer 150 is exemplarily provided in the embodiment, the n-type semiconductor layer 150 may not be provided. Similarly, the surface transparent electrode layer 170 also may not be provided.

Further, though the first scribing and the second scribing are conducted for providing the dividing groove 121, the first process groove 131 and the second process groove 171, the film may be divided in advance by the dividing groove 121, the first process groove 131 and the second process groove 171 by printing or by providing a mask.

Though the n-type semiconductor layer 150, the transparent electrode layer 160 and the surface transparent electrode layer 170 are provided by the same material in the exemplary embodiments, these layers may not be provided by the same material.

Further, the refractivity can be appropriately set in accordance with the formation condition of the n-type semiconductor layer 150, the transparent electrode layer 160 and the surface transparent electrode layer 170. It should be understood that the layers are preferably arranged so as to efficiently receive the light and to reflect and confine the light in the layers. Further, the work function may be suitably set in accordance with the energy band of the light absorption layer 130.

The other specific arrangements and configurations for implementing the invention may be altered in any manner as long as the modifications and improvements are compatible with the invention.

Industrial Applicability

The present invention is applicable to a photovoltaic element that has a p-type light absorption layer that is formed of a conductive chalcopyrite-structure compound into a thin layer.

Explanation of Codes

| | |
|---|---|
| 100, 100A, 100B, 100C | photovoltaic element |
| 110 | glass substrate |
| 120, 120C | backside electrode layer |
| 121 | dividing groove |
| 130, 130B, 130C | light absorption layer |
| 131 | first process groove |
| 140, 140B, 140C | buffer layer |
| 150, 150A, 150B, 150C | n-type semiconductor layer |
| 160, 160A, 1608, 160C | transparent electrode layer |
| 170, 170A, 170B, 170C | surface transparent electrode layer |
| 171 | second process groove |

**Claims**

1. A photovoltaic element, comprising:

   a glass substrate;
   a pair of backside electrode layers provided on a side of the glass substrate;
   a p-type conductive light absorption layer that is layered to bridge the pair of backside electrode layer, the light absorption layer being provided by a chalcopyrite-structure compound;
   a light-transmissive n-type buffer layer that is layered on the light absorption layer and forms a p-n junction with the light absorption layer; and
   a light-transmissive transparent electrode layer that is layered on the buffer layer to extend from a side of the layered light absorption layer and buffer layer to one of the pair of backside electrode layers, wherein
   the transparent electrode layer has a film stress of $\pm 1 \times 10^9$ Pa or less.

2. The photovoltaic element according to claim 1, wherein
   the transparent electrode layer is provided by indium oxide and zinc oxide as primary components, the transparent electrode layer being formed into an amorphous layer having a grain size of 0.001 μm or less measured by observing a surface thereof by an atomic force microscope.

3. A photovoltaic element, comprising:

   a glass substrate;
   a backside electrode layer provided on a side of the glass substrate;
   a p-type conductive light absorption layer that is layered on the backside electrode layer, the light absorption layer being provided by a chalcopyrite-structure compound;
   a light-transmissive n-type buffer layer that is layered on the light absorption layer and forms a p-n junction with the light absorption layer;
   a light-transmissive n-type semiconductor layer that is layered on the buffer layer and exhibits a higher resistance than the buffer layer, the n-type semiconductor layer being n-type against the light absorption layer; and
   a light-transmissive transparent electrode layer that is layered on the n-type semiconductor layer to extend from a side of the layered light absorption layer, the buffer layer and the n-type semiconductor layer toward the backside electrode layer, wherein
the n-type semiconductor layer and the transparent electrode layer are provided by indium oxide and zinc oxide as primary components, a difference in a work function of the n-type semiconductor layer and a work function of the transparent electrode layer is less than 0.3 eV, and a difference in an energy band gap of the n-type semiconductor layer and an energy band gap of the transparent electrode layer is less than 0.2 eV.

4. The photovoltaic element according to claim 1, wherein
the transparent electrode layer is formed in an amorphous film containing indium oxide and zinc oxide as primary components.

5. The photovoltaic element according to any one of claims 1 to 4, wherein
the transparent electrode layer is formed by a sputtering using a mixture gas of argon and oxygen under at least one of conditions of: oxygen partial pressure of the mixture gas being in a range from $1 \times 10^{-3}$ to $5 \times 10^{-2}$ Pa; and a substrate temperature in a range from 100 to 200 degrees Celsius, so that the transparent electrode layer is formed in an amorphous film.

6. The photovoltaic element according to any one of claims 1 to 5, wherein
the transparent electrode layer contains $In_2O_3$ and ZnO that are contained at a ratio of $In_2O_3/(In_2O_3+ZnO)$ being in a range from 50 to 95 mass%.

7. The photovoltaic element according to any one of claims 1 to 6, wherein
the transparent electrode layer contains a third component in addition to indium oxide and zinc oxide as primary components, the third component being contained in 20 mass% or less.

8. The photovoltaic element according to any one of claims 1 to 7, further comprising:

a light-transmissive n-type semiconductor layer that is layered on the buffer layer and exhibits a higher resistance than the buffer layer, the n-type semiconductor layer being n-type against the light absorption layer.

9. The photovoltaic element according to claim 8, wherein
the n-type semiconductor layer is formed by a sputtering using a mixture gas of argon and oxygen under at least one of conditions of: oxygen partial pressure of the mixture gas being in a range from $1 \times 10^{-2}$ to 0.2 Pa; and a substrate temperature in a range from 100 to 200 degrees Celsius, so that the n-type semiconductor layer is formed in a high-resistance amorphous film.

10. The photovoltaic element according to claim 8, wherein
the n-type semiconductor layer is formed into an amorphous layer having a grain size of 0.001 $\mu$m or less measured by observing a surface thereof by an atomic force microscope.

11. The photovoltaic element according to any one of claims 8 to 10, wherein
the n-type semiconductor layer is provided by the same material as the transparent electrode layer.

12. The photovoltaic element according to any one of claims 8 to 11, wherein
the n-type semiconductor layer has a film stress of $\pm\, 1 \times 10^9$ Pa or less.

13. The photovoltaic element according to any one of claims 8 to 11, wherein
the n-type semiconductor layer is formed by a sputtering using a mixture gas of argon and oxygen under at least one of conditions of: oxygen partial pressure of the mixture gas being in a range from $1 \times 10^{-2}$ to 0.2 Pa; and a substrate temperature in a range from 100 to 200 degrees Celsius, so that the n-type semiconductor layer is formed in an amorphous film.

14. The photovoltaic element according to any one of claims 1 to 13, further comprising:

a conductive and light-transmissive surface transparent electrode layer that is layered on the transparent electrode, the surface transparent electrode layer having a refractivity smaller than a refractivity of the transparent electrode layer.

15. The photovoltaic element according to claim 14, wherein

EP 2 360 733 A1

the surface transparent electrode layer is formed by a sputtering using a mixture gas of argon and oxygen under at least one of conditions of: oxygen partial pressure of the mixture gas being in a range from $1 \times 10^{-3}$ to $5 \times 10^{-2}$ Pa; and a substrate temperature in a range from 100 to 200 degrees Celsius, so that the transparent electrode layer is formed in an amorphous film.

16. The photovoltaic element according to claim 14 or 15, wherein
the surface transparent electrode layer is provided by the same material as the transparent electrode layer.

17. The photovoltaic element according to any one of claims 14 to 16, wherein
the surface transparent electrode layer has a film stress of $\pm 1 \times 10^9$ Pa or less.

18. A photovoltaic element, comprising:

a glass substrate;
a backside electrode layer provided on a side of the glass substrate;
a p-type conductive light absorption layer that is layered on the backside electrode layer, the light absorption layer being provided by a chalcopyrite-structure compound;
a light-transmissive n-type buffer layer that is layered on the light absorption layer;
a light-transmissive n-type semiconductor layer that is layered on the buffer layer and exhibits a higher resistance than the buffer layer, the n-type semiconductor layer being n-type against the light absorption layer;
a transparent electrode layer that is layered on the n-type semiconductor layer; and
a surface transparent electrode layer that is layered on the transparent electrode layer, wherein
the n-type semiconductor layer, the transparent electrode layer and the surface transparent electrode layer are provided by the same amorphous film-forming material,
a refractivity of the transparent electrode layer is larger than a refractivity of the n-type semiconductor layer, and
a refractivity of the surface transparent electrode layer is smaller than the refractivity of the transparent electrode layer.

19. The photovoltaic element according to claim 18, wherein
the refractivity of the n-type semiconductor layer is in a range from 1.6 to 2.0, the refractivity of the transparent electrode layer is in a range from 1.8 to 2.3, and the refractivity of the surface transparent electrode layer is in a range from 1.6 to 2.0.

20. The photovoltaic element according to claim 18 or 19, wherein
the film-forming material is an oxide of at least one of elements selected from the group consisting of indium (In), zinc (Zn), tin (Sn), aluminum (Al), gallium (Ga), tungsten (W), cerium (Ce) and titanium (Ti).

21. A manufacturing method of a photovoltaic element, comprising:

a backside-electrode-layer forming step for thinly forming a backside electrode layer on a glass substrate;
a light-absorption-layer forming step for thinly forming a p-type light absorption layer on the backside electrode layer, the light absorption layer being provided by a chalcopyrite-structure compound;
a buffer-layer forming step for thinly forming an n-type buffer layer on the light absorption layer, the buffer layer forming a p-n junction with the light absorption layer; and
a transparent electrode-layer forming step for forming a transparent electrode layer on the buffer layer, wherein in the transparent electrode-layer forming step, the transparent electrode layer is thinly formed to exhibit a film stress of $\pm 1 \times 10^9$ Pa or less.

22. The manufacturing method of a photovoltaic element according to claim 21, wherein
in the transparent electrode-layer forming step, the transparent electrode layer is provided by indium oxide and zinc oxide as primary components, the transparent electrode layer being formed into an amorphous layer having grain size of 0.001 $\mu$m or less measured by observing a surface thereof by an atomic force microscope.

23. A manufacturing method of a photovoltaic element, comprising:

a backside-electrode-layer forming step for thinly forming a backside electrode layer on a glass substrate;
a light-absorption-layer forming step for thinly forming a p-type light absorption layer on the backside electrode layer, the light absorption layer being provided by a chalcopyrite-structure compound;

a buffer-layer forming step for thinly forming an n-type buffer layer on the light absorption layer, the buffer layer forming a p-n junction with the light absorption layer;

a transparent electrode-layer forming step for forming a transparent electrode layer on the buffer layer; and

a first scribing step for, after forming the buffer layer in the buffer-layer forming step, scribing the light absorption layer and the buffer layer that are layered on the backside electrode layer to provide a predetermined insulation distance therebetween to expose the backside electrode layer, wherein

in the transparent electrode-layer forming step, the transparent electrode layer that is layered on the buffer layer in an amorphous film by indium oxide and zinc oxide as primary components, the transparent electrode layer reaching to the backside electrode layer exposed in the first scribing step, and

after the transparent electrode layer is formed in the transparent electrode-layer forming step, a second scribing step in which the transparent electrode layer is subjected to a mechanical scribing at a predetermined insulation distance therebetween to provide a series connection of the photovoltaic element is performed.

24. A manufacturing method of a photovoltaic element, comprising:

a backside-electrode-layer forming step for thinly forming a backside electrode layer on a glass substrate;

a light-absorption-layer forming step for thinly forming a p-type light absorption layer on the backside electrode layer, the light absorption layer being provided by a chalcopyrite-structure compound;

a buffer-layer forming step for thinly forming an n-type buffer layer on the light absorption layer, the buffer layer forming a p-n junction with the light absorption layer;

an n-type semiconductor-layer forming step for thinly forming a light-transmissive n-type semiconductor layer that exhibits a higher resistance than the buffer layer and is n-type against the light absorption layer; and

a transparent electrode-layer forming step for forming a transparent electrode layer on the n-type semiconductor layer, wherein

in the n-type semiconductor-layer forming step and the transparent electrode-layer forming step, the n-type semiconductor layer and the transparent electrode layer are thinly provided by indium oxide and zinc oxide as primary components so that a difference in a work function of the n-type semiconductor layer and a work function of the transparent electrode layer is less than 0.3 eV, and a difference in an energy band gap of the n-type semiconductor layer and an energy band gap of the transparent electrode layer is less than 0.2 eV.

25. A manufacturing method of a photovoltaic element, comprising:

a backside-electrode-layer forming step for thinly forming a backside electrode layer on a glass substrate;

a light-absorption-layer forming step for thinly forming a p-type light absorption layer on the backside electrode layer, the light absorption layer being provided by a chalcopyrite-structure compound;

a buffer-layer forming step for thinly forming a light-transmissive n-type buffer layer on the light absorption layer;

an n-type semiconductor-layer forming step for thinly forming a light-transmissive n-type semiconductor layer that exhibits a higher resistance than the buffer layer and is n-type against the light absorption layer;

a transparent electrode-layer forming step for forming a transparent electrode layer on the n-type semiconductor layer; and

a surface-transparent electrode-layer forming step for forming a surface transparent electrode layer on the transparent electrode layer, wherein

the n-type semiconductor layer, the transparent electrode layer and the surface transparent electrode layer are provided by the same amorphous material,

a refractivity of the transparent electrode layer is larger than a refractivity of the buffer layer, and

a refractivity of the surface transparent electrode layer is smaller than the refractivity of the buffer layer, and

the n-type semiconductor-layer forming step, the transparent electrode-layer forming step and the surface-transparent electrode-layer forming step are continuously performed using the same apparatus.

26. The manufacturing method of a photovoltaic element according to claim 25, wherein the refractivity of the n-type semiconductor layer is in a range from 1.6 to 2.0, the refractivity of the transparent electrode layer is in a range from 1.8 to 2.3, and the refractivity of the surface transparent electrode layer is in a range from 1.6 to 2.0.

27. The manufacturing method of a photovoltaic element according to claim 25 or 26, wherein in the n-type semiconductor-layer forming step, the n-type semiconductor layer is formed by a film-forming process using a mixture gas of argon and oxygen under at least one of conditions of: oxygen partial pressure of the mixture gas being in a range from $1 \times 10^{-2}$ to 0.2 Pa; and a temperature of the glass substrate being in a range from 100 to 200 degrees Celsius, so that the n-type semiconductor layer is formed in an amorphous film.

28. The manufacturing method of a photovoltaic element according to any one of claims 25 to 27, wherein in the transparent electrode-layer forming step, the transparent electrode layer is formed by the same film-forming process as in the n-type semiconductor-layer forming step using the mixture gas of argon and oxygen under at least one of conditions of: oxygen partial pressure of the mixture gas being in a range from $1 \times 10^{-3}$ to $5 \times 10^{-2}$ Pa; and a temperature of the glass substrate being in a range from 100 to 200 degrees Celsius, so that the transparent electrode layer is formed in an amorphous film.

29. The manufacturing method of a photovoltaic element according to any one of claims 25 to 28, wherein the film-forming material is an oxide of at least one of elements selected from the group consisting of indium (In), zinc (Zn), tin (Sn), aluminum (Al), gallium (Ga), tungsten (W), cerium (Ce) and titanium (Ti).

# FIG.1

100, 100A, 100B

170, 170A, 170B

160, 160A, 160B

171

150, 150A, 150B

140, 140B

130, 130B

131

120

120

110

121

FIG.2

100C

170C

160C

150C

140C

130C

120C

110C

**INTERNATIONAL SEARCH REPORT**

| International application No. |
|---|
| PCT/JP2009/068012 |

A. CLASSIFICATION OF SUBJECT MATTER
*H01L31/04*(2006.01)i

According to International Patent Classification (IPC) or to both national classification and IPC

B. FIELDS SEARCHED

Minimum documentation searched (classification system followed by classification symbols)
H01L31/04

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)
JSTPlus/JMEDPlus/JST7580(JDreamII), CiNii

C. DOCUMENTS CONSIDERED TO BE RELEVANT

| Category* | Citation of document, with indication, where appropriate, of the relevant passages | Relevant to claim No. |
|---|---|---|
| X<br>Y | WO 2007/108932 A2  (SOLOPOWER, INC.),<br>27 September 2007 (27.09.2007),<br>paragraph [00061]<br>& JP 2009-530812 A      & US 2007/0093006 A1<br>& EP 1999795 A2         & KR 10-2009-0014146 A<br>& CN 101443920 A | 23<br>1-22,24-29 |
| Y | T. Sasabayashi, et al., Thin Solid Films, 2003,<br>Vol.445, p.219-223 | 1,2,4-17,21,<br>22 |
| Y | E. Nishimura, et al., Japanese Journal of<br>Applied Physics, 2007, Vol.46, No.12, p.7806-<br>7811 | 1,4-9,11-17,<br>21 |

☒ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 07 January, 2010 (07.01.10) | 26 January, 2010 (26.01.10) |

| Name and mailing address of the ISA/<br>Japanese Patent Office | Authorized officer |
|---|---|
| Facsimile No. | Telephone No. |

Form PCT/ISA/210 (second sheet) (April 2007)

**INTERNATIONAL SEARCH REPORT**

| International application No. |
| --- |
| PCT/JP2009/068012 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2001-257374 A (Honda Motor Co., Ltd.), 21 September 2001 (21.09.2001), paragraph [0002] (Family: none) | 8-13,18-20, 24-29 |
| Y | JP 2006-332440 A (Showa Shell Sekiyu Kabushiki Kaisha), 07 December 2006 (07.12.2006), entire text; all drawings & US 2009/0087940 A1 & EP 1898469 A1 & WO 2006/126598 A1 & KR 10-2008-0033157 A & CN 101213674 A | 3,9-13, 18-20,24-29 |
| Y | JP 09-135037 A (Canon Inc.), 20 May 1997 (20.05.1997), entire text; all drawings & US 5858120 A | 14-20,25-29 |
| A | Akira UNAKAMI, "Tokushu/Kinosei Coating no Shuyaku Shinkisei Hi Shoshistu Tomei Doden Zairyo", Convertech, 1996.03, pages 19 to 21 | 1-29 |
| A | T. Minami, et al., Highly Transparent and Conductive Zn2InO5 Thin Films Prepared by RF Magnetron Sputtering, Japanese Journal of Applied Physics, 1995.08.01, Vol.34, Part 2, No.8A, p.L971-L974 | 1-29 |
| A | Akira UNAKAMI, "Hi Shoshitsu Tomei Doden Zairyo", Idemitsu Technical Report, vol.39, no.1, 1996, pages 40 to 45 | 1-29 |
| A | JP 2005-126758 A (Matsushita Electric Industrial Co., Ltd.), 19 May 2005 (19.05.2005), paragraph [0003] (Family: none) | 3,9-13, 18-20,24-29 |
| A | JP 2004-158619 A (Matsushita Electric Industrial Co., Ltd.), 03 June 2004 (03.06.2004), paragraph [0049] & US 2004/0089874 A1 & DE 10351674 A & CN 1499649 A | 3,9-13, 18-20,24-29 |
| A | Eriko NISHIMURA et al., "29a-RA-6 DC Magnetron Sputter-ho de Sakusei shita ITO, IZO Tomei Doden Maku no Naibu Oryoku", 2006 Nen (Heisei 18 Nen) Shuki Dai 67 Kai Extended abstracts; the Japan Society of Applied Physics separate vol.2, 29 August 2006 (29.08.2006), page 552 | 1-29 |

Form PCT/ISA/210 (continuation of second sheet) (April 2007)

# EP 2 360 733 A1

| **INTERNATIONAL SEARCH REPORT** | International application No. |
|---|---|
| | PCT/JP2009/068012 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:

The invention in claim 1, the inventions in claims 3, 24 and the inventions in claims 5 – 17 having a "special technical feature" of the invention in claim 3, the inventions in claims 18, 25, the inventions in claims 19, 20, 26 – 29 having a "special technical feature" of the invention in claim 18 or 25, and the invention in claim 23 do not have same or corresponding special technical feature.

Therefore, since there is no technical relationship involving one or more same or corresponding special technical feature among those inventions, those inventions are not considered to be so linked as to form a single general inventive concept.

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)